# EUROPEAN PATENT APPLICATION

(11) **EP 4 123 738 A1**
(43) Date of publication of application: **25.01.2023**
(21) Application number: 21772554.8
(22) Date of filing: 18.03.2021
(51) Int. Cl.: H01L 51/00, H01L 51/50, H01L 51/52, H01L 51/56

(54) **HIGHLY EFFICIENT AND LONG-LASTING ORGANIC LIGHT-EMITTING DIODE**

(30) Priority: 18.03.2020 KR 20200033289
(71) Applicant: SFC Co., Ltd., Cheongju-si, Chungcheongbuk-do 28122 (KR)
(72) Inventor: LEE, Se-Jin, Cheongju-si Chungcheongbuk-do 28122 (KR); CHOI, Yeong-Tae, Cheongju-si Chungcheongbuk-do 28122 (KR); KIM, Ji-Yung, Cheongju-si Chungcheongbuk-do 28122 (KR); KIM, Kyungtae, Cheongju-si Chungcheongbuk-do 28122 (KR); KIM, Myeong-Jun, Cheongju-si Chungcheongbuk-do 28122 (KR); KIM, Kyeong-Hyeon, Cheongju-si Chungcheongbuk-do 28122 (KR)
(74) Representative: Epping - Hermann - Fischer
(86) International application number: PCT/KR2021/003380
(87) International publication number: WO 2021/187925

(57) **Abstract**

Disclosed herein is an organic light-emitting diode comprising at least one of the compounds represented by [Chemical Formula A] and at least one of the compound represented by [Chemical Formula B] as host materials therein, wherein [Chemical Formula A] and [Chemical Formula B] are as defined in the description.

## Description

### Technical Field

The present disclosure relates to an organic light-emitting diode with high efficiency and long lifespan and, more specifically, to an organic light-emitting diode that employs two or more structurally different anthracene derivatives whereby the organic light-emitting diode can exhibit high efficiency and long lifespan characteristics.

### Background Art

Organic light-emitting diodes, based on self-luminescence, exhibit the advantages of having a wide viewing angle, excellent contrast, fast response time, high brightness, and excellent driving voltage and response rate characteristics and of allowing for a polychromic display.

A typical organic light-emitting diode includes a positive electrode (anode) and a negative electrode (cathode), facing each other, with an organic emissive layer disposed therebetween.

As to the general structure of the organic light-emitting diode, a hole transport layer, a light-emitting layer, an electron transport layer, and a cathode are formed in that order on an anode. Here, all of the hole transport layer, the light-emitting layer, and the electron transport layer are organic films comprising organic compounds.

An organic light-emitting diode having such a structure operates as follows: when a voltage is applied between the anode and the cathode, the anode injects holes which are then transferred to the light-emitting layer via the hole transport layer while electrons injected from the cathode move to the light-emitting layer via the electron transport layer. In the luminescent zone, the carriers such as holes and electrons recombine to produce an exciton. When the exciton returns to the ground state from the excited state, the molecule of the light-emitting layer emits light.

Materials used as the organic layers in organic light-emitting diodes may be divided according to functions into luminescent materials and charge carrier materials, for example, a hole injection material, a hole transport material, an electron transport material, and an electron injection material. The light-emitting mechanism forms the basis of classification of luminescent materials as fluorescent and phosphorescent materials, which use excitons in singlet and triplet states, respectively.

When a single material is employed as the luminescent material, intermolecular actions cause the maximum luminescence wavelength to shift toward a longer wavelength, resulting in a reduction in color purity and light emission efficiency due to light attenuation. In this regard, a host-dopant system may be used as a luminescent material so as to increase the color purity and the light emission efficiency through energy transfer.

This is based on the principle whereby, when a dopant which is smaller in energy band gap than a host forming a light-emitting layer is added in a small amount to the light-emitting layer, excitons are generated from the light-emitting layer and transported to the dopant, emitting light at high efficiency. Here, light with desired wavelengths can be obtained depending on the kind of the dopant because the wavelength of the host moves to the wavelength range of the dopant.

With regard to related arts pertaining to host compounds in the light-emitting layer, reference may be made to Korean Patent No. 10-2015-0043020 A (April 22, 2015), which discloses an organic light-emitting diode in which a compound in a phenyl-anthracene-naphthyl structure is used as a luminescent material, and Japanese Patent No. 5608978 (Oct. 22, 2014), which describes an organic light-emitting diode comprising a luminescent medium layer containing an anthracene derivative in which an anthracene moiety has a dibenzofuran moiety as a substituent at a terminal position thereof.

Despite application of various kinds of compounds prepared for use in luminescent layers including the related art to OLEDs, there is still a continued need to develop organic layer materials that are capable of driving OLEDs at a lower voltage than ever and guarantee that OLEDs retain high efficiency and long lifespan characteristics.

### Disclosure

### Technical Problem

In order to solve the foregoing problems, the present disclosure aims to provide an organic light-emitting diode which has two or more structurally different anthracene derivatives introduced as hosts into a light-emitting layer thereof, whereby the organic light-emitting diode can operate at low voltage with high efficiency and long lifespan characteristics.

### Technical Solution

The present disclosure provides an organic light-emitting diode including: a first electrode; a second electrode facing the first electrode; and a light-emitting layer disposed between the first electrode and the second electrode, wherein the light-emitting layer contains a host and a dopant, the host including at least one compound represented by the following Chemical Formula A and at least one compound represented by the following Chemical Formula B, with a structural difference therebetween: 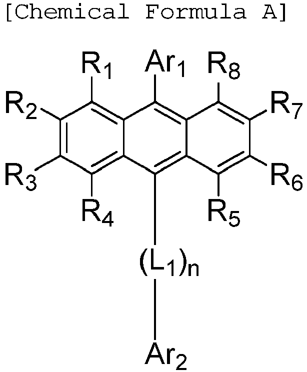 wherein,
R₁ to R₈, which are same or different, are each independently any one selected from a hydrogen atom, a deuterium atom, a substituted or unsubstituted alkyl of 1 to 30 carbon atoms, a substituted or unsubstituted aryl of 6 to 50 carbon atoms, a substituted or unsubstituted alkenyl of 2 to 30 carbon atoms, a substituted or unsubstituted alkynyl of 2 to 20 carbon atoms, a substituted or unsubstituted cycloalkyl of 3 to 30 carbon atoms, a substituted or unsubstituted cycloalkenyl of 5 to 30 carbon atoms, a substituted or unsubstituted heteroaryl of 2 to 50 carbon atoms, a substituted or unsubstituted heterocycloalkyl of 2 to 30 carbon atoms, a substituted or unsubstituted alkoxyl of 1 to 30 carbon atoms, a substituted or unsubstituted aryloxyl of 6 to 30 carbon atoms, a substituted or unsubstituted alkylthioxy of 1 to 30 carbon atoms, a substituted or unsubstituted arylthioxy of 6 to 30 carbon atoms, a substituted or unsubstituted alkylamine of 1 to 30 carbon atoms, a substituted or unsubstituted arylamine of 6 to 30 carbon atoms, a substituted or unsubstituted alkylsilyl of 1 to 30 carbon atoms, a substituted or unsubstituted arylsilyl of 6 to 30 carbon atoms, a cyano, and a halogen,
An and Ar₂, which are same or different, are each independently any one selected from a substituted or unsubstituted aryl of 6 to 50 carbon atoms and a substituted or unsubstituted heteroaryl of 2 to 50 carbon atoms,
L₁, which functions as a linker, is any one selected from a single bond, a substituted or unsubstituted arylene of 6 to 20 carbon atoms, and a substituted or unsubstituted heteroarylene of 2 to 20 carbon atoms,
n is an integer of 1 to 3 wherein when n is 2 or greater, corresponding L₁'s are same or different; 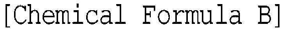 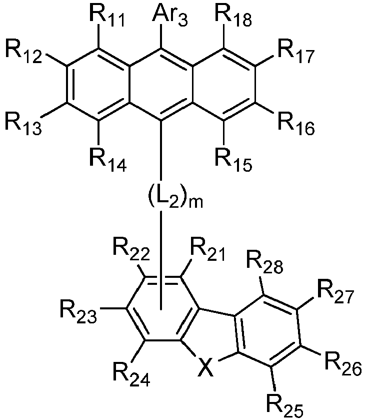 wherein,
   R₁₁ to R₁₈ and R₂₁ to R₂₈, which are same or different, are each independently selected from a hydrogen atom, a deuterium atom, a substituted or unsubstituted alkyl of 1 to 30 carbon atoms, a substituted or unsubstituted aryl of 6 to 50 carbon atoms, a substituted or unsubstituted alkenyl of 2 to 30 carbon atoms, a substituted or unsubstituted alkynyl of 2 to 30 carbon atoms, a substituted or unsubstituted cycloalkyl of 3 to 30 carbon atoms, a substituted or unsubstituted cycloalkenyl of 5 to 30 carbon atoms, a substituted or unsubstituted heteroaryl of 2 to 50 carbon atoms, a substituted or unsubstituted heterocycloalkyl of 2 to 30 carbon atoms, a substituted or unsubstituted alkoxyl of 1 to 30 carbon atoms, a substituted or unsubstituted aryloxyl of 6 to 30 carbon atoms, a substituted or unsubstituted alkylthioxy of 1 to 30 carbon atoms, a substituted or unsubstituted arylthioxy of 6 to 30 carbon atoms, a substituted or unsubstituted alkylamine of 1 to 30 carbon atoms, a substituted or unsubstituted arylamine of 6 to 30 carbon atoms, a substituted or unsubstituted alkylsilyl of 1 to 30 carbon atoms, a substituted or unsubstituted arylsilyl of 6 to 30 carbon atoms, a cyano, and a halogen,
Ar₃ is any one selected from a substituted or unsubstituted aryl of 6 to 50 carbon atoms and a substituted or unsubstituted heteroaryl of 2 to 50 carbon atoms,
one of R₂₁ to R₂₈ is a single bond to L₂ that functions as a linker,
X is O or S,
the linker L₂ is any one selected from a single bond, a substituted or unsubstituted arylene of 6 to 20 carbon atoms, and a substituted or unsubstituted heteroarylene of 2 to 20 carbon atoms, and
m is an integer of 1 to 3 wherein when m is 2 or greater, corresponding L₂'s are same or different,
   wherein the term "substituted" in the expression "substituted or unsubstituted" for [Chemical Formula A] and [Chemical Formula B] means having at least one substituent selected from the group consisting of a deuterium atom, a cyano, a halogen, a hydroxy, a nitro, an alkyl of 1 to 24 carbon atoms, a halogenated alkyl of 1 to 24 carbon atoms, a cycloalkyl of 3 to 30 carbon atoms, an alkenyl of 2 to 24 carbon atoms, an alkynyl of 2 to 24 carbon atoms, a heteroalkyl of 1 to 24 carbon atoms, an aryl of 6 to 24 carbon atoms, an arylalkyl of 7 to 24 carbon atoms, an alkylaryl of 7 to 24 carbon atoms, a heteroaryl of 2 to 24 carbon atoms, a heteroarylalkyl of 2 to 24 carbon atoms, an alkoxy of 1 to 24 carbon atoms, an alkylamino of 1 to 24 carbon atoms, an arylamino of 6 to 24 carbon atoms, a heteroarylamino of 1 to 24 carbon atoms, an alkylsilyl of 1 to 24 carbon atoms, and an arylsilyl of 6 to 24 carbon atoms, aryloxy of 6 to 24 carbon atoms.

### Advantageous Effects

The organic light-emitting diode according to the present disclosure, which has two or more different anthracene compounds of respective specific structures introduced as host materials into a light-emitting layer thereof, exhibits improved physical properties including high luminous efficiency and long lifespan characteristics.

Particularly, the host in the light-emitting layer employs: a hydrocarbon-derived host material composed only of carbon atoms and hydrogen atoms (inclusive of deuterium atoms); and a dibenzofuran-based (or dibenzothiophene-based) hydrocarbon-derived host material composed of a dibenzofuran heterocyclic ring moiety bearing only one oxygen or sulfur atom as a sole intramolecular heteroatom and a moiety including only carbon atoms and hydrogen atoms (inclusive of deuterium atoms), without significant differences in molecular weight between said host materials, whereby the host materials can be easily mixed in a single evaporation source and introduced into a deposition process due to their similar sublimation temperature ranges and guarantee greater uniformity and stability for the deposition process, with the consequent achievement of high efficiency and long lifespan of the light-emitting layer in the light-emitting layer.

### Brief Description of the Drawings

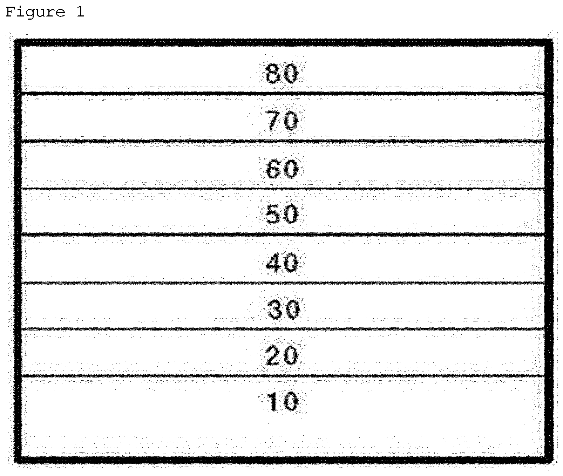

FIG. 1 is a schematic view of the structure of an organic light-emitting diode according to an embodiment of the present disclosure.

### Best Mode for Carrying out the Invention

Hereinafter, exemplary embodiments which can be easily implemented by those skilled in the art will be described with reference to the accompanying drawing.

In each drawing of the present disclosure, sizes or scales of components may be enlarged or reduced from their actual sizes or scales for better illustration, and known components may not be depicted therein to clearly show features of the present disclosure. Therefore, the present disclosure is not limited to the drawings. When describing the principle of the embodiments of the present disclosure in detail, details of well-known functions and features may be omitted to avoid unnecessarily obscuring the presented embodiments.

In drawings, for convenience of description, sizes of components may be exaggerated for clarity. For example, since sizes and thicknesses of components in drawings are arbitrarily shown for convenience of description, the sizes and thicknesses are not limited thereto. Furthermore, throughout the description, the terms "on" and "over" are used to refer to the relative positioning, and mean not only that one component or layer is directly disposed on another component or layer but also that one component or layer is indirectly disposed on another component or layer with a further component or layer being interposed therebetween. Also, spatially relative terms, such as "below", "beneath", "lower", and "between" may be used herein for ease of description to refer to the relative positioning.

Throughout the specification, when a portion may "comprise" or "include" a certain constituent element, unless explicitly described to the contrary, it may not be construed to exclude another constituent element but may be construed to further include other constituent elements. Further, throughout the specification, the word "on" means positioning on or below the object portion, but does not essentially mean positioning on the lower side of the object portion based on a gravity direction.

The present disclosure provides an organic light-emitting diode with improved physical properties including high efficiency and long lifespan, wherein two or more anthracene compounds having respective different specific hydrocarbon-based structures, with no significant difference in molecular weight therebetween, are simultaneously introduced into a light-emitting layer of the organic light-emitting diode, thereby improving luminous efficiency and lifespan characteristics.

In detail, an organic light-emitting diode according to the present disclosure includes: a first electrode; a second electrode facing the first electrode; and a light-emitting layer disposed between the first electrode and the second electrode, wherein the light-emitting layer contains a host and a dopant, the host including at least one compound represented by the following Chemical Formula A and at least one compound represented by the following Chemical Formula B, with a structural difference therebetween: 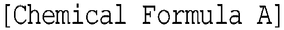 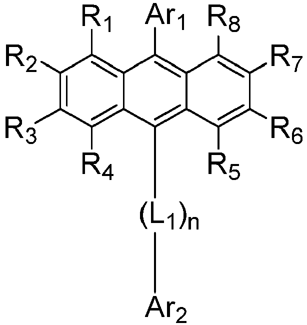 wherein,
R₁ to R₈, which are same or different, are each independently any one selected from a hydrogen atom, a deuterium atom, a substituted or unsubstituted alkyl of 1 to 30 carbon atoms, a substituted or unsubstituted aryl of 6 to 50 carbon atoms, a substituted or unsubstituted alkenyl of 2 to 30 carbon atoms, a substituted or unsubstituted alkynyl of 2 to 20 carbon atoms, a substituted or unsubstituted cycloalkyl of 3 to 30 carbon atoms, a substituted or unsubstituted cycloalkenyl of 5 to 30 carbon atoms, a substituted or unsubstituted heteroaryl of 2 to 50 carbon atoms, a substituted or unsubstituted heterocycloalkyl of 2 to 30 carbon atoms, a substituted or unsubstituted alkoxyl of 1 to 30 carbon atoms, a substituted or unsubstituted aryloxyl of 6 to 30 carbon atoms, a substituted or unsubstituted alkylthioxy of 1 to 30 carbon atoms, a substituted or unsubstituted arylthioxy of 6 to 30 carbon atoms, a substituted or unsubstituted alkylamine of 1 to 30 carbon atoms, a substituted or unsubstituted arylamine of 6 to 30 carbon atoms, a substituted or unsubstituted alkylsilyl of 1 to 30 carbon atoms, a substituted or unsubstituted arylsilyl of 6 to 30 carbon atoms, a cyano, and a halogen,
An and Ar₂, which are same or different, are each independently any one selected from a substituted or unsubstituted aryl of 6 to 50 carbon atoms and a substituted or unsubstituted heteroaryl of 2 to 50 carbon atoms,
L₁, which functions as a linker, is any one selected from a single bond, a substituted or unsubstituted arylene of 6 to 20 carbon atoms, and a substituted or unsubstituted heteroarylene of 2 to 20 carbon atoms,
n is an integer of 1 to 3 wherein when n is 2 or greater, corresponding L₁'s are same or different; 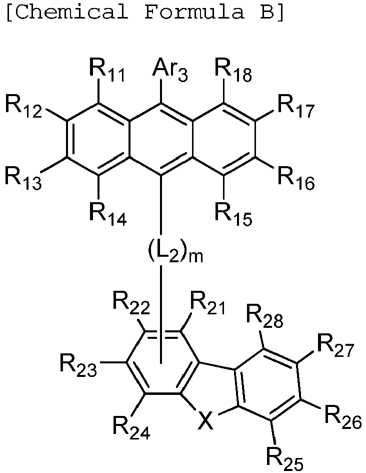 wherein,
   R₁₁ to R₁₈ and R₂₁ to R₂₈, which are same or different, are each independently selected from a hydrogen atom, a deuterium atom, a substituted or unsubstituted alkyl of 1 to 30 carbon atoms, a substituted or unsubstituted aryl of 6 to 50 carbon atoms, a substituted or unsubstituted alkenyl of 2 to 30 carbon atoms, a substituted or unsubstituted alkynyl of 2 to 30 carbon atoms, a substituted or unsubstituted cycloalkyl of 3 to 30 carbon atoms, a substituted or unsubstituted cycloalkenyl of 5 to 30 carbon atoms, a substituted or unsubstituted heteroaryl of 2 to 50 carbon atoms, a substituted or unsubstituted heterocycloalkyl of 2 to 30 carbon atoms, a substituted or unsubstituted alkoxyl of 1 to 30 carbon atoms, a substituted or unsubstituted aryloxyl of 6 to 30 carbon atoms, a substituted or unsubstituted alkylthioxy of 1 to 30 carbon atoms, a substituted or unsubstituted arylthioxy of 6 to 30 carbon atoms, a substituted or unsubstituted alkylamine of 1 to 30 carbon atoms, a substituted or unsubstituted arylamine of 6 to 30 carbon atoms, a substituted or unsubstituted alkylsilyl of 1 to 30 carbon atoms, a substituted or unsubstituted arylsilyl of 6 to 30 carbon atoms, a cyano, and a halogen,
   Ar₃ is any one selected from a substituted or unsubstituted aryl of 6 to 50 carbon atoms and a substituted or unsubstituted heteroaryl of 2 to 50 carbon atoms,
   one of R₂₁ to R₂₈ is a single bond to L₂ that functions as a linker,
   X is O or S,
   the linker L₂ is any one selected from a single bond, a substituted or unsubstituted arylene of 6 to 20 carbon atoms, and a substituted or unsubstituted heteroarylene of 2 to 20 carbon atoms, and
   m is an integer of 1 to 3 wherein when m is 2 or greater, corresponding L₂'s are same or different,
   wherein the term "substituted" in the expression "substituted or unsubstituted" for [Chemical Formula A] and [Chemical Formula B] means having at least one substituent selected from the group consisting of a deuterium atom, a cyano, a halogen, a hydroxy, a nitro, an alkyl of 1 to 24 carbon atoms, a halogenated alkyl of 1 to 24 carbon atoms, a cycloalkyl of 3 to 30 carbon atoms, an alkenyl of 2 to 24 carbon atoms, an alkynyl of 2 to 24 carbon atoms, a heteroalkyl of 1 to 24 carbon atoms, an aryl of 6 to 24 carbon atoms, an arylalkyl of 7 to 24 carbon atoms, an alkylaryl of 7 to 24 carbon atoms, a heteroaryl of 2 to 24 carbon atoms, a heteroarylalkyl of 2 to 24 carbon atoms, an alkoxy of 1 to 24 carbon atoms, an alkylamino of 1 to 24 carbon atoms, an arylamino of 6 to 24 carbon atoms, a heteroarylamino of 1 to 24 carbon atoms, an alkylsilyl of 1 to 24 carbon atoms, and an arylsilyl of 6 to 24 carbon atoms, aryloxy of 6 to 24 carbon atoms.

The expression indicating the number of carbon atoms such as in "a substituted or unsubstituted alkyl of 1 to 24 carbon atoms", "a substituted or unsubstituted aryl of 6 to 50 carbon atoms", etc. means the total number of carbon atoms of, for example, the alkyl or aryl radical or moiety alone, exclusive of the number of carbon atoms of the substituent. For instance, a phenyl group with a butyl at the para position falls within the scope of an aryl of 6 carbon atoms although it is substituted with a butyl radical of 4 carbon atoms.

As used herein, the term "aryl" refers to an organic radical derived from an aromatic hydrocarbon by removing one hydrogen atom. In addition, the aromatic system may further include a fused ring that is formed by adjacent substituents, if present, on the aryl radical.

Examples of the aryl include phenyl, o-biphenyl, m-biphenyl, p-biphenyl, o-terphenyl, m-terphenyl, p-terphenyl, naphthyl, anthryl, phenanthryl, pyrenyl, indenyl, fluorenyl, tetrahydronaphthyl, perylenyl, chrysenyl, naphthacenyl, and fluoranthenyl, but are not limited thereto. At least one hydrogen atom on the aryl radical may be substituted by a deuterium atom, a halogen atom, a hydroxy, a nitro, a cyano, a silyl, an amino (-NH₂, -NH (R), -N (R') (R") wherein R' and R" are each independently an alkyl of 1 to 10 carbon atoms, in this case called "alkylamino"), an amidino, a hydrazine, a hydrazone, a carboxyl, a sulfonic acid, a phosphoric acid, an alkyl of 1 to 24 carbon atoms, a halogenated alkyl of 1 to 24 carbon atoms, an alkenyl of 1 to 24 carbon atoms, an alkynyl of 1 to 24 carbon atoms, a heteroalkyl of 1 to 24 carbon atoms, an aryl of 6 to 24 carbon atoms, an arylalkyl of 6 to 24 carbon atoms, a heteroaryl of 2 to 24 carbon atoms, or a heteroarylalkyl of 2 to 24 carbon atoms.

The substituent heteroaryl used in the compound of the present disclosure refers to a cyclic aromatic system of 2 to 50 and preferably 2 to 24 carbon atoms bearing one to three heteroatoms selected from among N, O, P, Si, S, Ge, Se, and Te. In the aromatic system, two or more rings may be fused. One or more hydrogen atoms on the heteroaryl may be substituted by the same substituents as on the aryl.

As used herein, the term "heteroaromatic ring" refers to an aromatic hydrocarbon ring bearing at least one heteroatom as a ring member. In the heteroaromatic ring, one to three aromatic carbon atoms may be substituted by at least one heteroatom selected from N, O, P, Si, S, Ge, Se, and Te.

Examples of the substituent alkyl useful in the present disclosure include methyl, ethyl, propyl, isopropyl, isobutyl, sec-butyl, tert-butyl, pentyl, iso-amyl, and hexyl. At least one hydrogen atom of the alkyl may be substituted by the same substituent as in the aryl.

Examples of the substituent alkoxy used in the compounds of the present disclosure include methoxy, ethoxy, propoxy, isobutyloxy, sec-butyloxy, pentyloxy, iso-amyloxy, and hexyloxy. At least one hydrogen atom of the alkoxy may be substituted by the same substituent as in the aryl.

Representative of the silyl useful in the compound of the present disclosure are trimethylsilyl, triethylsilyl, triphenylsilyl, trimethoxysilyl, dimethoxyphenylsilyl, diphenylmethylsilyl, diphenylvinylsilyl, methylcyclobutylsilyl, and dimethylfurylsilyl. At least one hydrogen atom in the silyl may be substituted by the same substituent as in the aryl.

The organic light-emitting compound represented by Chemical Formula A according to the present disclosure is characterized by the structure in which the anthracene ring moiety has a substituted or unsubstituted aryl of 6 to 50 carbon atoms or a substituted or unsubstituted heteroaryl of 2 to 50 carbon atoms as the substituent (An) on the carbon atom at position 9 thereof, and any one selected from a single bond, a substituted or unsubstituted arylene of 6 to 20 carbon atoms, a substituted or unsubstituted heteroarylene of 2 to 20 carbon atoms as the linker (L₁) on the carbon atom at position 10, with a substituted or unsubstituted aryl of 6 to 50 carbon atoms or a substituted or unsubstituted heteroaryl of 2 to 50 carbon atoms being used as the substituent (Ar₂) bonded to one end of the linker (L₁). In addition, the anthracene compound represented by Chemical Formula B is characterized by the structure in which the anthracene ring moiety has a substituted or unsubstituted aryl of 6 to 50 carbon atoms or a substituted or unsubstituted heteroaryl of 2 to 50 carbon atoms as the substituent (Ar₃) on the carbon atom at position 9 thereof, and any one selected from a single bond, a substituted or unsubstituted arylene of 6 to 20 carbon atoms, and a substituted or unsubstituted heteroarylene of 2 to 20 carbon atoms as the linker (L₂) on the caron atom at position 10, with a dibenzofuran derivative represented by the following Structural Formula A or a dibenzothiophene derivative represented by the following Structural Formula B being bonded to an end of the linker (L₂) (here, any one of R₂₁ to R₂₈ is a single bond connected to the linker L₂). With such configurations, the organic light-emitting diode exhibits improved properties including high efficiency and long lifespan.

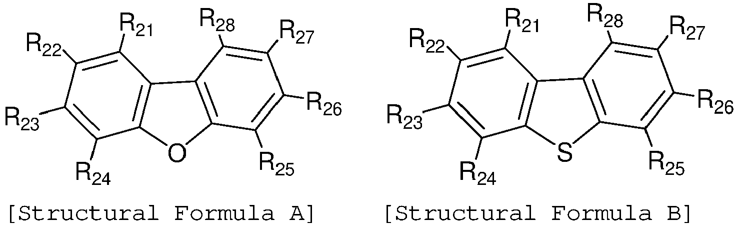

Two or more compounds employed as host materials in a light-emitting layer are different in structure but are not significantly different in molecular weight so that vapor pressures of the compounds are in similar ranges under a deposition condition (pressure of 1×10⁻⁵ torr or less) for the compounds, whereby the deposition of the light-emitting layer can be achieved with uniformity and stability. Accordingly, the organic light-emitting diode according to the present disclosure exhibits high efficiency and long lifespan characteristics at low voltages, compared to conventional organic light-emitting diodes.

In the present disclosure, Compound A and Compound B, which are used as hosts in the light-emitting layer, may be different in molecular weight by 200 or less, preferably by 180 or less, more preferably by 150 or less, more preferably by 140 or less, more preferably by 130 or less, more preferably by 120 or less, more preferably by 110 or less, more preferably by 100 or less, more preferably by 90 or less, more preferably by 80 or less, more preferably by 70 or less, more preferably by 60 or less, more preferably by 50 or less, more preferably by 40 or less, more preferably by 30 or less, more preferably by 20 or less, and most preferably by 10 or less.

In an embodiment of the present disclosure, the substituents R₁ to R₈ in Chemical Formula A are same or different and may each be independently a hydrogen atom or a deuterium atom.

In an embodiment of the present disclosure, the substituents Ar₁ and Ar₂ in Chemical Formula A, which are same or different, may each be independently a substituted or unsubstituted aryl of 6 to 18 carbon atoms.

In an embodiment, the substituents Ar₁ and Ar₂ are same or different and may each be independently a substituted or unsubstituted aryl of 6 to 18 carbon atoms. In this regard, the substituents Ar₁ and Ar₂ are same or different and may each be independently any one selected from a substituted or unsubstituted phenyl, a substituted or unsubstituted naphthyl, a substituted or unsubstituted anthracenyl, a substituted or unsubstituted phenanthrenyl, and a substituted or unsubstituted fluorenyl.

In an embodiment of the present disclosure, the linker L₁ in Chemical Formula A may be a single bond or a substituted or unsubstituted arylene of 6 to 18 carbon atoms. Particularly, the linker L₁ may be a single bond or any one selected from the following Structural Formulas 21 to 27:

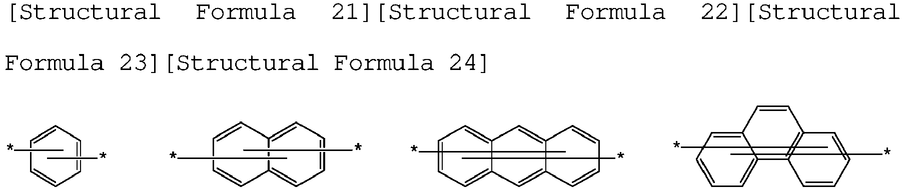

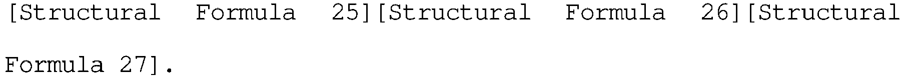

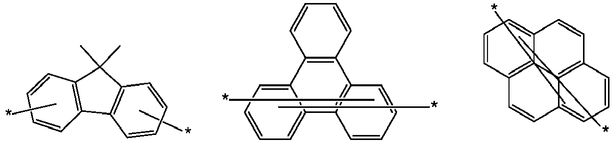

In the linker L₁, each of the unsubstituted carbon atoms of the aromatic ring moiety may be bound with a hydrogen atom or a deuterium atom.

In addition, the substituents R₁₁ to R₁₈ and R₂₁ to R₂₈ in the compound of Chemical Formula B, which may be same or different, are each independently a hydrogen atom or a deuterium atom.

In an embodiment, the substituent Ar₃ in Chemical Formula B may be a substituted or unsubstituted aryl of 6 to 18 carbon atoms.

In an embodiment, when the substituent Ar₃ is a substituted or unsubstituted aryl of 6 to 18 carbon atoms, it may be any one selected from a substituted or unsubstituted phenyl, a substituted or unsubstituted naphthyl, a substituted or unsubstituted anthracenyl, a substituted or unsubstituted phenanthrenyl, and a substituted or unsubstituted fluorenyl.

In an embodiment, the linker L₂ in Chemical Formula B may be a single bond or a substituted or unsubstituted arylene of 6 to 18 carbon atoms. In this regard, the linker L₂ may be a single bond or any one selected from the following Structural Formulas 41 to 47:

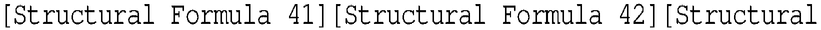

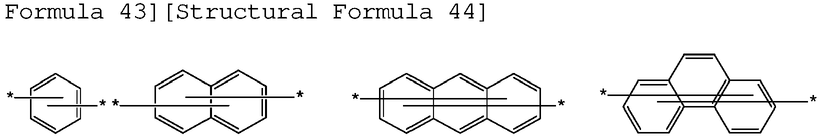

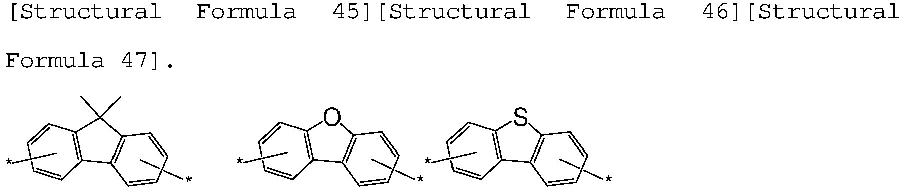

In the linker L₂, each of the unsubstituted carbon atoms of the aromatic ring moiety may be bound with a hydrogen atom or a deuterium atom.

In the present disclosure, the compound represented by Chemical Formula A may be a hydrocarbon composed only of carbon atoms and hydrogen atoms as intramolecular elements; or a hydrocarbon composed only of carbon atoms, deuterium atoms, and hydrogen atoms as intramolecular elements, and the compound represented by Chemical Formula B may be a hydrocarbon composed only of carbon atoms and hydrogen atoms, except for X, as intramolecular elements; or a hydrocarbon composed only of carbon atoms, deuterium atoms, and hydrogen atoms, except for X, as intramolecular elements.

That is, the compound of Chemical Formula A, which is a hydrocarbon composed only of carbon atoms and hydrogen atoms (inclusive of deuterium atoms), and the compound of Chemical Formula B, which is a hydrocarbon composed only of carbon atoms and hydrogen atoms (inclusive of deuterium atoms), except for X, as intramolecular elements, are used as host materials and thus each retain a minimum of intramolecular polar portions, whereby a heating temperature for an evaporation source at a specific pressure can be reduced upon deposition process.

The compounds corresponding to "a hydrocarbon composed only of carbon atoms and hydrogen atoms as intramolecular elements or a hydrocarbon composed only of carbon atoms, deuterium atoms, and hydrogen atoms" is exemplified by the compound of Chemical Formula A wherein R₁ to R₈, which may be same or different, are each independently a hydrogen atom or a deuterium atom, An and Ar₂, which may be same or different, are each independently a substituted or unsubstituted aryl of 6 to 18 carbon atoms, and the linker L₁ is a single bond or a substituted or unsubstituted arylene of 6 to 18 carbon atoms. In this point of view, the same substituents may be set forth for Chemical Formula B, except for the dibenzofuran moiety and the dibenzothiophene moiety.

Particularly, a host material derived from a hydrocarbon composed only of carbon atoms and hydrogen (inclusive of deuterium) atoms as intramolecular elements and a host material derived from a dibenzofuran (or dibenzothiophene)-based hydrocarbon composed of a dibenzofuran (or dibenzothiophene) bearing only one oxygen or sulfur atom as an intramolecular member, and carbon and hydrogen (inclusive of deuterium) atoms as the remaining intramolecular members are used together in the light-emitting layer, so that a minimized polar portion is formed in each of the host materials, with no significant difference in molecular weight therebetween. Thus, the host materials are readily miscible with each other and exhibit similar degrees of sublimation (sublimation temperature) under the same pressure in a deposition process, allowing the light-emitting layer to be deposited uniformly and stably.

Conventional techniques are disadvantageous in that a plurality of compounds used as host materials in a deposition process are different in terms of degree of deposition, the evaporation sources must be provided in respective separate deposition chambers. As opposed, the host materials according to the present disclosure can be mixed together in one evaporation source and deposited simultaneously.

In an embodiment, when deposited on a target, the compound represented by Chemical Formula A and the compound represented by Chemical Formula B, which are contained as host materials in the light-emitting layer of the organic light-emitting diode of the present disclosure, may differ from each other in evaporation temperature by 30°C or less, preferably by 25°C or less, more preferably by 20°C or less, even more preferably by 15°C or less, far even more preferably by 10°C or less, and most preferably by 5°C or less.

Here, the evaporation temperature means the temperature within the chamber (temperature below the evaporation source) set forth to deposit the deposition material at a rate of 1 Å/s onto the target substrate when all deposition conditions (pressure, location and size of evaporation source, and content of evaporation material) are same, except for the materials, in the cluster deposition machine. The temperature may vary according to the intrinsic properties of the materials to be deposited. In this regard, the deposition chamber may be set forth to have a pressure of 10⁻⁴ torr or less, preferably 10⁻⁵ torr or less, more preferably 10⁻⁶ torr or less, and even more preferably 10⁻⁷ torr or less.

Concrete examples of the anthracene derivative compound represented by Chemical Formula A according to the present disclosure include, but are not limited to, [Compound 1] to [Compound 105]:

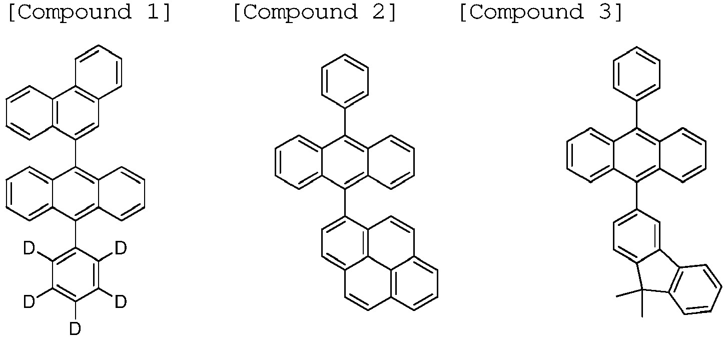

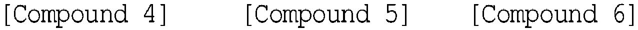

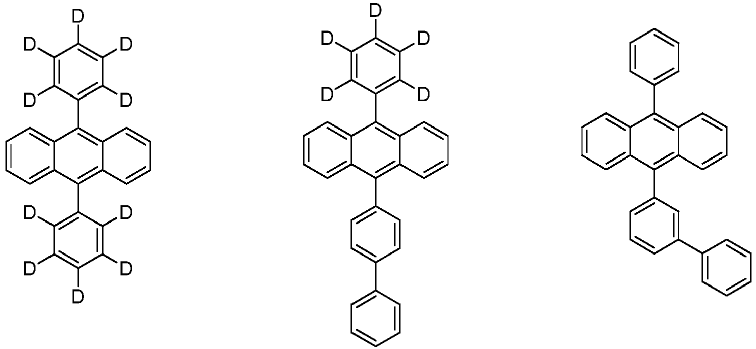

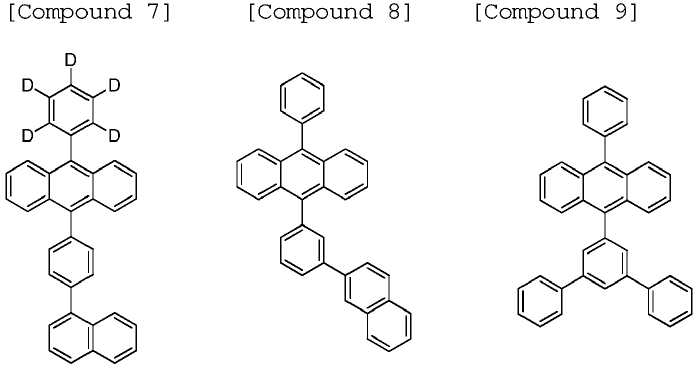

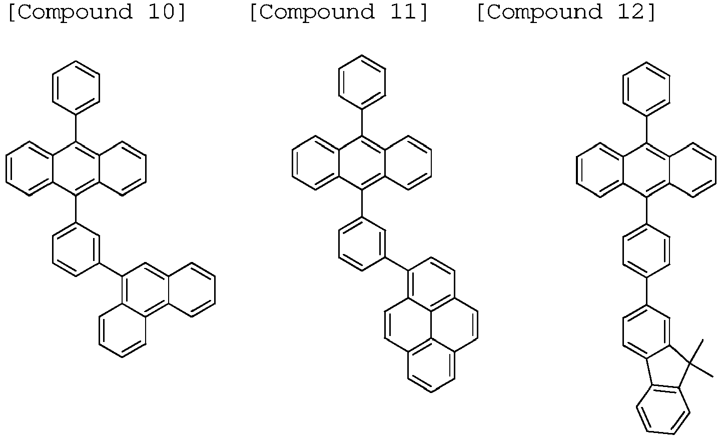

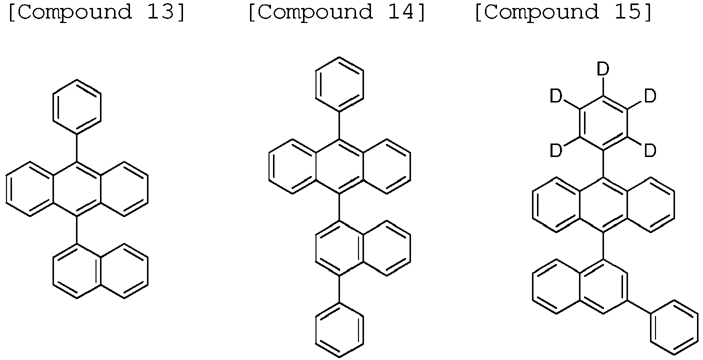

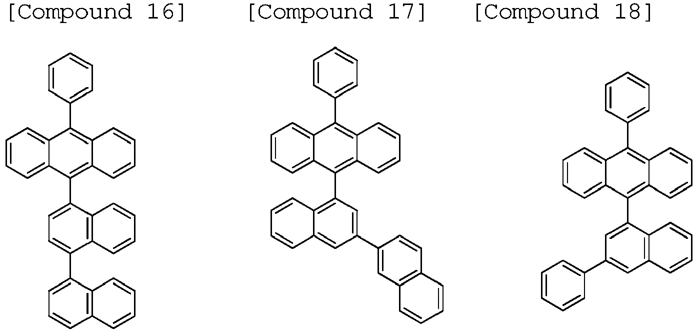

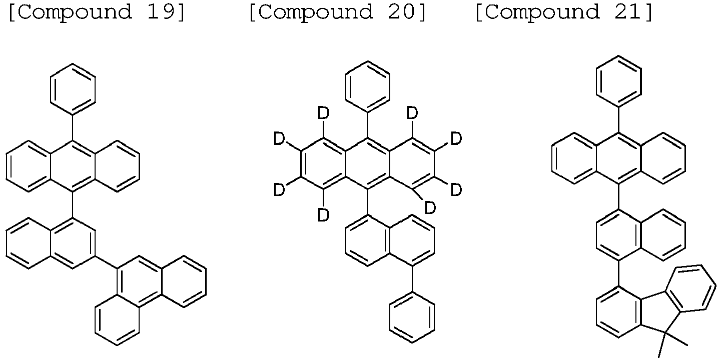

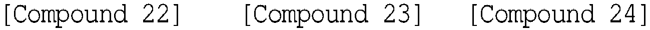

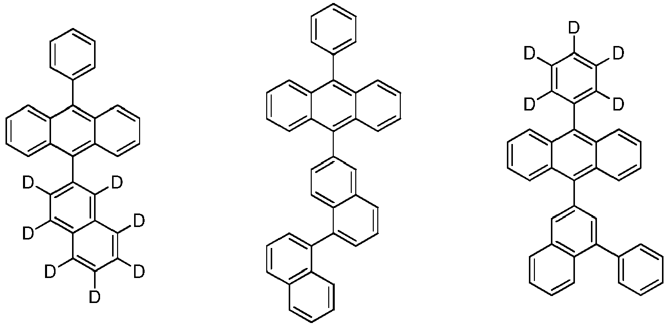

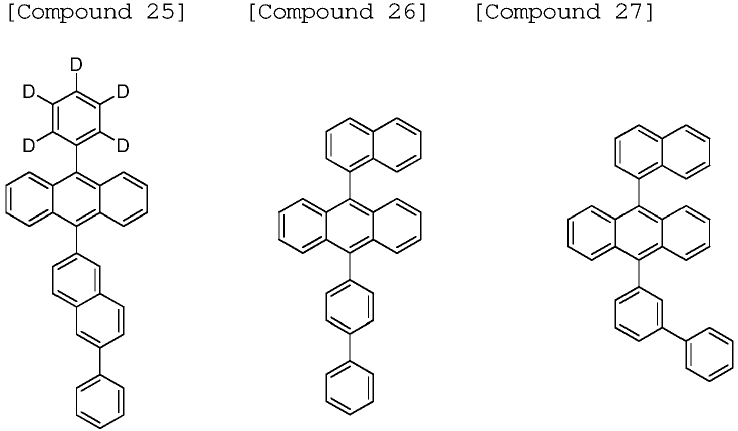

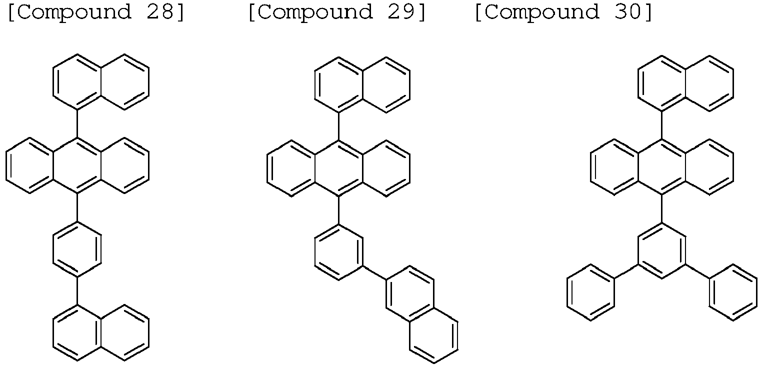

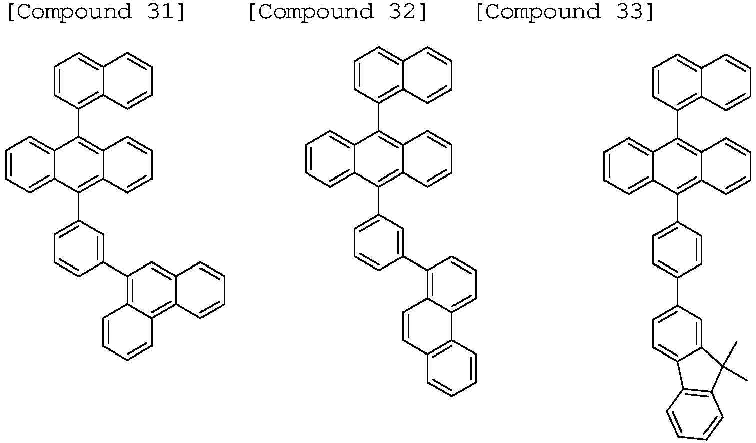

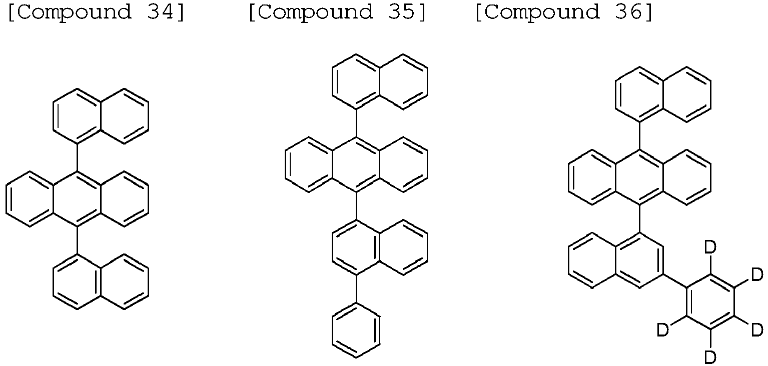

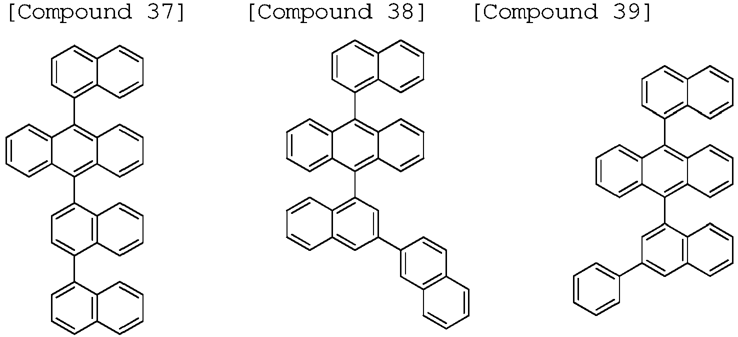

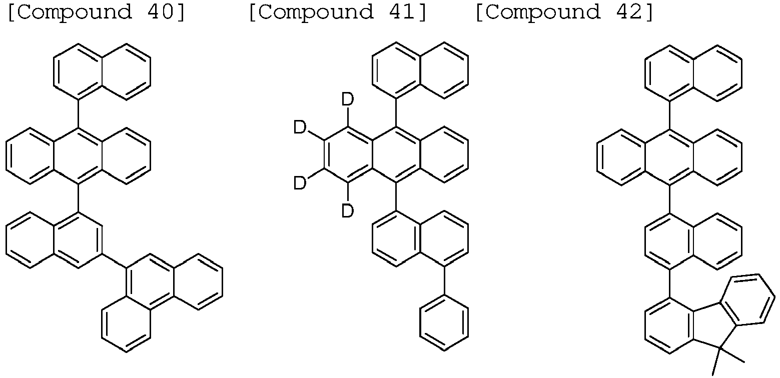

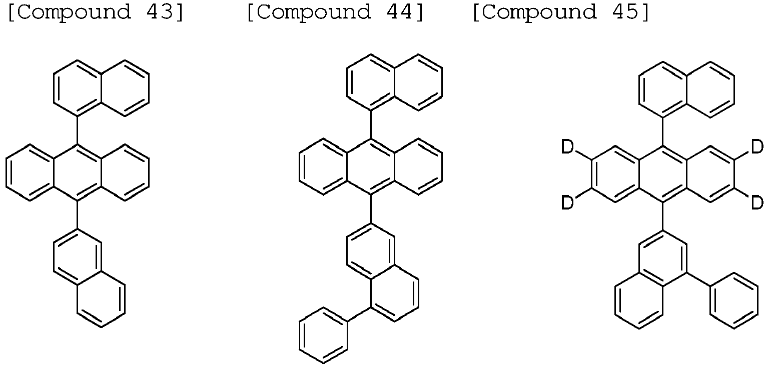

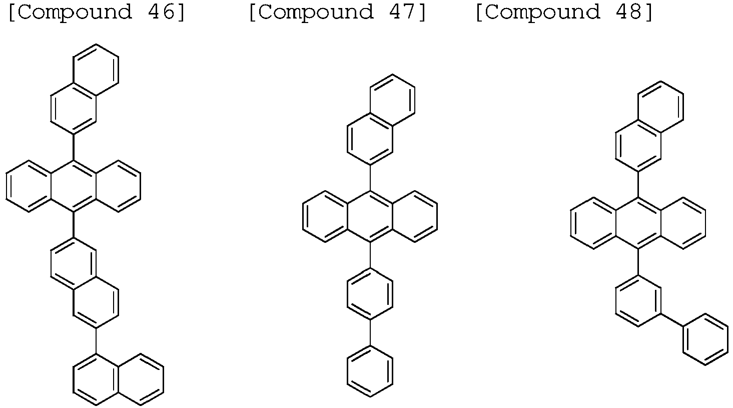

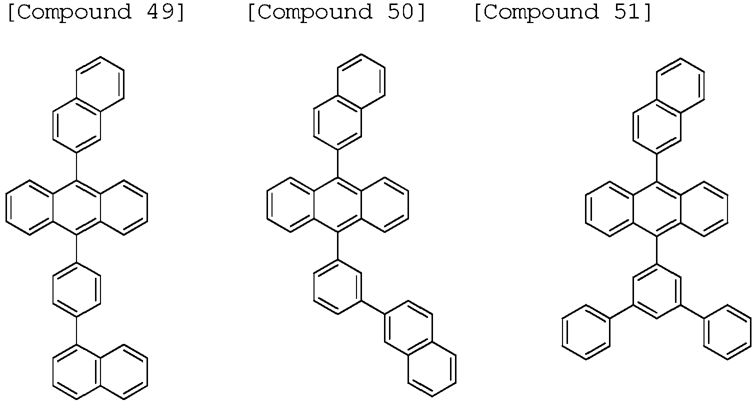

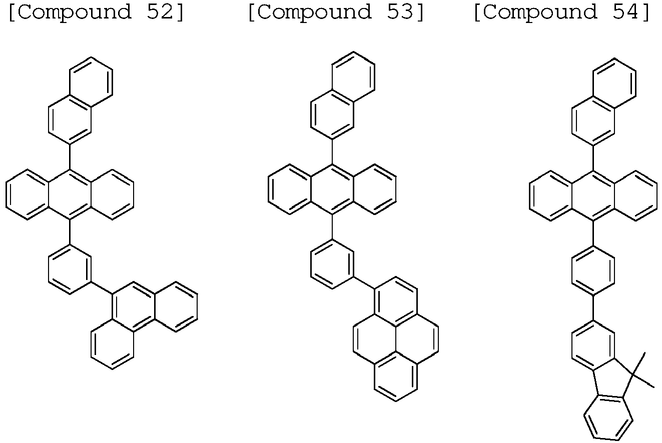

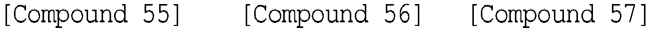

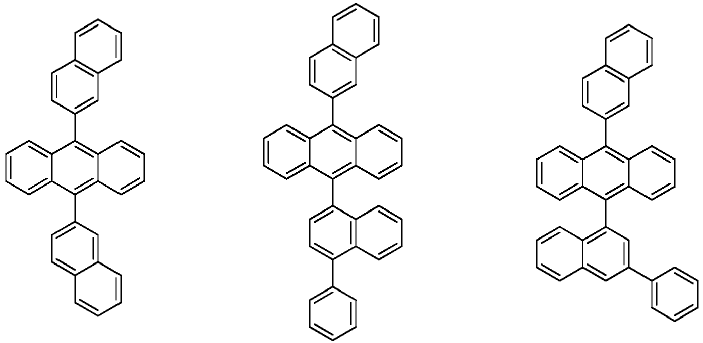

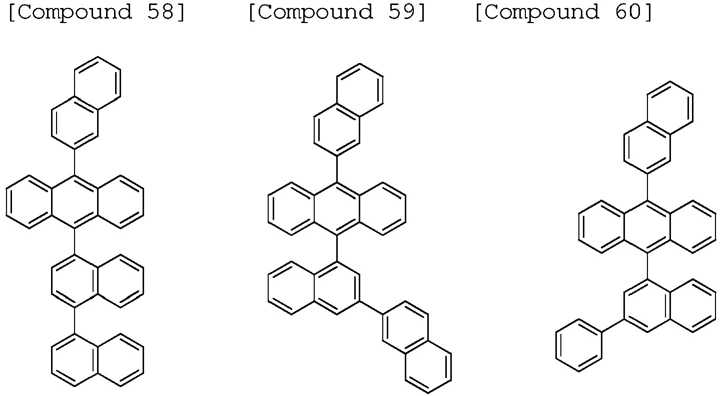

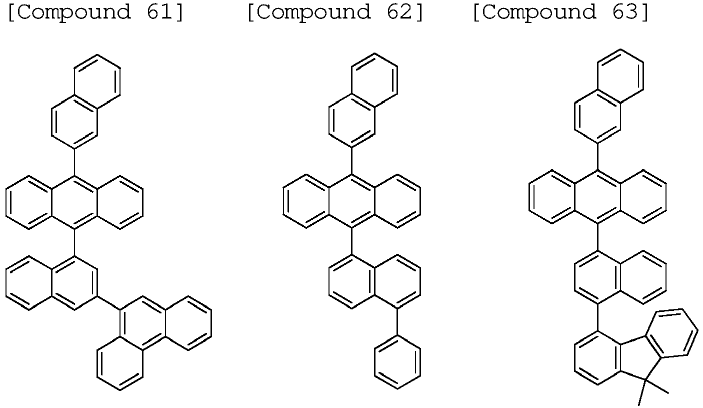

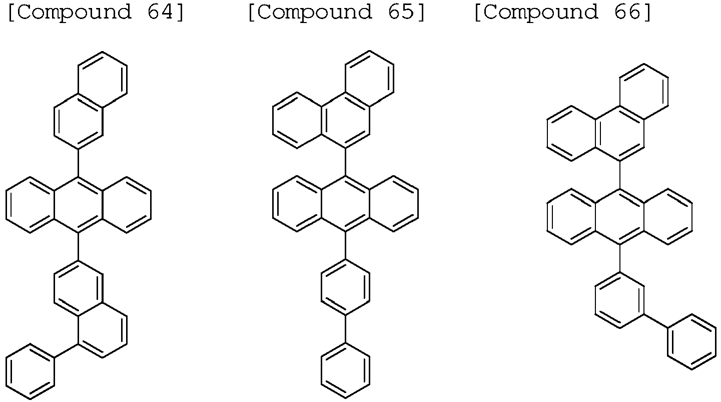

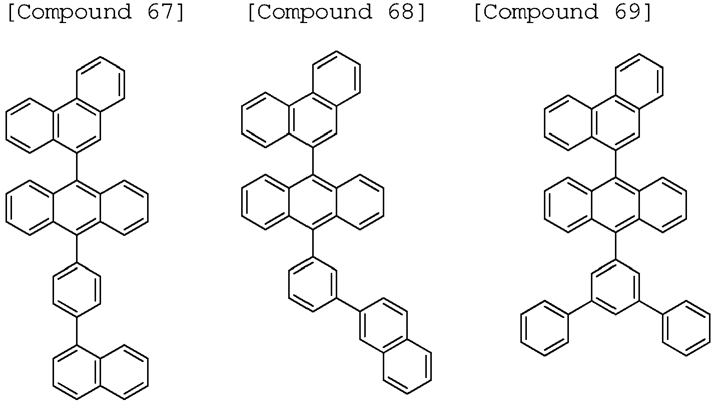

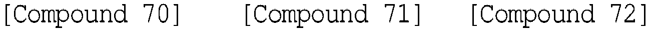

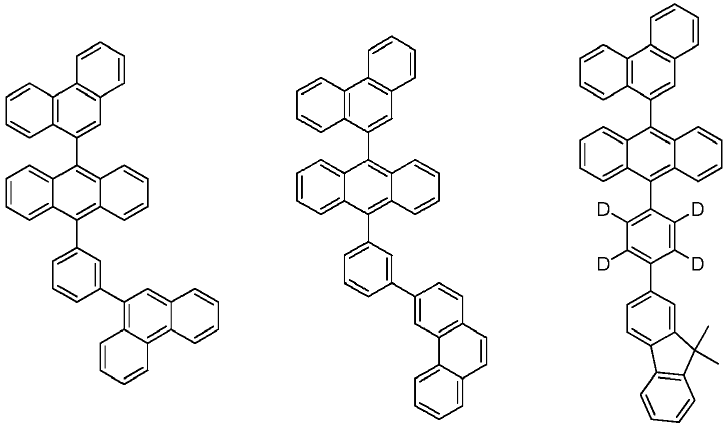

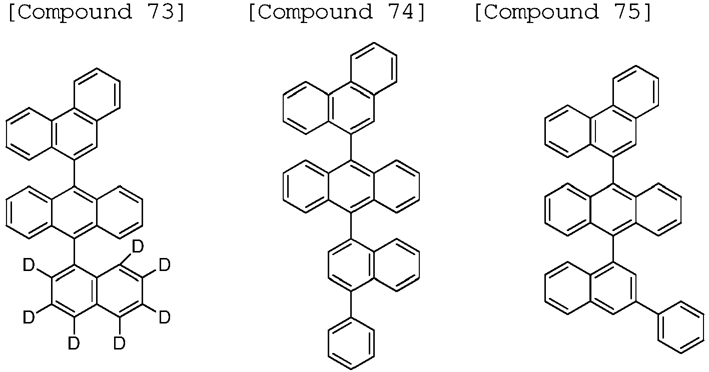

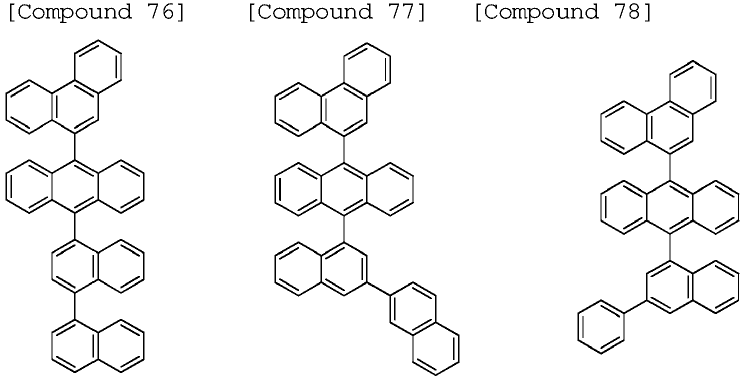

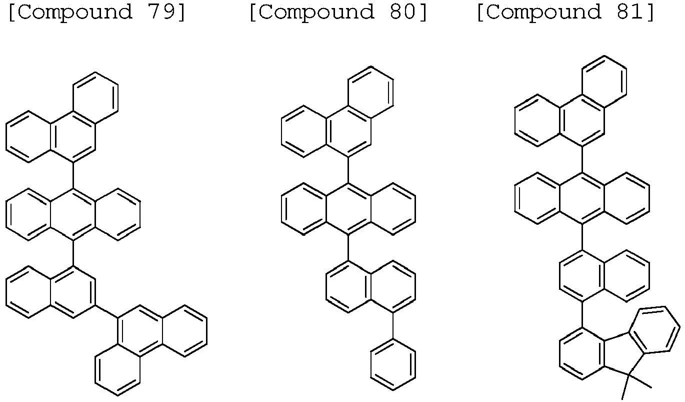

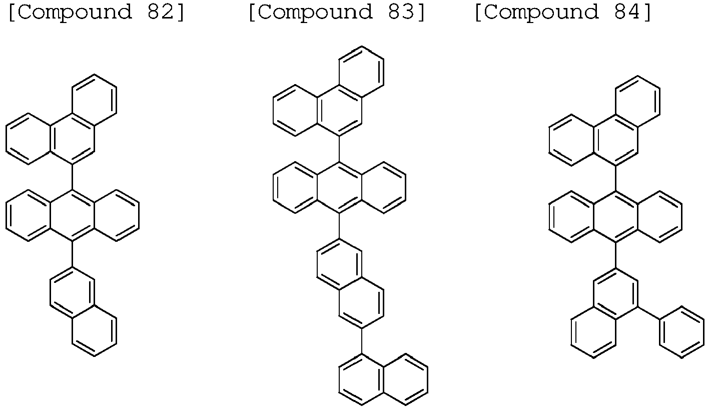

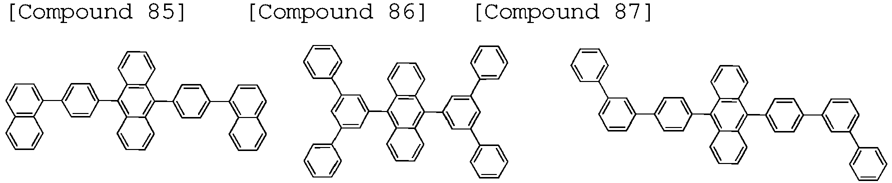

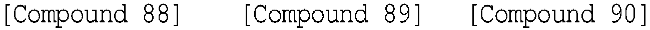

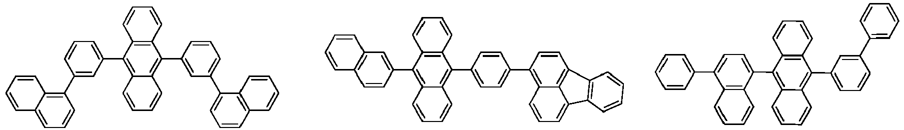

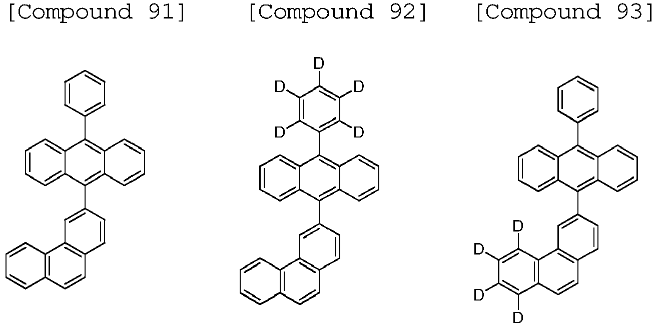

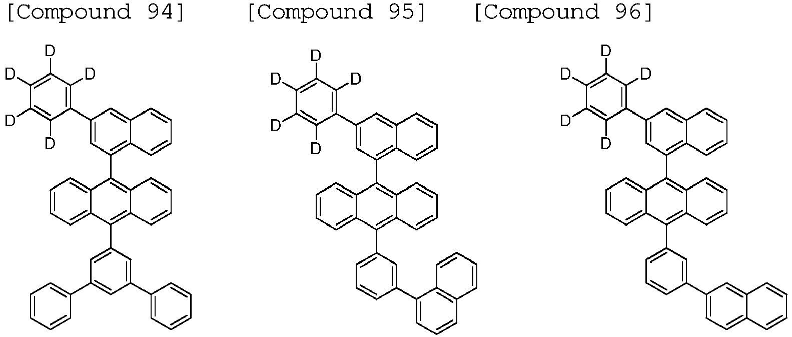

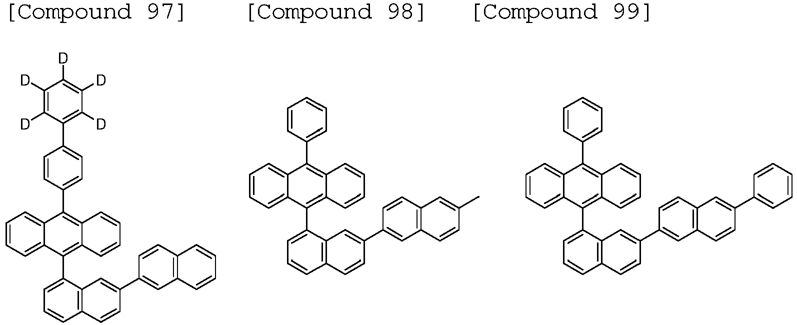

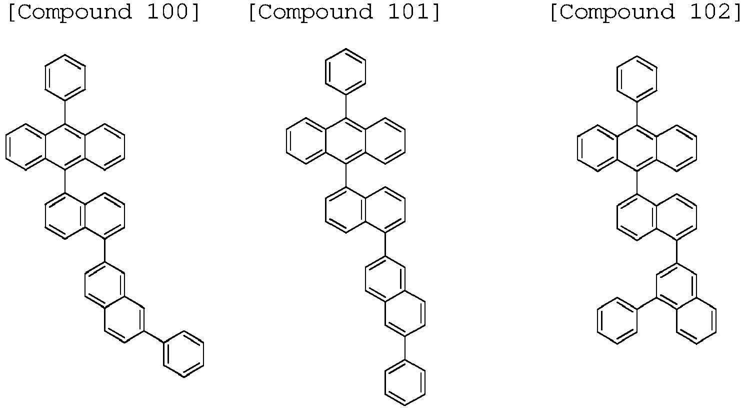

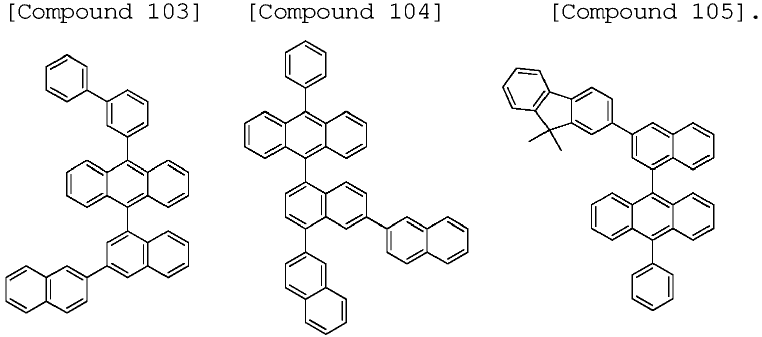

In addition, concrete examples of the anthracene derivative compound represented by Chemical Formula B according to the present disclosure include, but are not limited to, <Compound 201> to <Compound 353>:

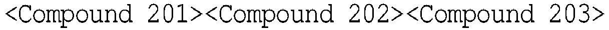

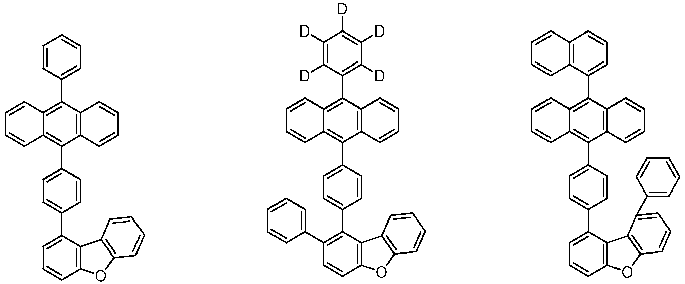

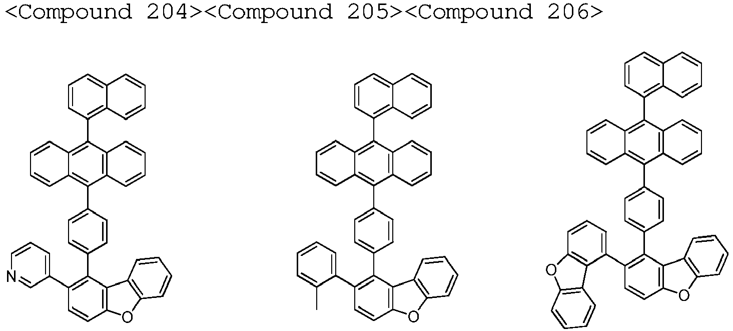

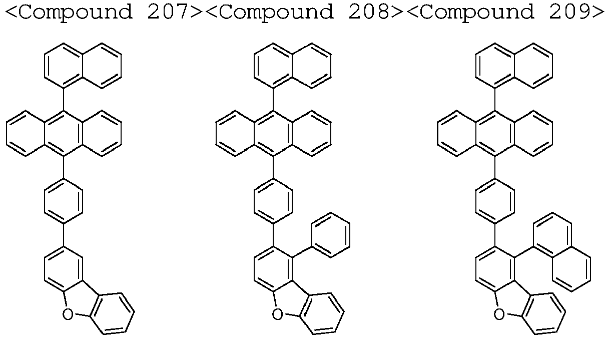

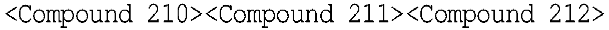

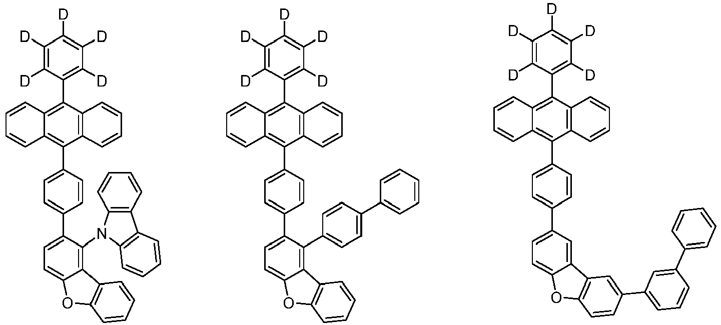

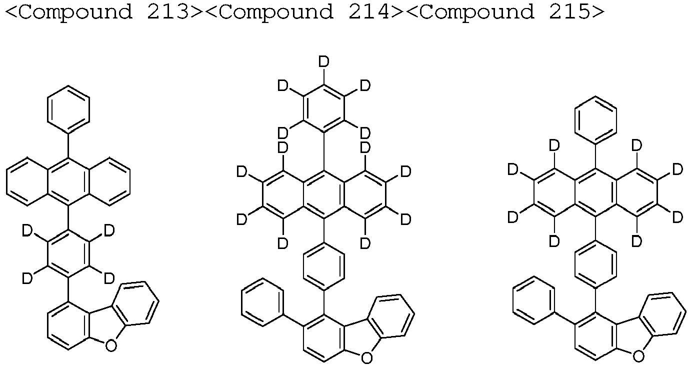

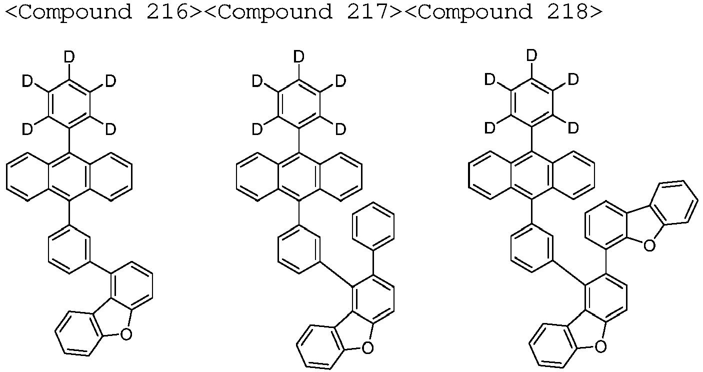

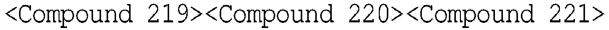

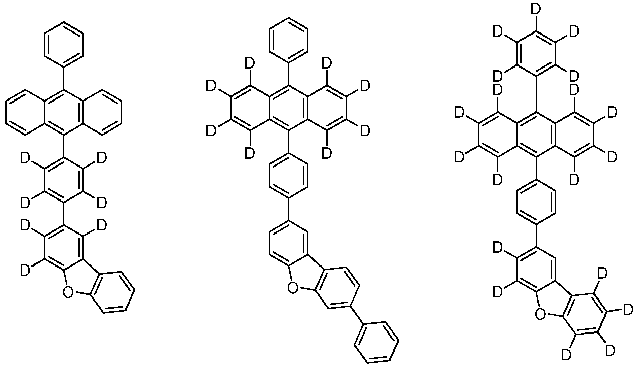

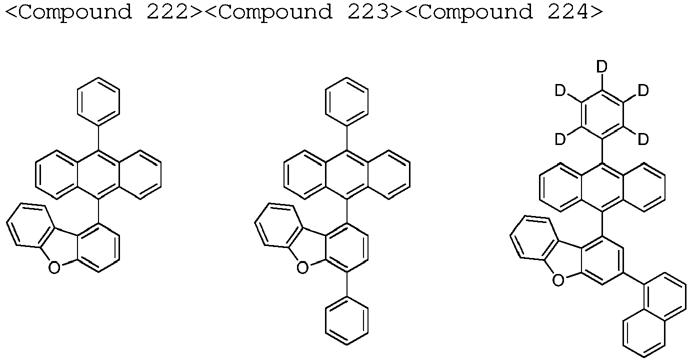

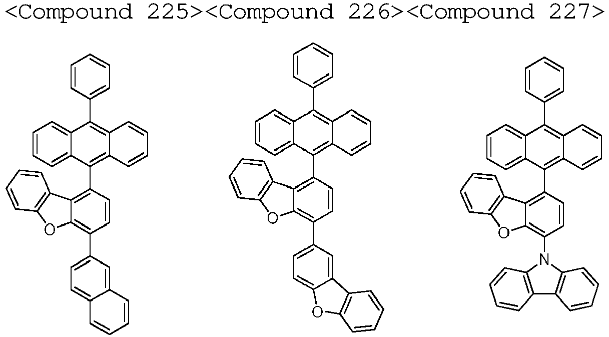

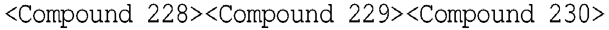

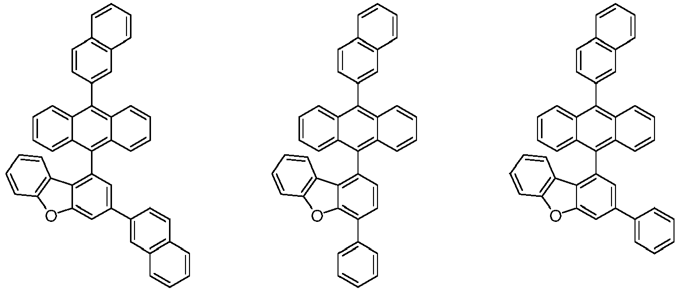

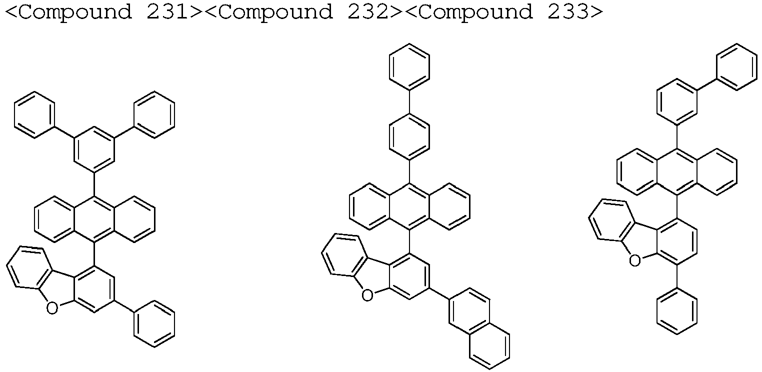

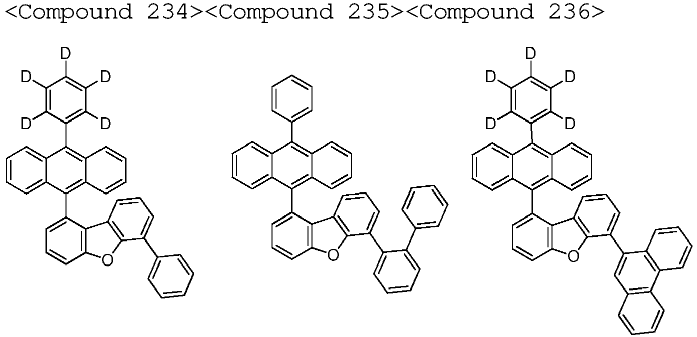

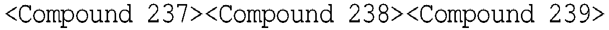

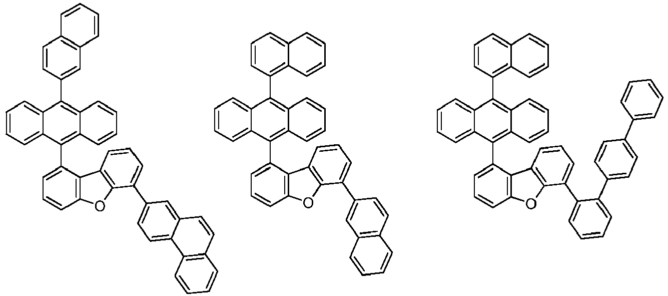

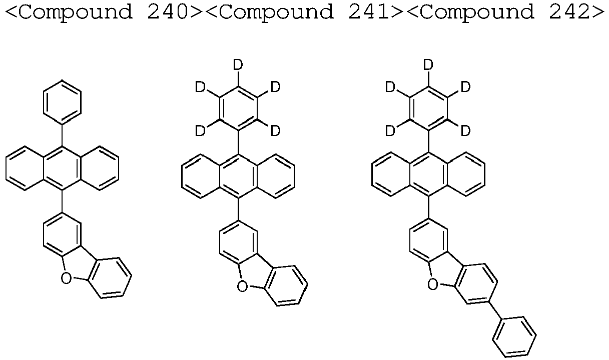

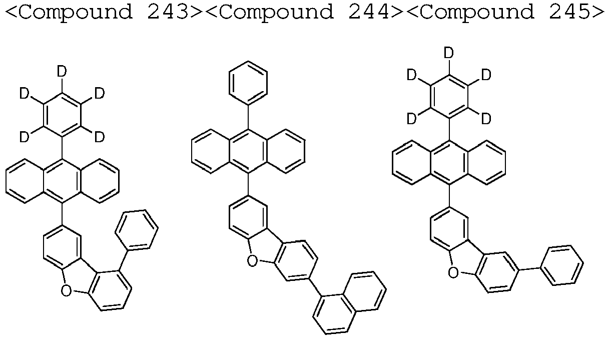

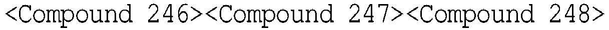

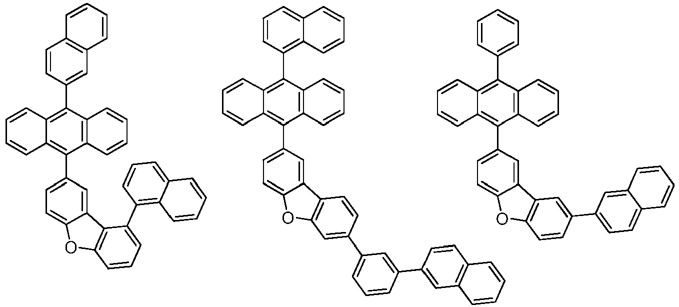

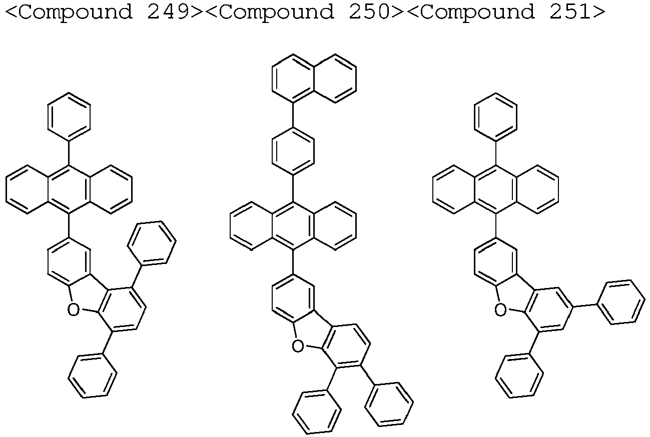

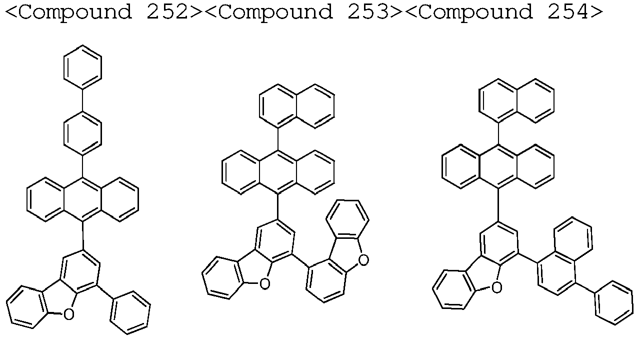

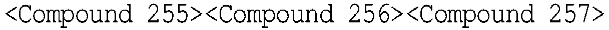

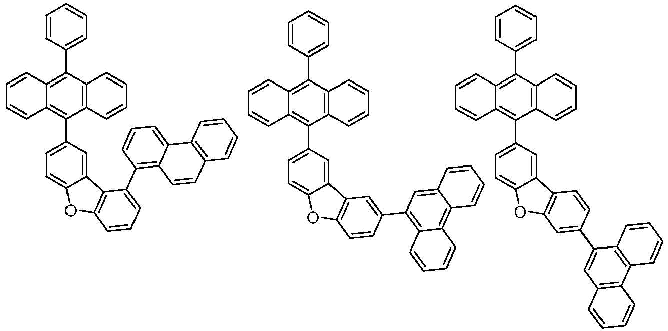

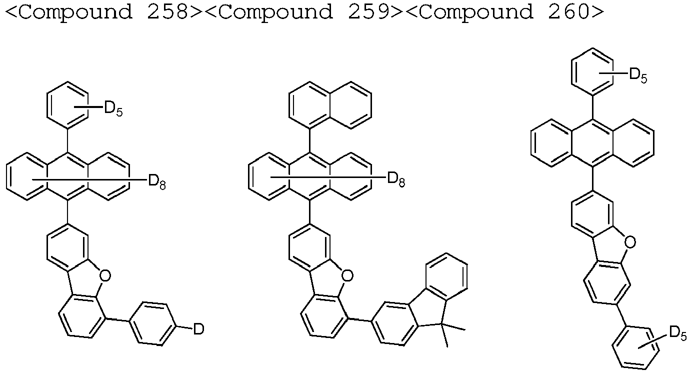

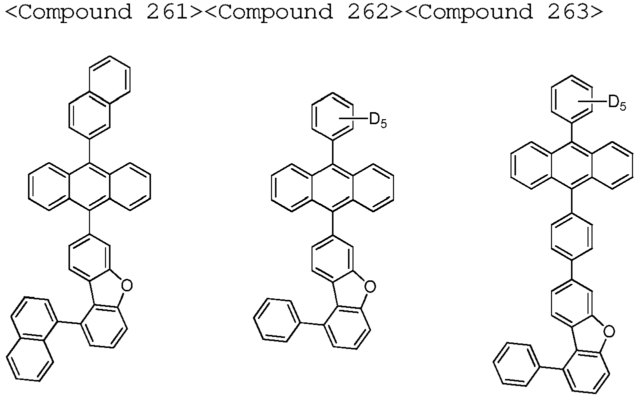

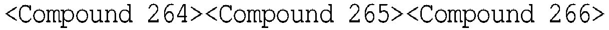

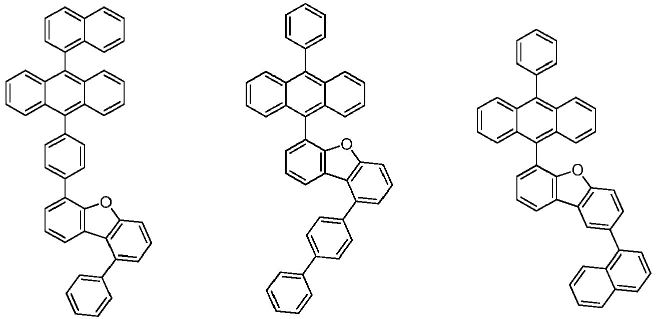

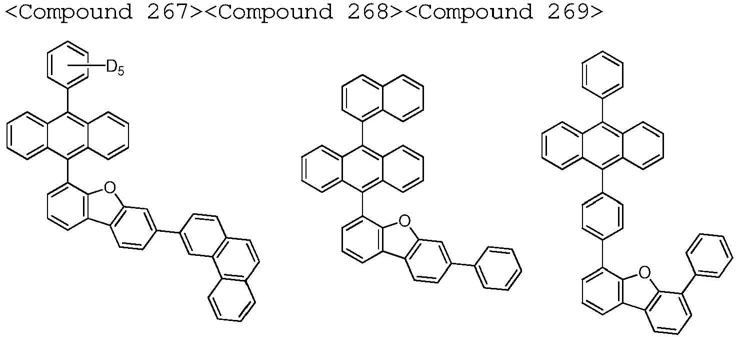

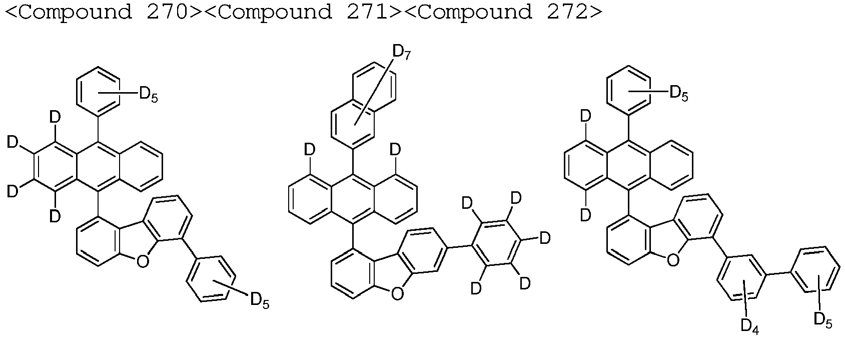

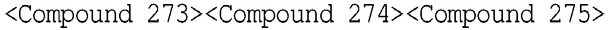

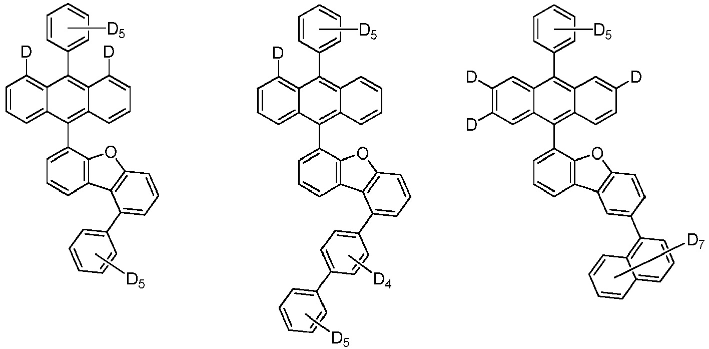

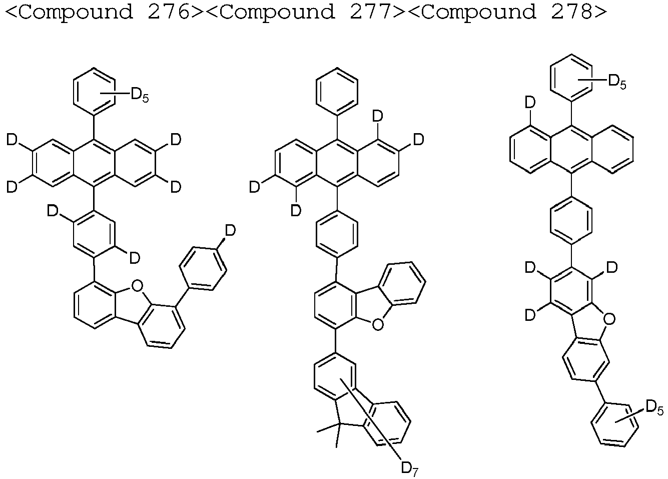

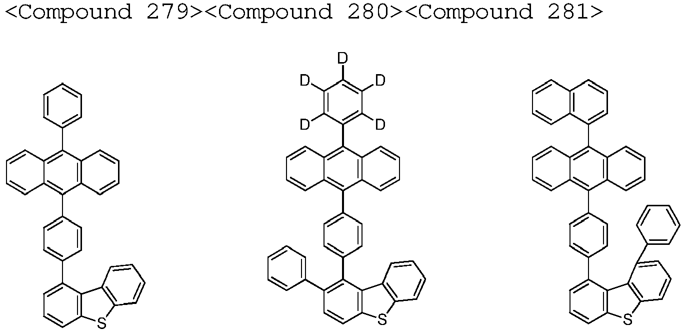

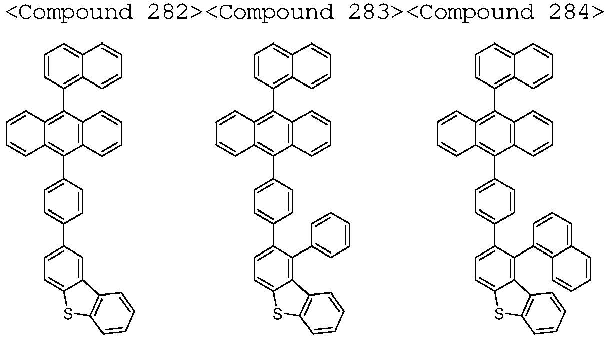

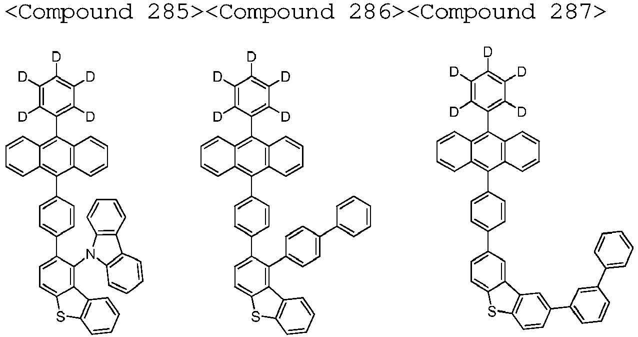

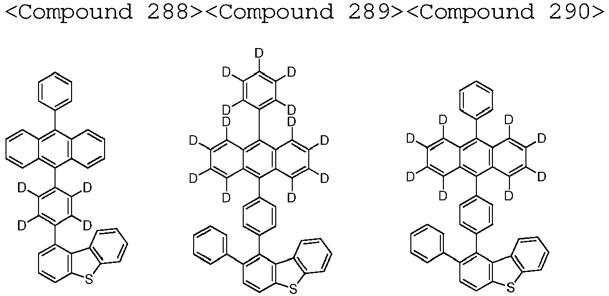

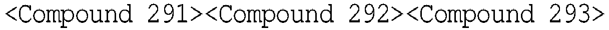

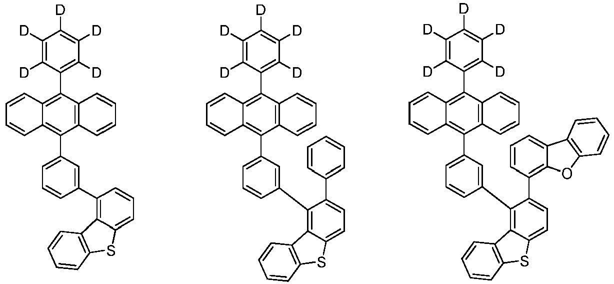

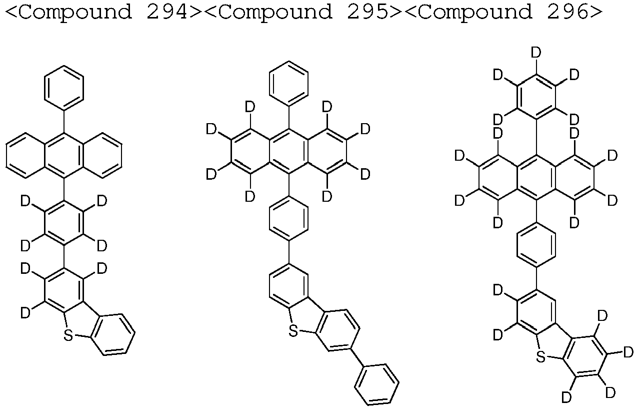

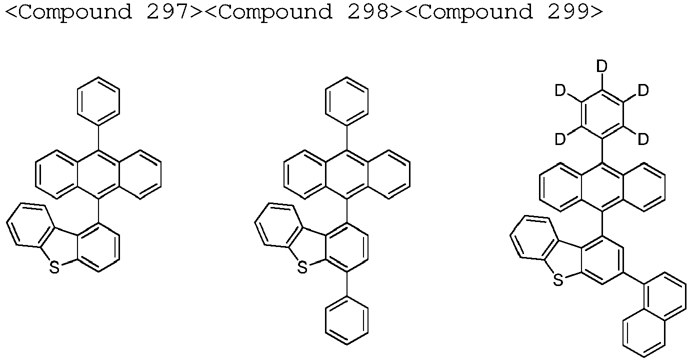

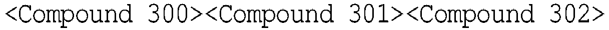

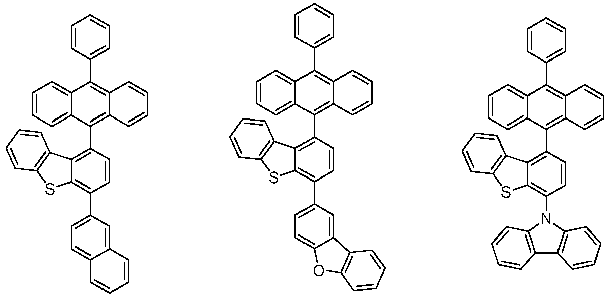

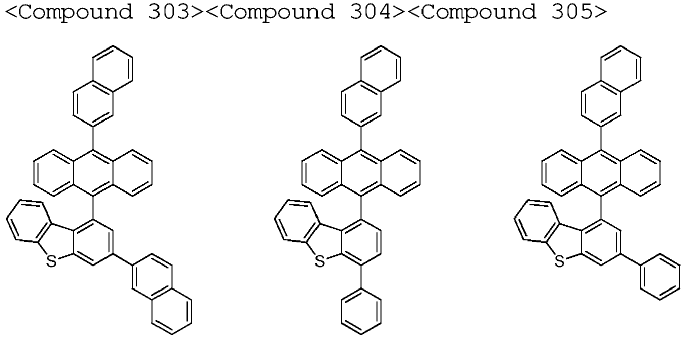

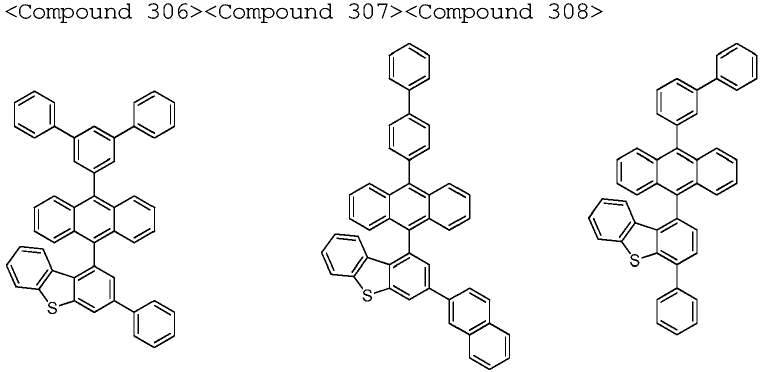

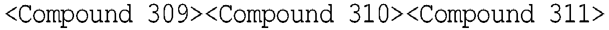

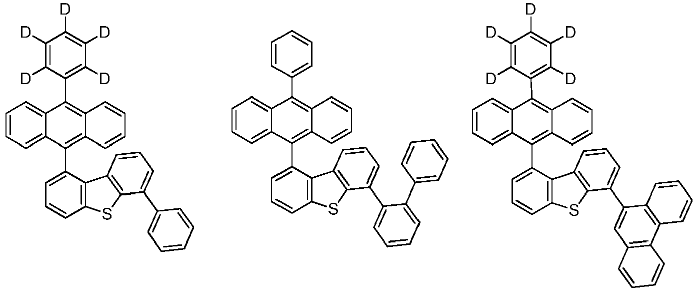

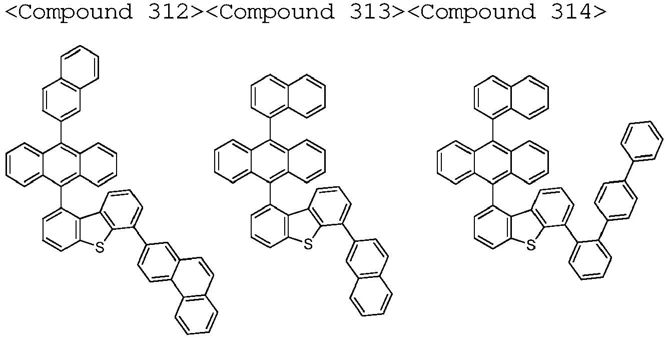

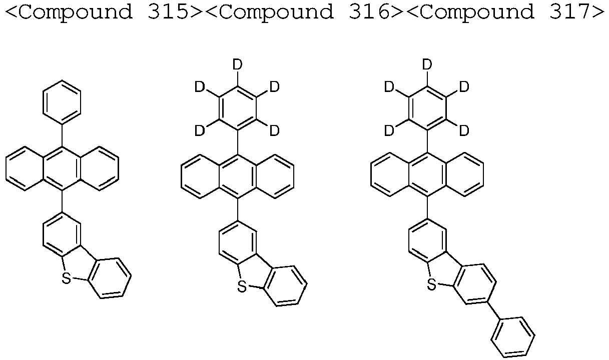

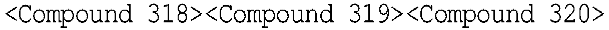

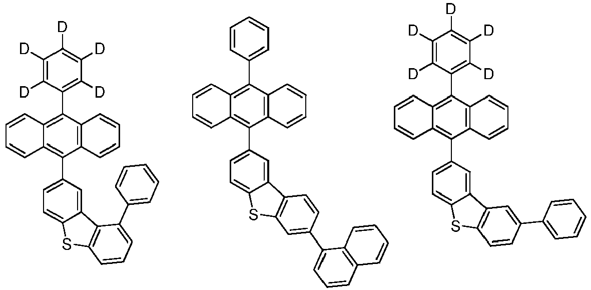

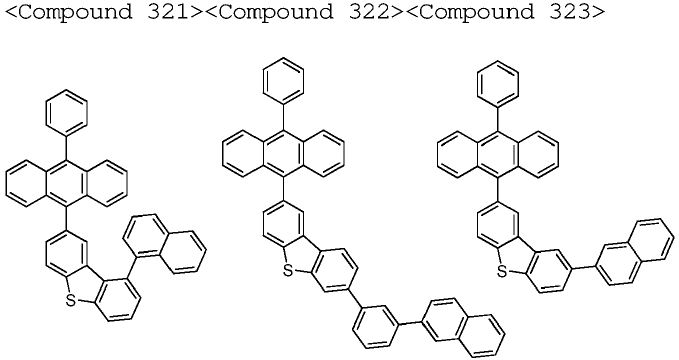

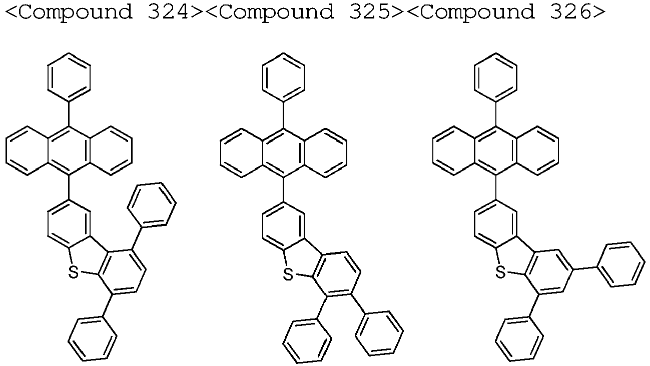

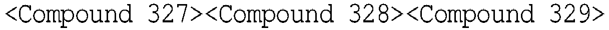

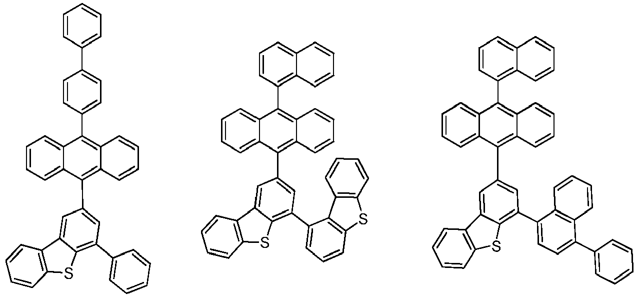

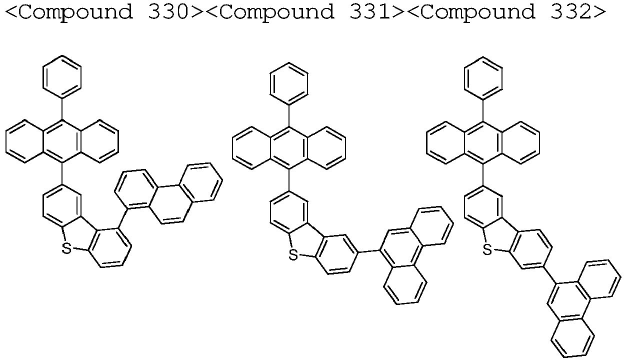

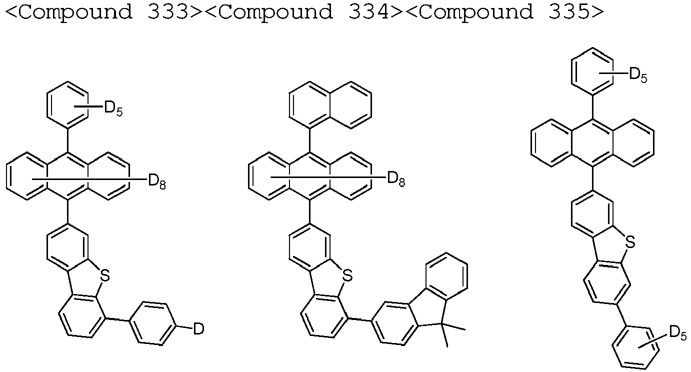

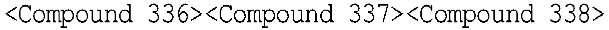

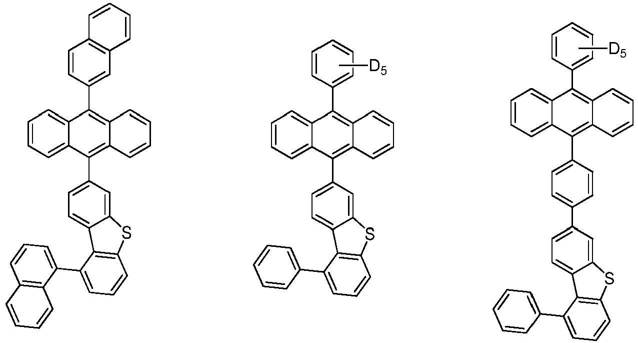

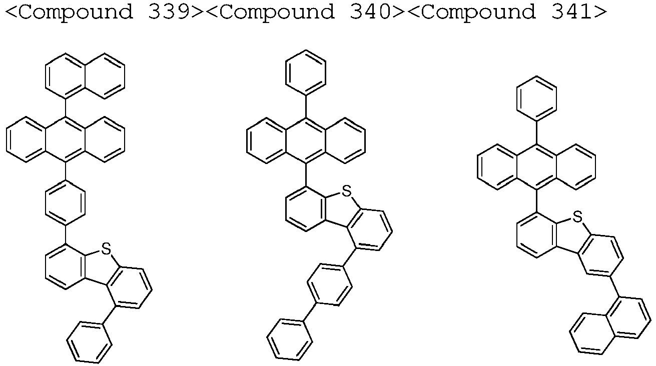

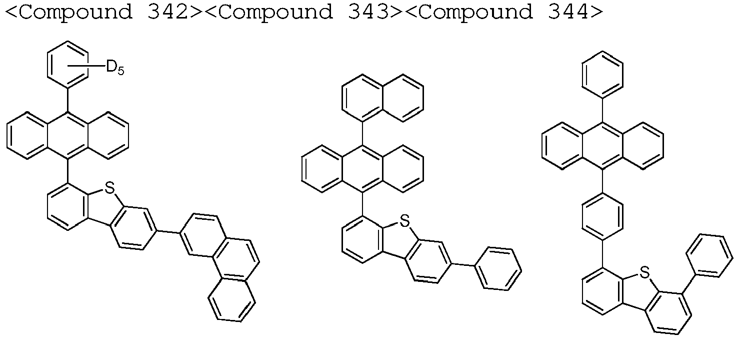

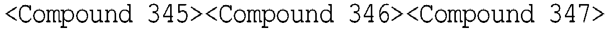

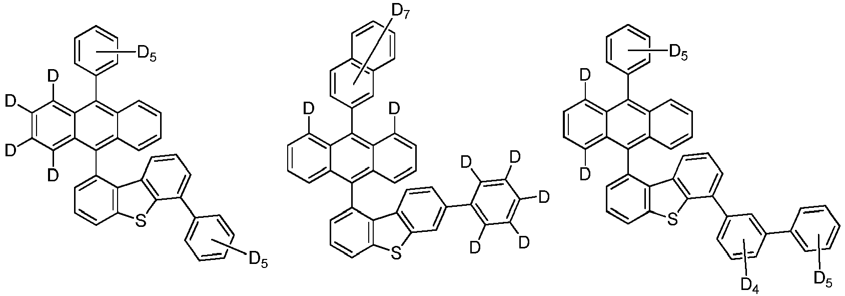

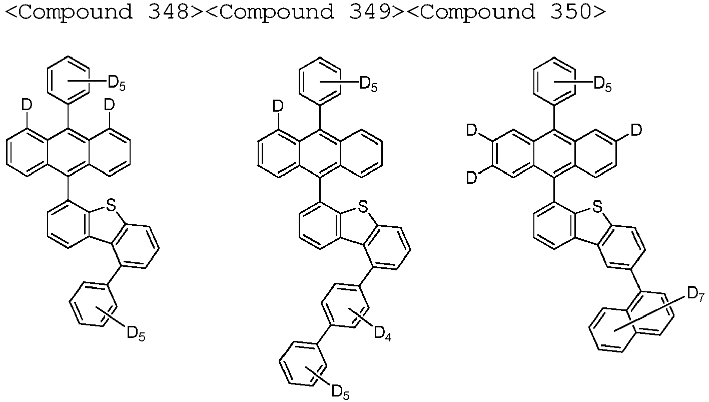

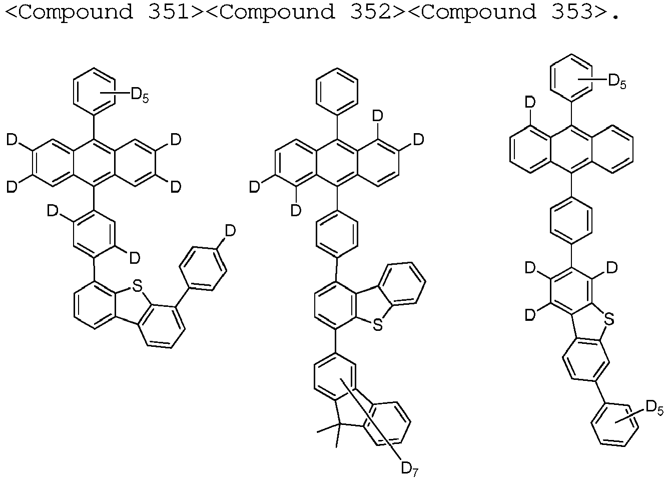

In addition, the light-emitting layer in the present disclosure may include, as a dopant compound, at least one of the compounds represented by the following [Chemical Formula D1] to [Chemical Formula D8]: 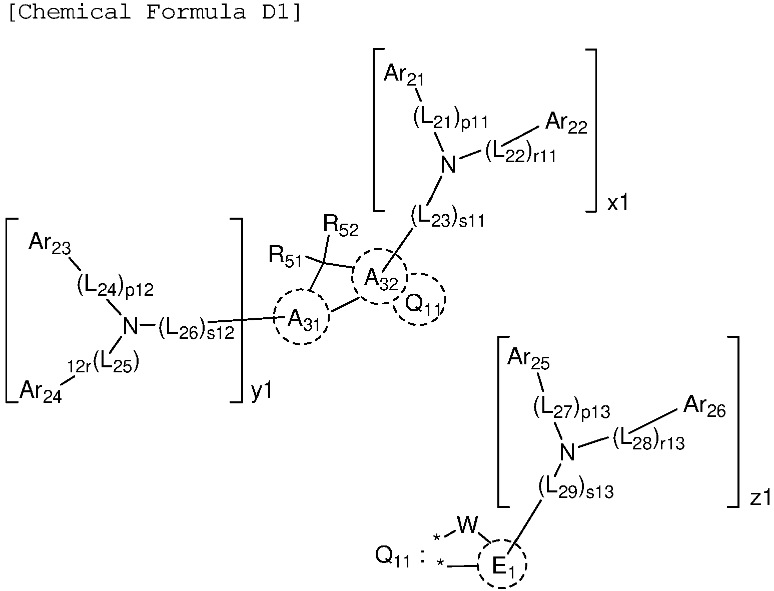 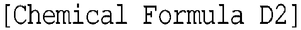 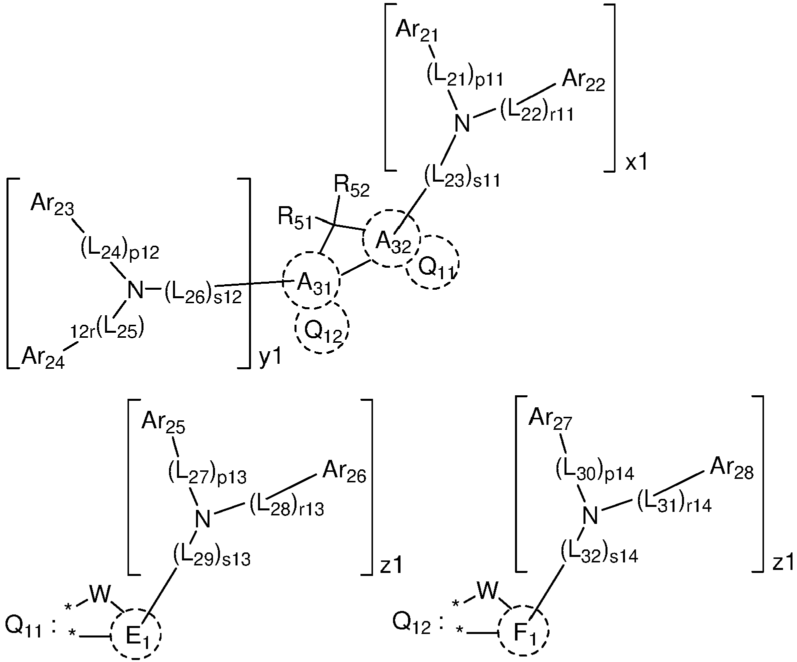 wherein,
A₃₁, A₃₂, E₁, and F₁ may be same or different and are each independently a substituted or unsubstituted aromatic hydrocarbon ring of 6 to 50 carbon atoms, or a substituted or unsubstituted heteroaromatic ring of 2 to 40 carbon atoms wherein two adjacent carbon atoms of the aromatic ring A₃₁ and two adjacent carbon atoms of the aromatic ring A₃₂ form a 5-membered fused ring together with a carbon atom to which substituents R₅₁ and R₅₂ are bonded;
linkers L₂₁ to L₃₂ may be same or different, and are each independently selected from among a single bond, a substituted or unsubstituted alkylene of 1 to 60 carbon atoms, a substituted or unsubstituted alkenylene of 2 to 60 carbon atoms, a substituted or unsubstituted alkynylene of 2 to 60 carbon atoms, a substituted or unsubstituted cycloalkylene of 3 to 60 carbon atoms, a substituted or unsubstituted heterocycloalkylene of 2 to 60 carbon atoms, a substituted or unsubstituted arylene of 6 to 60 carbon atoms, and a substituted or unsubstituted heteroarylene of 2 to 60 carbon atoms;
W is any one selected from among N-R₅₃, CR₅₄R₅₅, SiR₅₆R₅₇, GeF₅₈R₅₉, O, S, and Se;
R₅₁ to R₅₉, and Ar₂₁ to Ar₂₈ may be same or different, and are each independently any one selected from among a hydrogen atom, a deuterium atom, a substituted or unsubstituted alkyl of 1 to 30 carbon atoms, a substituted or unsubstituted aryl of 6 to 50 carbon atoms, a substituted or unsubstituted alkenyl of 2 to 30 carbon atoms, a substituted or unsubstituted alkynyl of 2 to 20 carbon atoms, a substituted or unsubstituted cycloalkyl of 3 to 30 carbon atoms, a substituted or unsubstituted cycloalkenyl of 5 to 30 carbon atoms, a substituted or unsubstituted heteroaryl of 2 to 50 carbon atoms, a substituted or unsubstituted heterocycloalkyl of 2 to 30 carbon atoms, a substituted or unsubstituted alkoxyl of 1 to 30 carbon atoms, a substituted or unsubstituted aryloxyl of 6 to 30 carbon atoms, a substituted or unsubstituted alkylthioxy of 1 to 30 carbon atoms, a substituted or unsubstituted arylthoxy of 5 to 30 carbon atoms, a substituted or unsubstituted alkylamine of 1 to 30 carbon atoms, a substituted or unsubstituted arylamine of 5 to 30 carbon atoms, a substituted or unsubstituted alkylsilyl of 1 to 30 carbon atoms, a substituted or unsubstituted arylsilyl of 5 to 30 carbon atoms, a substituted or unsubstituted alkylgermyl of 1 to 30 carbon atoms, a substituted or unsubstituted arylgermyl of 1 to 30 carbon atoms a cyano, a nitro, and a halogen, with a proviso that R₅₁ and R₅₂ together may form a mono- or polycyclic aliphatic or aromatic ring that may be a heterocyclic ring bearing a heteroatom selected from among N, O, P, Si, S, Ge, Se, and Te as a ring member;
p₁₁ to p₁₄, r₁₁ to r₁₄, and s₁₁ to s₁₄ are each independently an integer of 1 to 3, with a proviso that when any of them is 2 or greater, the corresponding linkers may be same or different,
x1 is an integer of 1 or 2, and y1 and z1 may be same or different and are each independently an integer of 0 to 3; and
Ar₂₁ may form a ring with Ar₂₂, Ar₂₃ may form a ring with Ar₂₄, Ar₂₅ may form a ring with Ar₂₆, and Ar₂₇ may form a ring with Ar₂₈;
two adjacent carbon atoms of the A₃₂ ring moiety of Chemical Formula D1 occupy respective positions * of Structural Formula Q₁₁ to form a fused ring, and
two adjacent carbon atoms of the A₃₁ ring moiety of Chemical Formula D2 occupy respective positions * of structural Formula Q₁₂ to form a fused ring, and two adjacent carbon atoms of the A₃₂ ring moiety of Chemical Formula D2 occupy respective positions * of structural Formula Q₁₁ to form a fused ring: 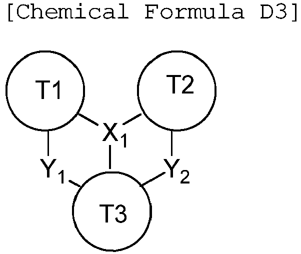 wherein,
   X₁ is any one selected from B, P, and P=O,
   T₁ to T₃, which are same or different, are each independently a substituted or unsubstituted aromatic hydrocarbon ring of 6 to 50 carbon atoms, or a substituted or unsubstituted heteroaromatic ring of 2 to 40 carbon atoms;
   Y₁ is any one selected from among N-R₆₁, CR₆₂R₆₃, O, S, and SiR₆₄R₆₅;
   Y₂ is any one selected from among N-R₆₆, CR₆₇R₆₈, O, S, SiR₆₉R₇₀,
   wherein R₆₁ to R₇₀, which may be same or different, are each independently any one selected from among a hydrogen atom, a deuterium atom, a substituted or unsubstituted alkyl of 1 to 30 carbon atoms, a substituted or unsubstituted aryl of 6 to 50 carbon atoms, a substituted or unsubstituted cycloalkyl of 3 to 30 carbon atoms, a substituted or unsubstituted heteroaryl of 2 to 50 carbon atoms, a substituted or unsubstituted alkoxy of 1 to 30 carbon atoms, a substituted or unsubstituted aryloxy of 6 to 30 carbon atoms, a substituted or unsubstituted alkylthioxy of 1 to 30 carbon atoms, a substituted or unsubstituted arylthioxy of 5 to 30 carbon atoms, a substituted or unsubstituted alkylamine of 1 to 30 carbon atoms, a substituted or unsubstituted arylamine of 5 to 30 carbon atoms, a substituted or unsubstituted alkylsilyl of 1 to 30 carbon atoms, a substituted or unsubstituted arylsilyl of 5 to 30 carbon atoms, a cyano, and a halogen and wherein at least one of R₆₁ to R₇₀ may be connected to at least one of T₁ to T₃ to form an additional mono- or polycyclic aliphatic or aromatic ring; 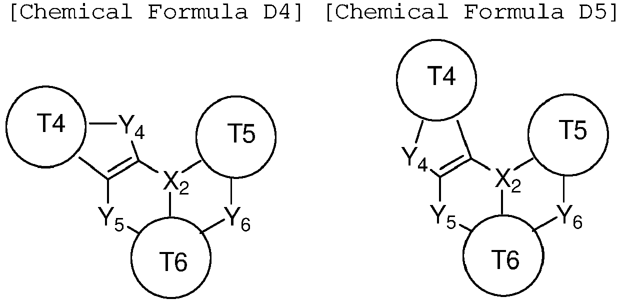 wherein,
      X₂ is any one selected from among B, P, and P=O,
      T₄ to T₆ are same or different and are as defined for T₁ to T₃ in Chemical Formula D3,
      Y₄ to Y₆ are same or different and are as defined for Y₁ to Y₂ in Chemical Formula D3; 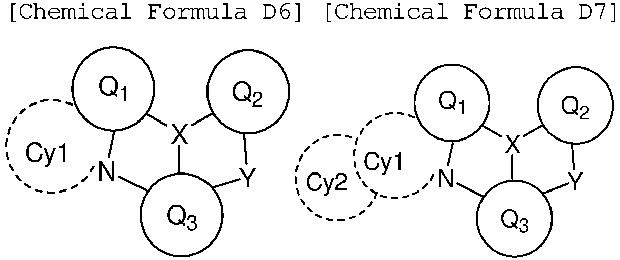 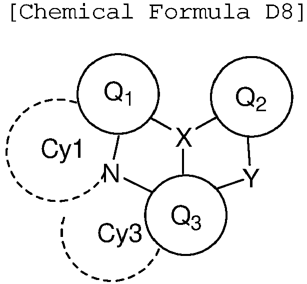 wherein,
         Q₁ to Q₃, which may be same or different, are each independently a substituted or unsubstituted aromatic hydrocarbon ring of 6 to 50 carbon atoms, or a substituted or unsubstituted heteroaromatic ring of 2 to 50 carbon atoms,
         Y is any one selected from N-R₇₃, CR₇₄R₇₅, O, S, and Se,
         X is any one selected from B, P, and P=O,
         R₇₃ to R₇₅, which may be same or different, are each independently any one selected from a hydrogen atom, a deuterium atom, a substituted or unsubstituted alkyl of 1 to 30 carbon atoms, a substituted or unsubstituted aryl of 6 to 50 carbon atoms, a substituted or unsubstituted cycloalkyl of 3 to 30 carbon atoms, a substituted or unsubstituted heteroaryl of 2 to 50 carbon atoms, a substituted or unsubstituted alkoxyl of 1 to 30 carbon atoms, a substituted or unsubstituted aryloxyl of 6 to 30 carbon atoms, a substituted or unsubstituted alkylthioxy of 1 to 30 carbon atoms, a substituted or unsubstituted arylthoxy of 5 to 30 carbon atoms, a substituted or unsubstituted alkylamine of 1 to 30 carbon atoms, a substituted or unsubstituted arylamine of 5 to 30 carbon atoms, a substituted or unsubstituted alkylsilyl of 1 to 30 carbon atoms, a substituted or unsubstituted arylsilyl of 5 to 30 carbon atoms, a nitro, a cyano, and a halogen, and
         R₇₃ to R₇₅ may each be connected to the Q₂ or Q₃ ring moiety to form an additional mono- or polycyclic aliphatic or aromatic,
         R₇₄ and R₇₅ may be connected to each other to form an additional mono- or polycyclic aliphatic or aromatic ring,
         the ring formed by Cy1 is a substituted or unsubstituted alkylene of 1 to 10 carbon atoms, except for the nitrogen (N) atom, the aromatic carbon atom of Q₁ to which the nitrogen (N) atom is connected, and the aromatic carbon atom of Q₁ to which Cy1 is to bond,
         Cy2 in Chemical Formula D7 forms a saturated hydrocarbon ring added to Cy1 wherein the ring formed by Cy2 is a substituted or unsubstituted alkylene of 1 to 10 carbon atoms, except for the carbon atoms included in Cy1, and
         the ring formed by Cy3 in Chemical Formula D8 is a substituted or unsubstituted alkylene of 1 to 10 carbon atoms, except for the aromatic carbon atom of Q₃ to which Cy3 is to bond, the aromatic carbon atom of Q₃ to which the nitrogen (N) atom is connected, the nitrogen (N) atom, and the carbon atom of Cy1 to which the nitrogen (N) atom is connected,
         wherein the term "substituted" in the expression "substituted or unsubstituted" used for compounds of Chemical Formulas D1 to D8 means having at least one substituent selected from the group consisting of a deuterium atom, a cyano, a halogen, a hydroxy, a nitro, an alkyl of 1 to 24 carbon atoms, a halogenated alkyl of 1 to 24 carbon atoms, a cycloalkyl of 3 to 30 carbon atoms, an alkenyl of 2 to 24 carbon atoms, an alkynyl of 2 to 24 carbon atoms, a heteroalkyl of 1 to 24 carbon atoms, an aryl of 6 to 24 carbon atoms, an arylalkyl of 7 to 24 carbon atoms, an alkylaryl of 7 to 24 carbon atoms, a heteroaryl of 2 to 24 carbon atoms, a heteroarylalkyl of 2 to 24 carbon atoms, al alkoxy of 1 to 24 carbon atoms, an alkylamino of 1 to 24 carbon atoms, an arylamino of 6 to 24 carbon atoms, a heteroarylamino of 1 to 24 carbon atoms, an alkylsilyl of 1 to 24 carbon atoms, an arylsilyl of 6 to 24 carbon atoms, and an aryloxy of 6 to 24 carbon atoms.

In Chemical Formulas D6 to D8, "Cy1" is linked to the nitrogen (N) atom and an aromatic carbon atom of the Q₁ ring to form a ring with the nitrogen (N) atom, the aromatic carbon atom of the Q₁ ring to which the nitrogen (N) atom is boned, and the aromatic carbon atom of the Q₁ ring to which Cy1 is to bond, and the ring formed by Cy1 may be a substituted or unsubstituted alkylene of 1 to 10 carbon atoms, particularly a substituted or unsubstituted alkylene of 2 to 7 carbon atoms, and more particularly a substituted or unsubstituted alkylene of 2 to 5 carbon atoms, except for the nitrogen (N) atom, the aromatic carbon atom of Q₁ to which the nitrogen (N) atom is bonded, and the aromatic carbon atom of Q₁ to which Cy1 is to bond.

In addition, the ring formed by "Cy2" in Chemical Formula D7 is a substituted or unsubstituted alkylene of 1 to 10 carbon atoms, particularly a substituted or unsubstituted alkylene of 2 to 7 carbon atoms, and more particularly a substituted or unsubstituted alkylene of 2 to 5 carbon atoms, except for the carbon atoms shared by Cy1.

Turning to 'Cy3' in Chemical Formula D8, it is linked to both the carbon atom boned to the nitrogen atom in Cy1 and the aromatic carbon atom of Q₃ ring to which Cy3 is to bond so as to form a fused ring with the aromatic carbon atom of Q3 ring to which Cy3 is to bond, the nitrogen (N) atom, and the carbon atom of Cy1 to which the nitrogen (N) atom is bonded, and the ring formed by Cy3 is a substituted or unsubstituted alkylene of 1 to 10 carbon atoms, particularly a substituted or unsubstituted alkylene of 2 to 7 carbon atoms, and more particularly a substituted or unsubstituted alkylene of 2 to 5 carbon atoms, except for the aromatic carbon atom of Q₃ to which Cy3 is to bond, the aromatic carbon atom of Q₃ to which the nitrogen (N) atom is bonded, the nitrogen (N) atom, and the carbon atom of Cy1 to which the nitrogen (N) atom is bonded.

Among the dopant compounds according to the present disclosure, the boron compounds represented by Chemical Formulas D3 to D8 may have, on the aromatic hydrocarbon rings or heteroaromatic rings of T₁ to T₆ or on the aromatic hydrocarbon rings or heteroaromatic rings of Q₁ to Q₃, a substituent selected from a deuterium atom, an alkyl of 1 to 24 carbon atoms, an aryl of 6 to 24 carbon atoms, an alkylamino of 1 to 24 carbon atoms, an arylamino of 6 to 24 carbon atoms, wherein the alkyl radicals or the aryl radicals in the alkylamino of 1 to 24 carbon atoms and the arylamino of 6 to 24 carbon atoms on the rings may be linked to each other, and particularly a substituent selected from an alkyl of 1 to 12 carbon atoms, an aryl of 6 to 18 carbon atoms, an alkylamino of 1 to 12 carbon atoms, and an arylamino of 6 to 18 carbon atoms wherein the alkyl radicals or aryl radicals in the alkylamino of 1 to 12 carbon atoms and the arylamino of 6 to 18 carbon atoms on the rings may be linked to each other.

In the present disclosure, the host including the anthracene compound represented by Chemical Formula A and the anthracene compound represented by Chemical Formula B may be used together with the dopant material.

Concrete examples of the dopant compounds of Chemical Formulas D1 and D2 used in the light-emitting layer include the compounds of the following Chemical Formulas d1 to d239:

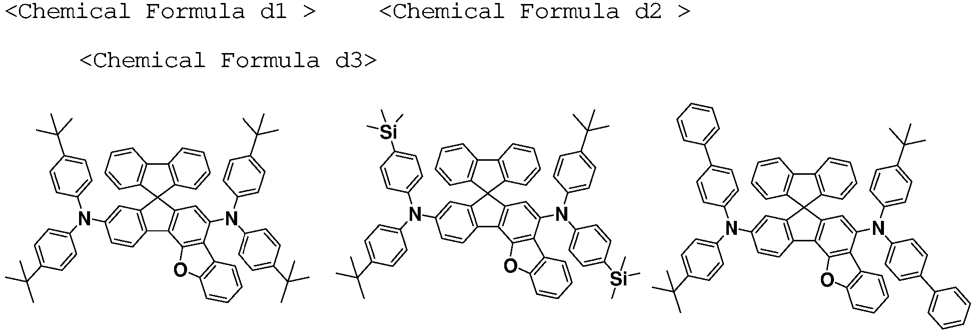

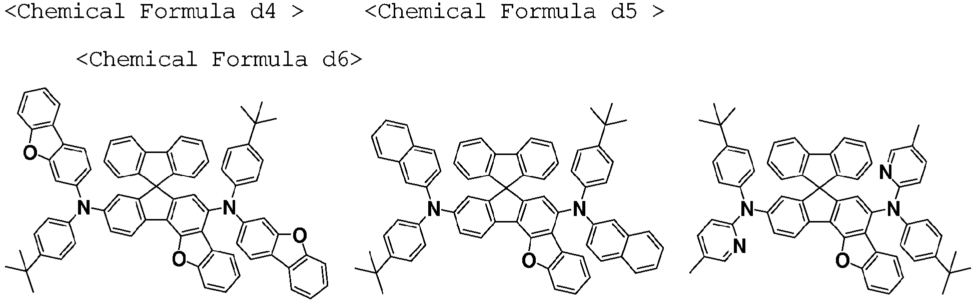

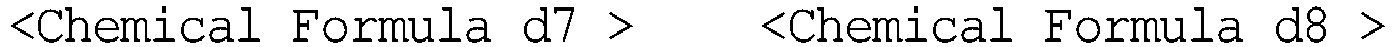

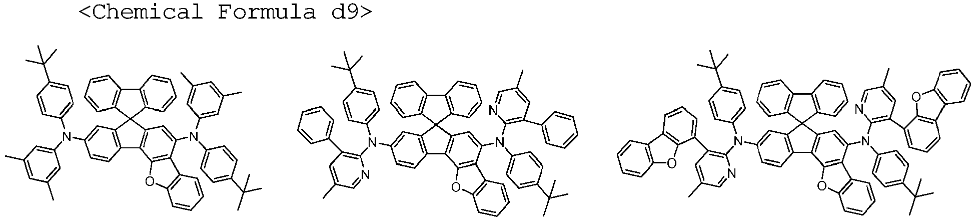

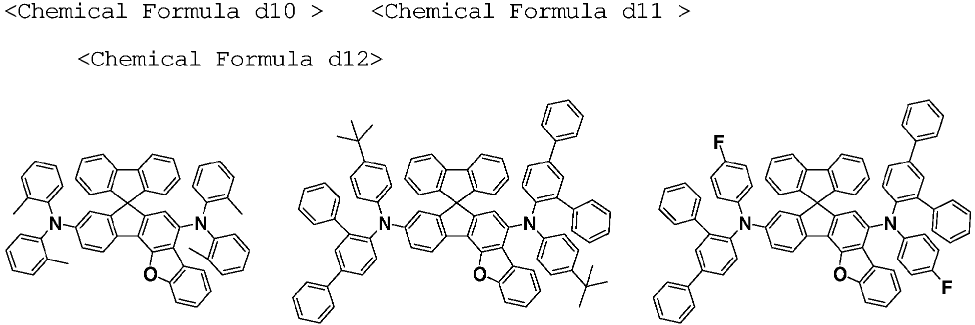

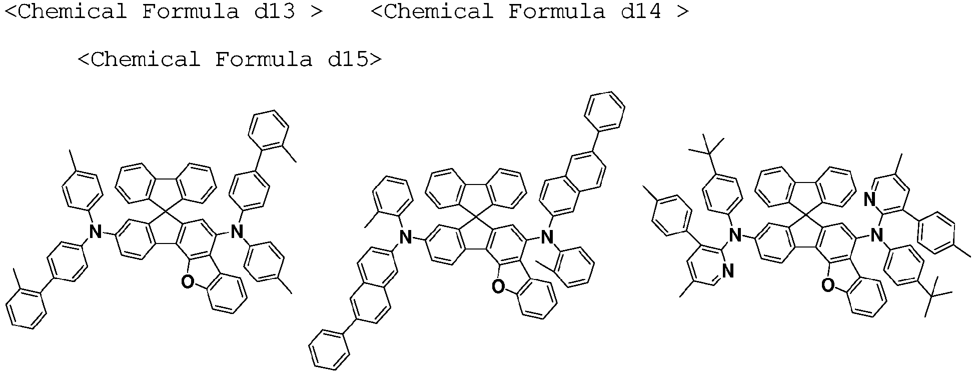

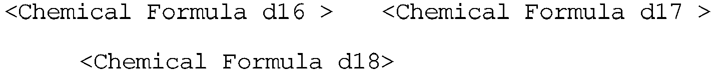

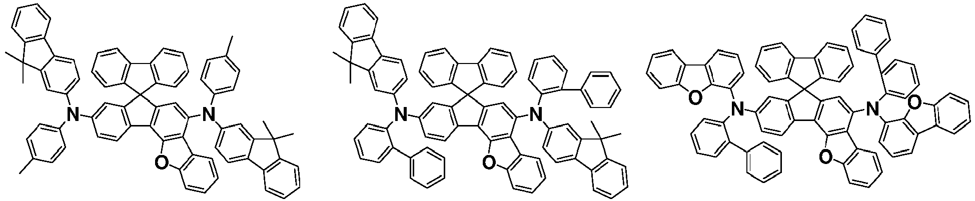

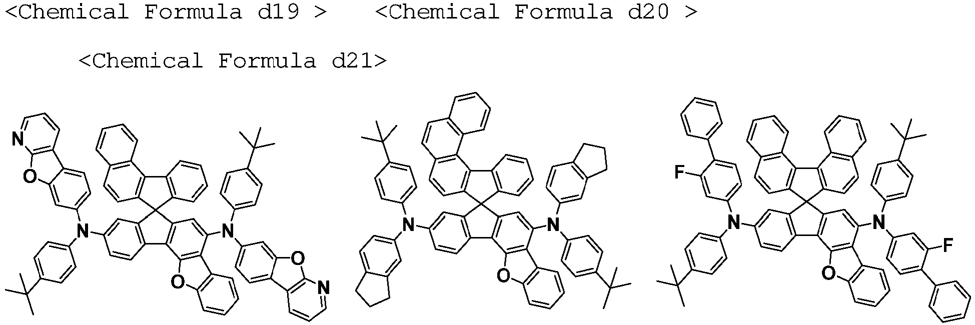

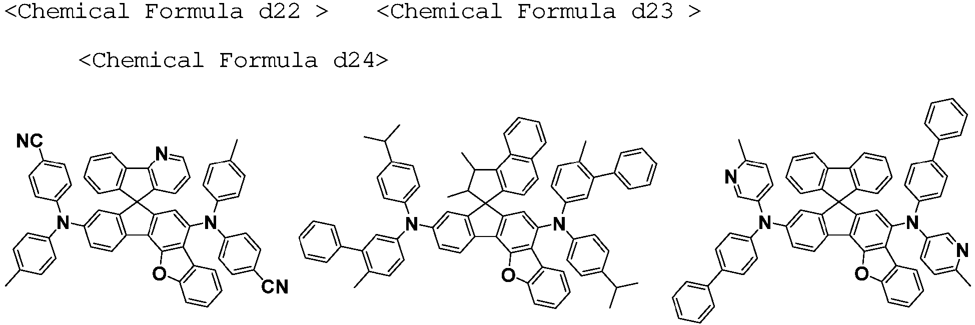

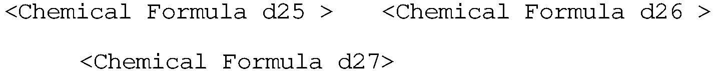

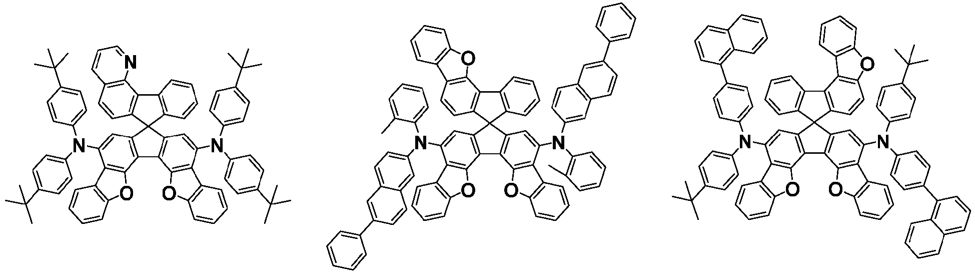

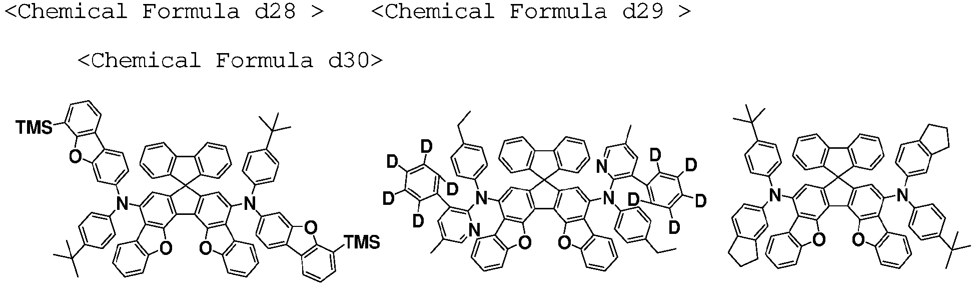

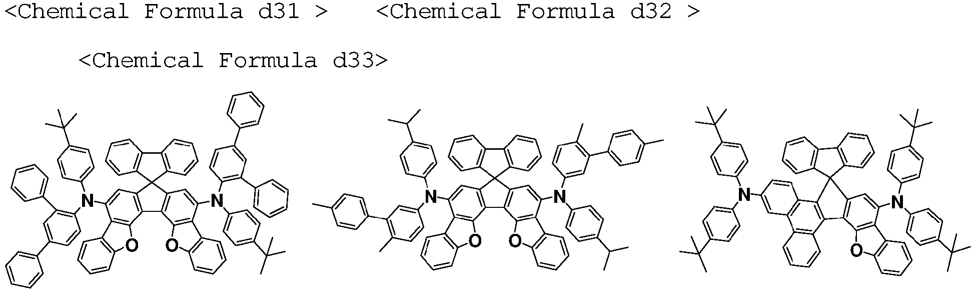

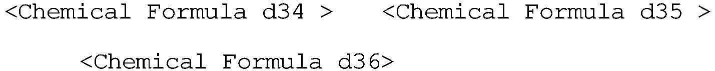

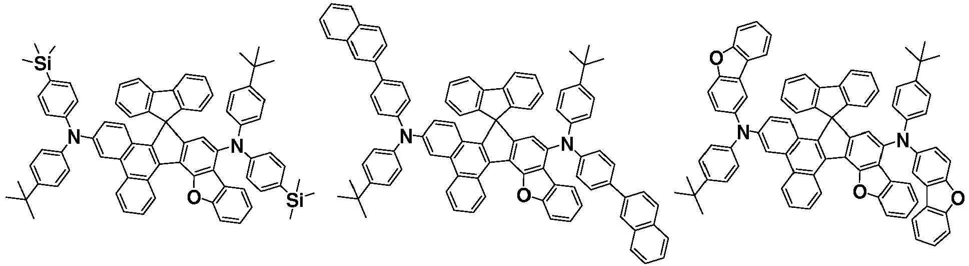

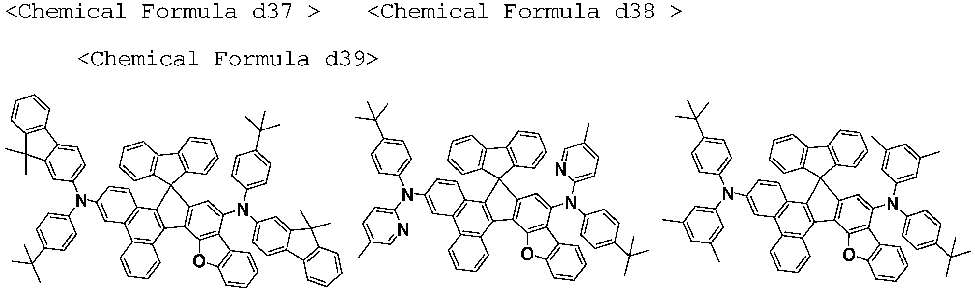

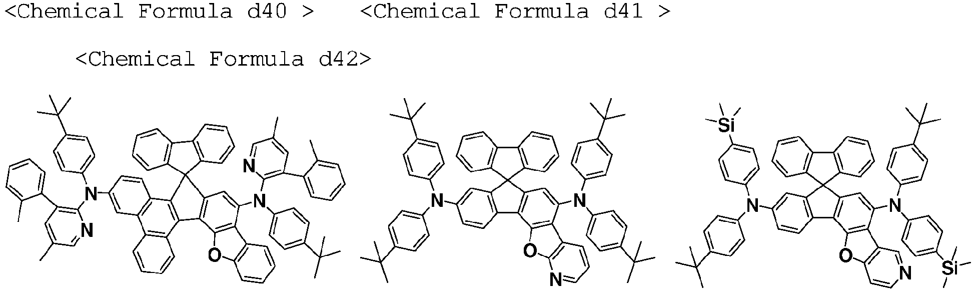

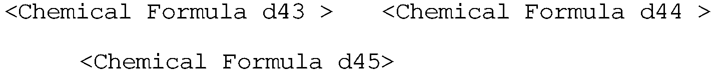

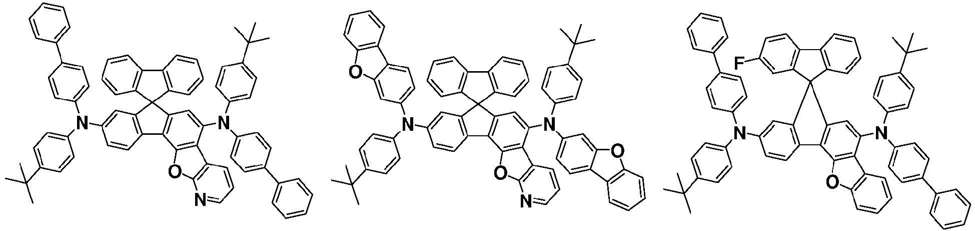

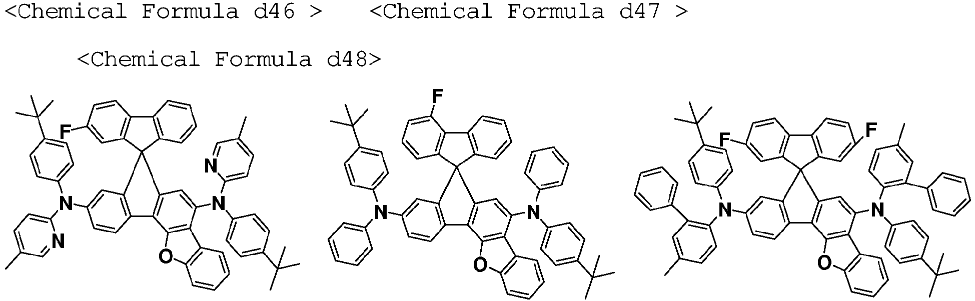

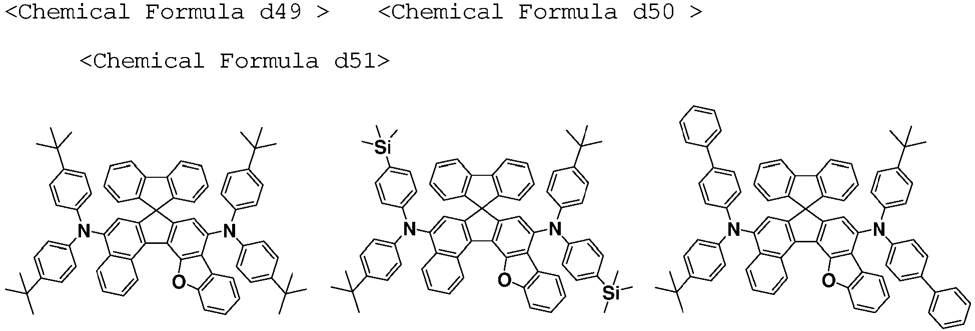

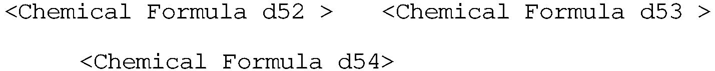

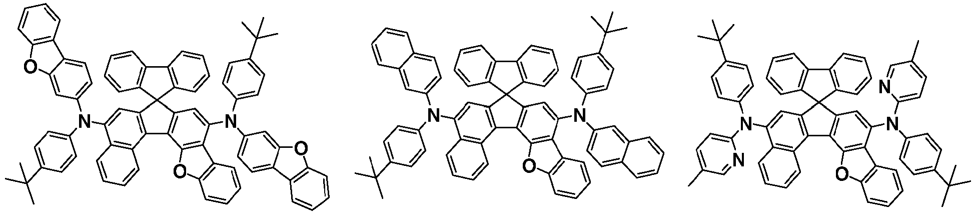

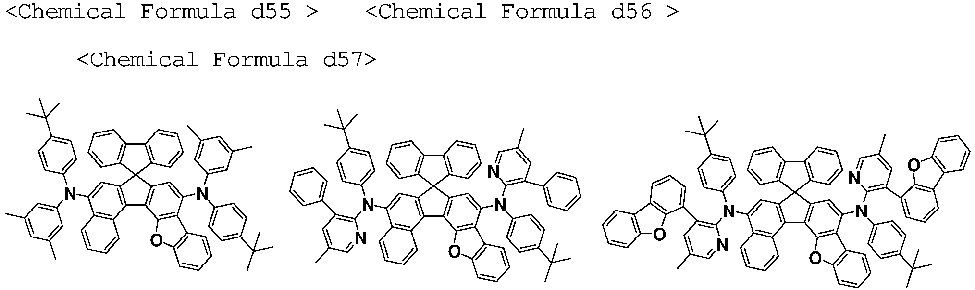

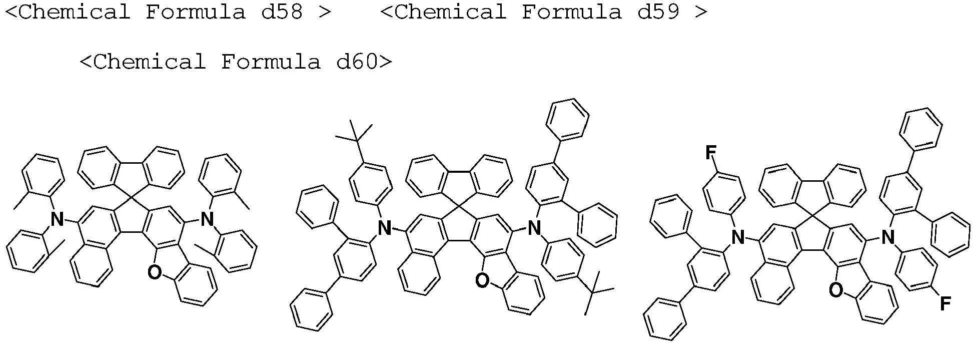

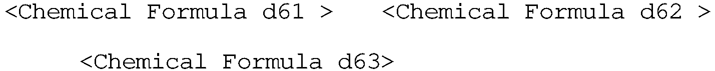

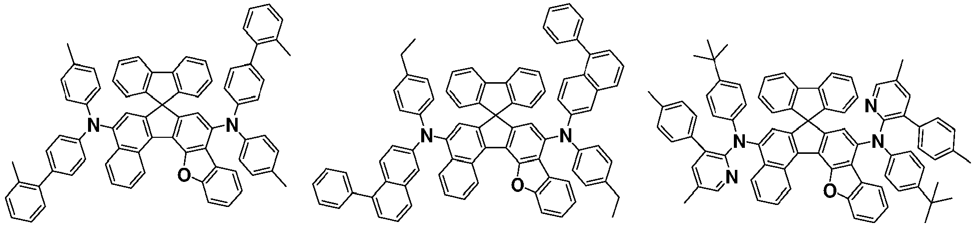

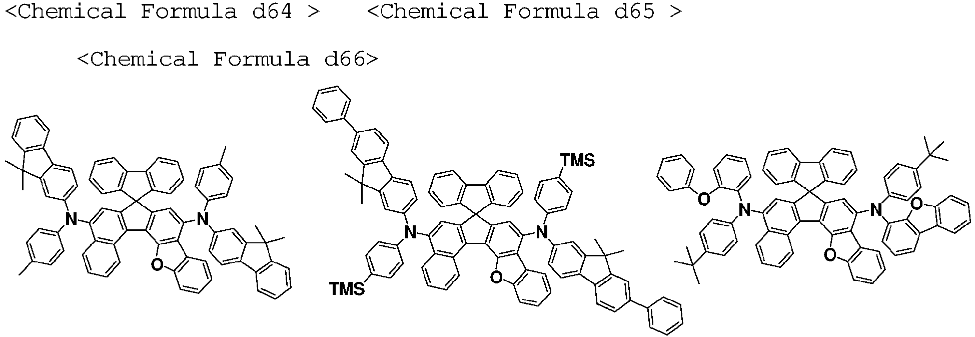

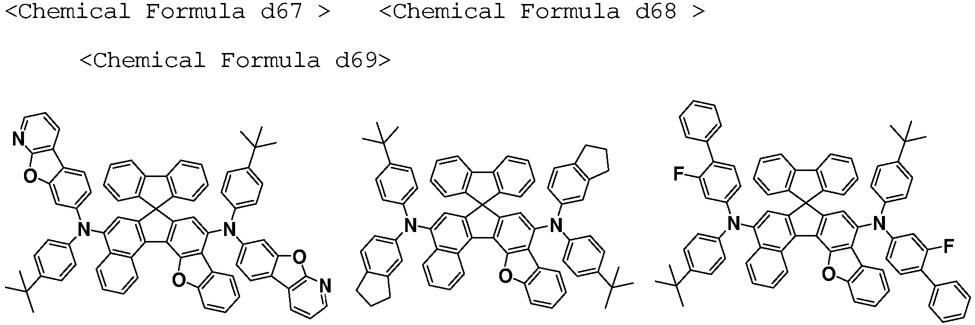

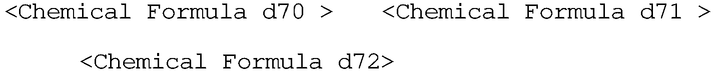

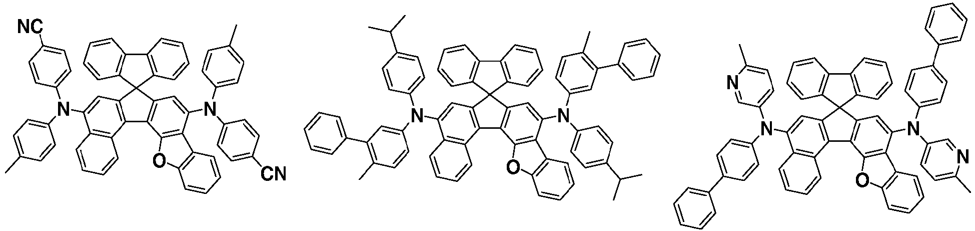

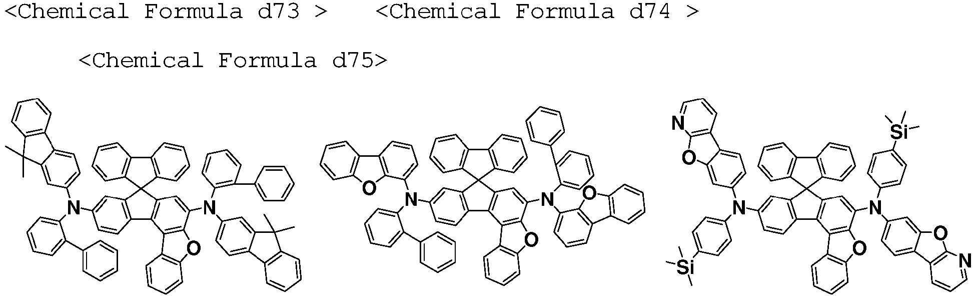

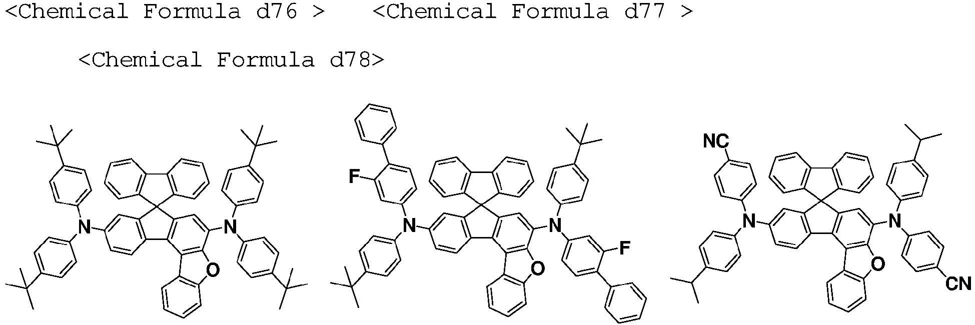

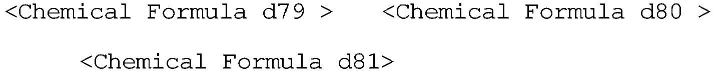

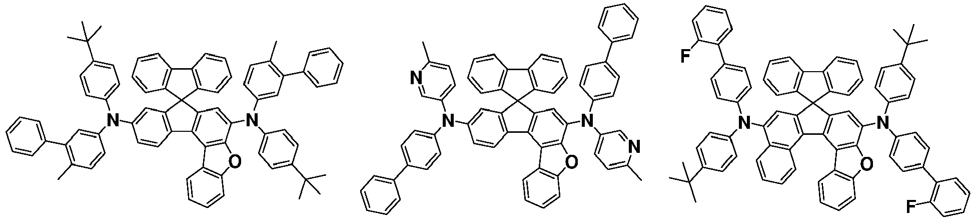

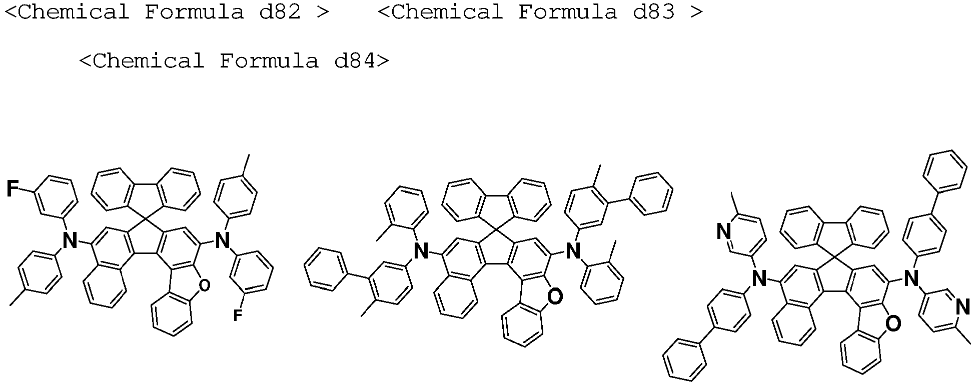

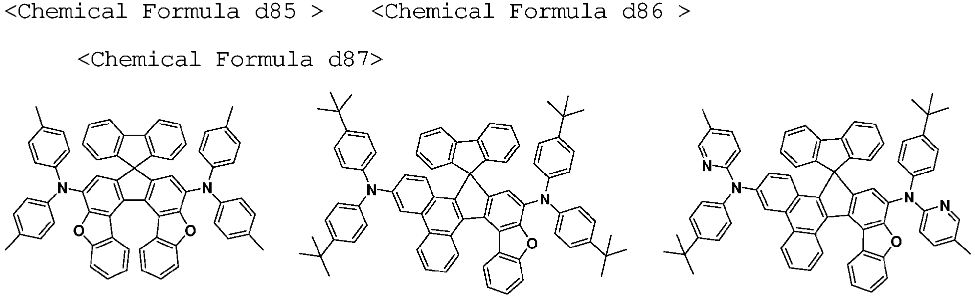

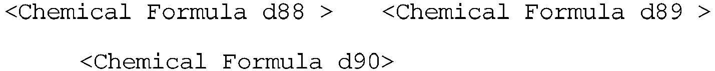

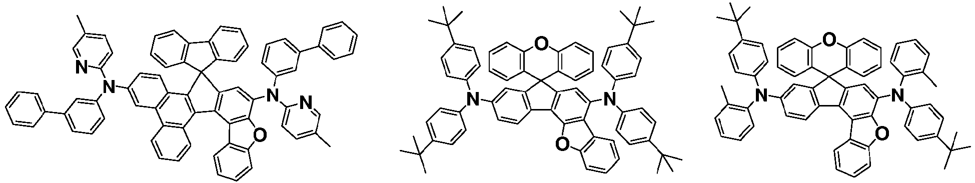

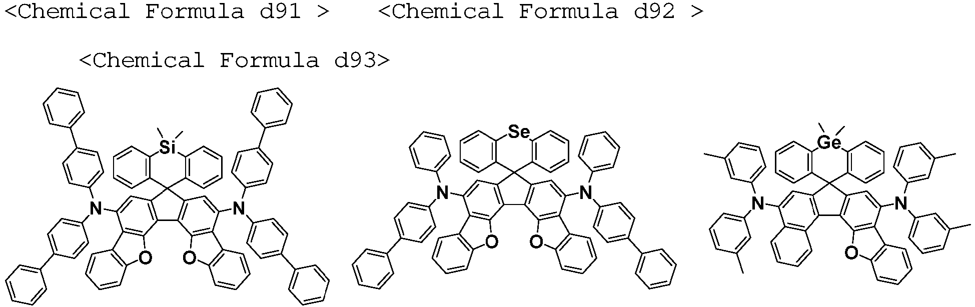

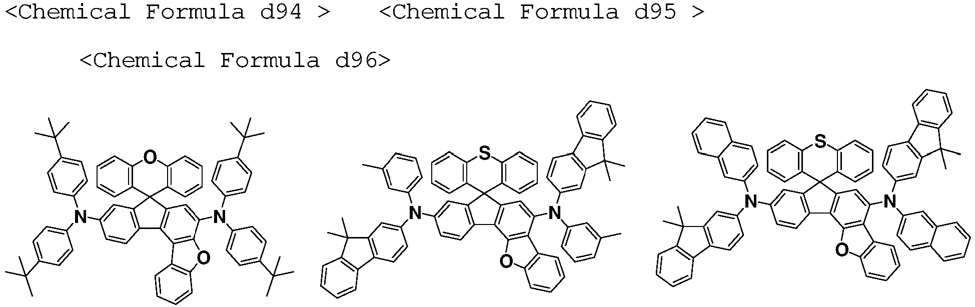

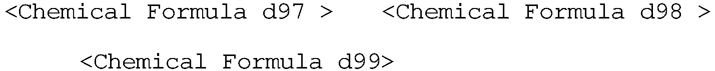

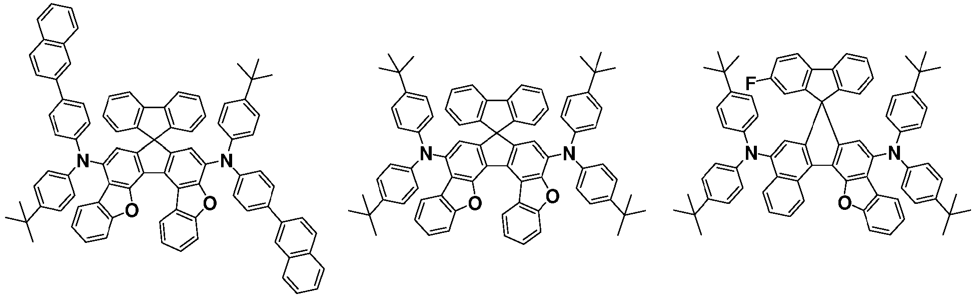

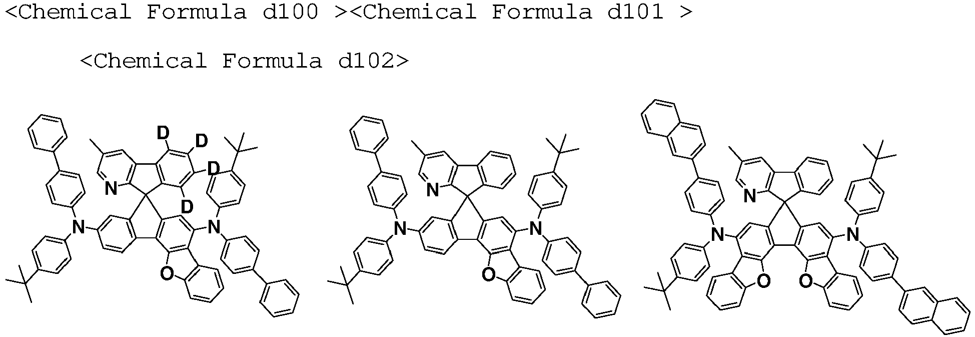

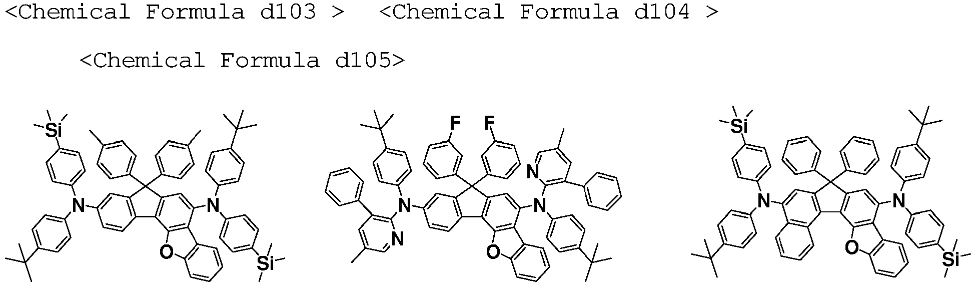

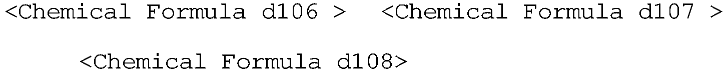

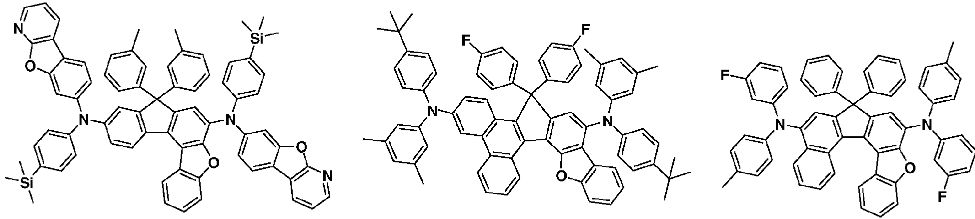

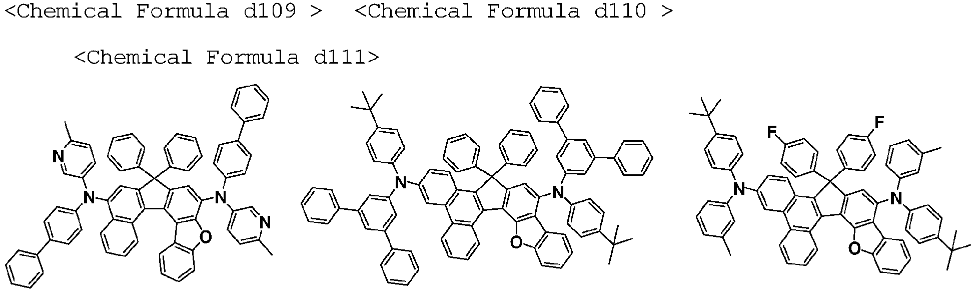

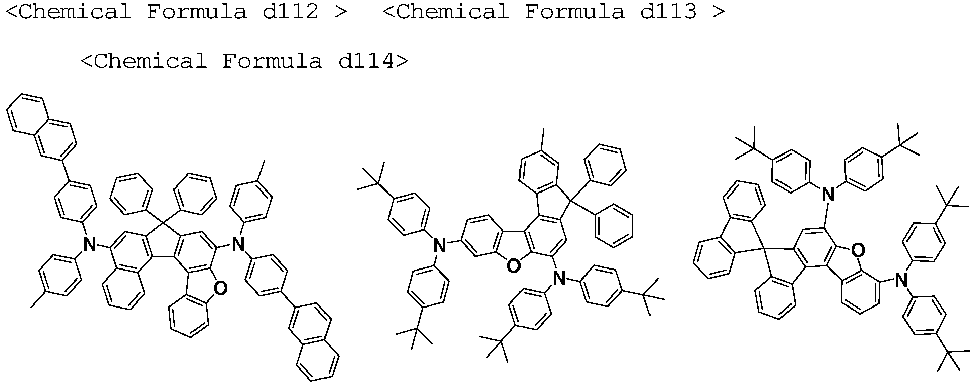

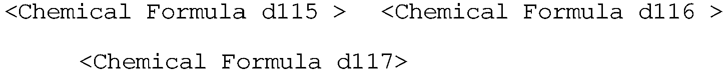

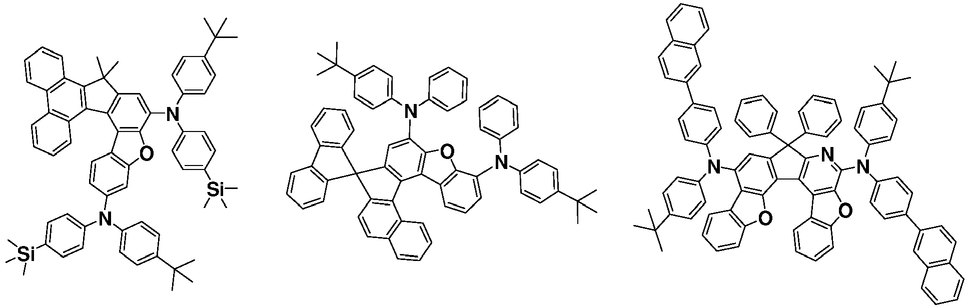

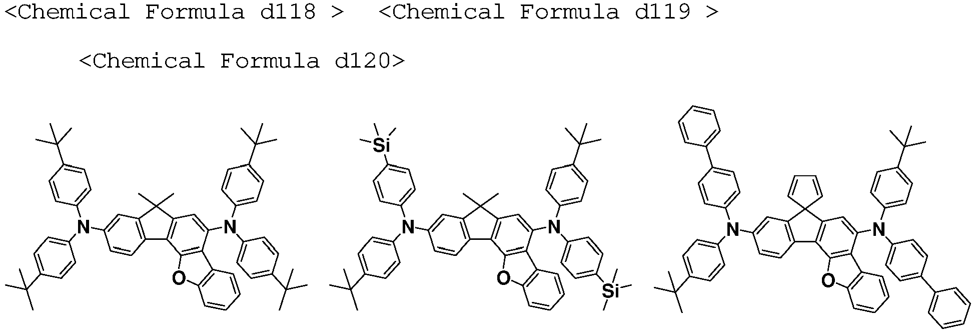

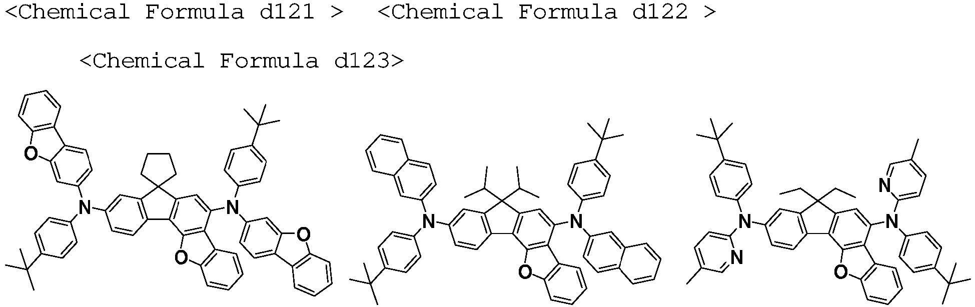

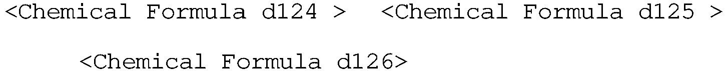

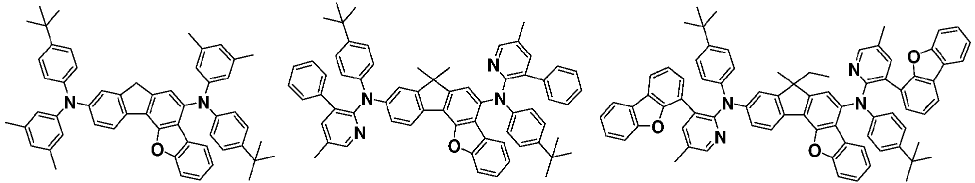

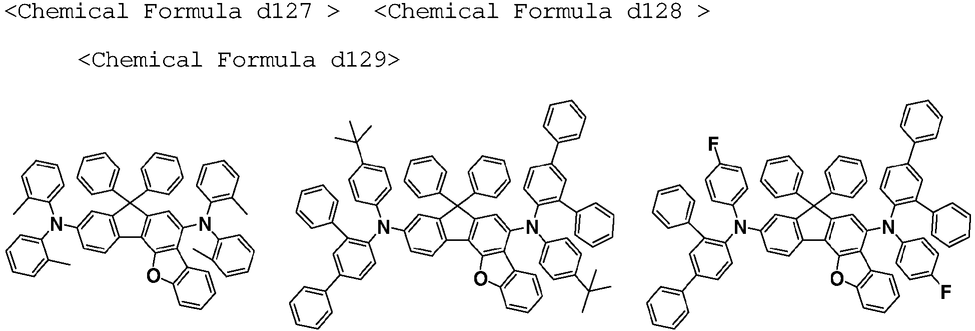

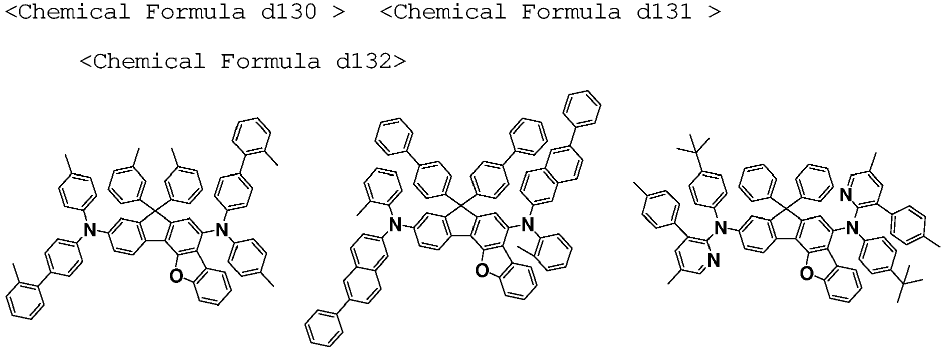

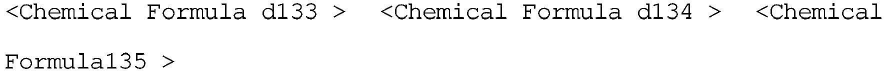

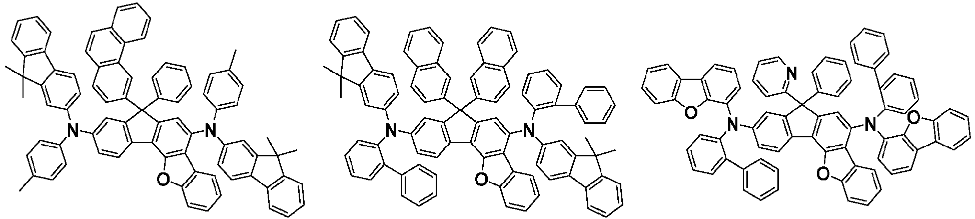

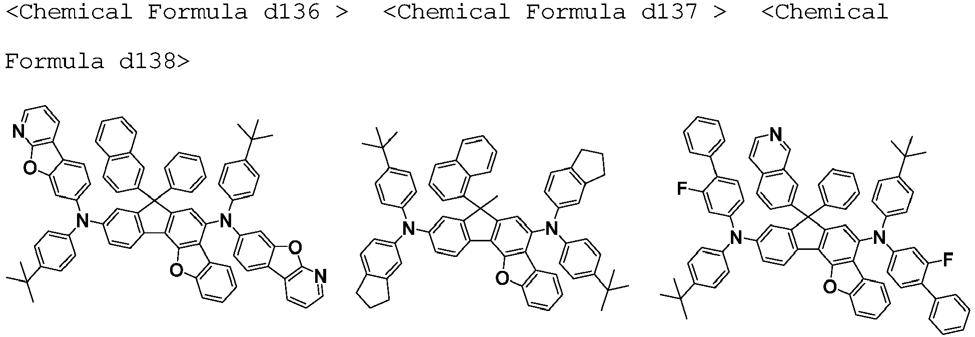

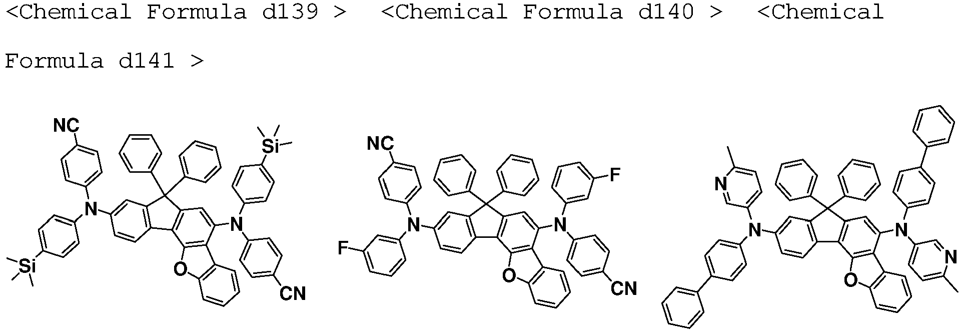

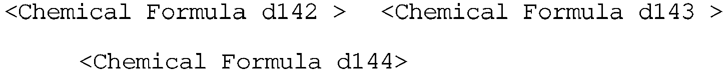

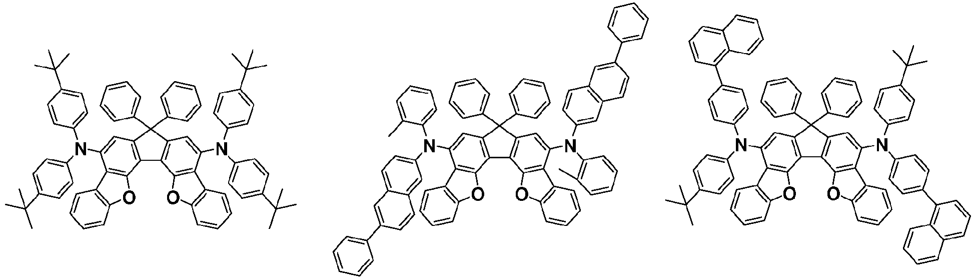

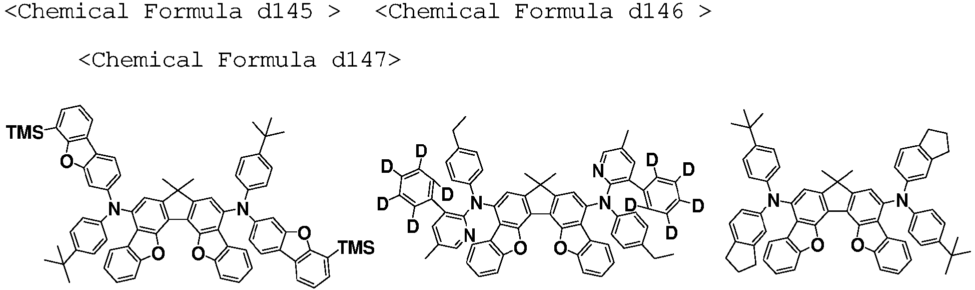

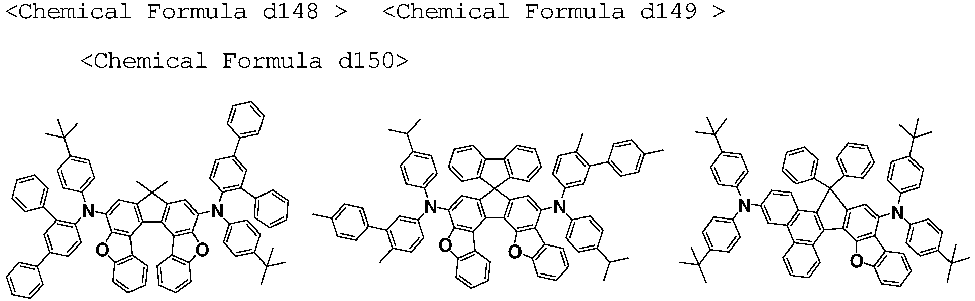

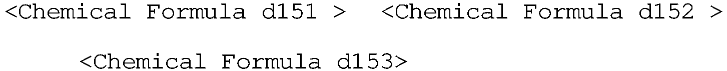

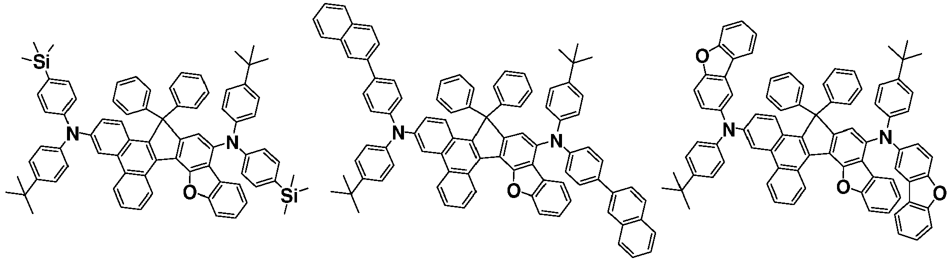

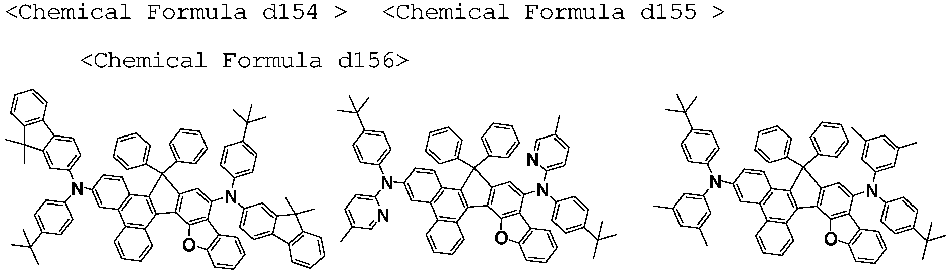

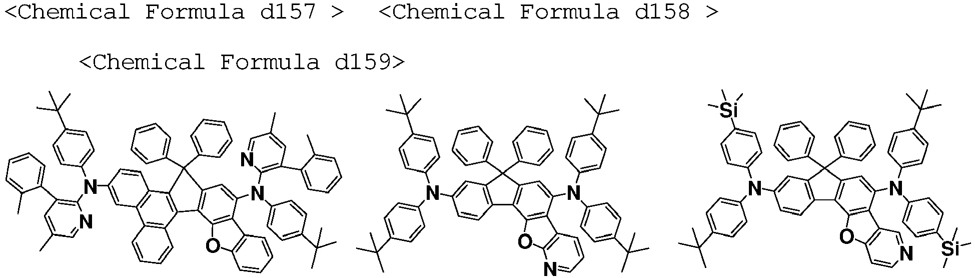

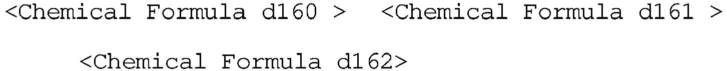

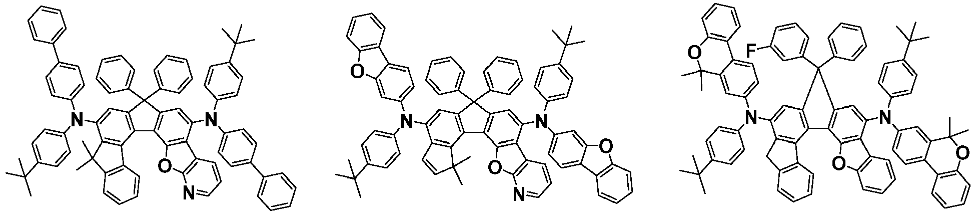

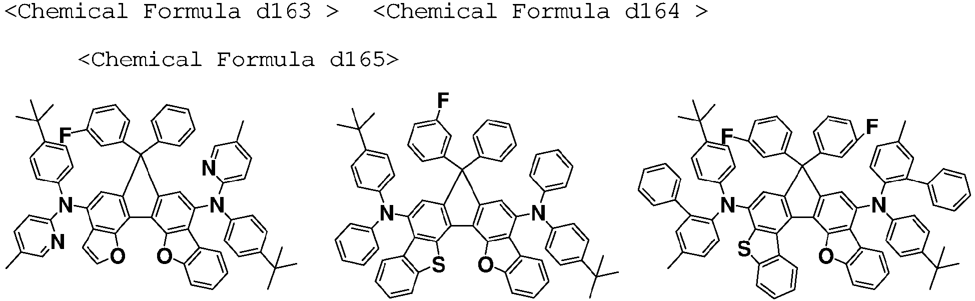

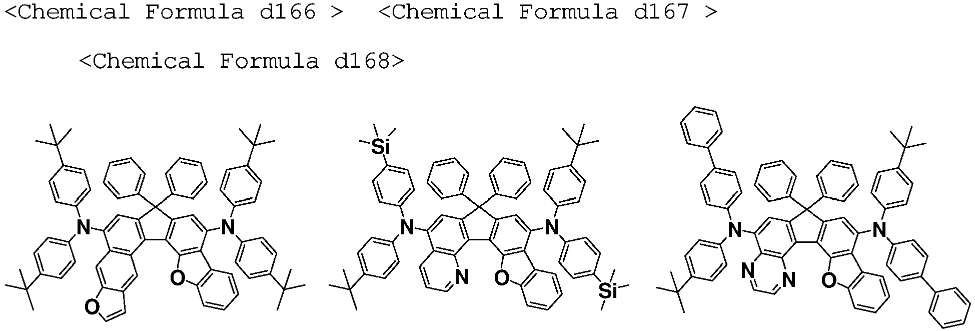

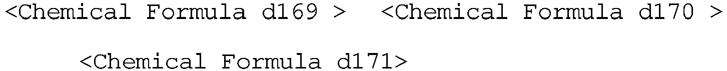

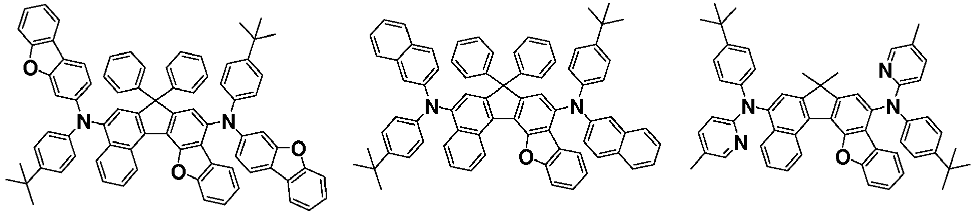

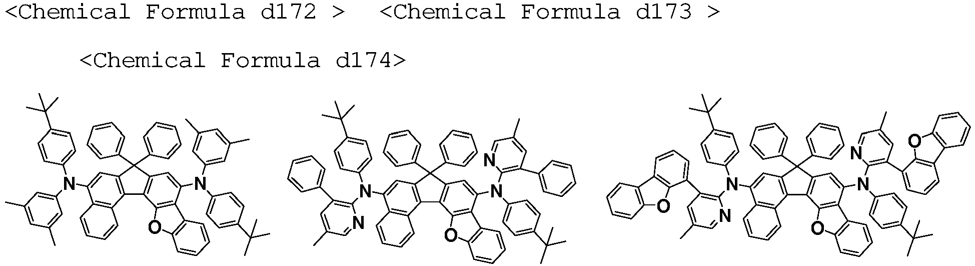

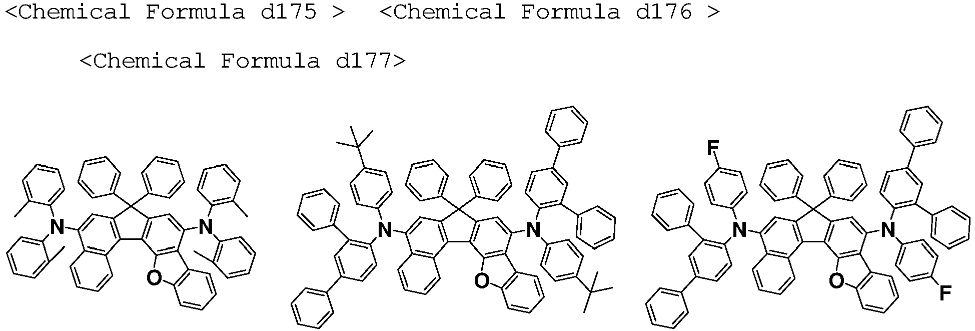

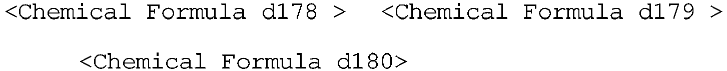

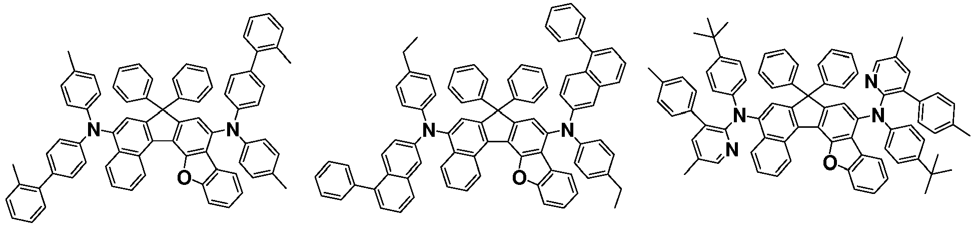

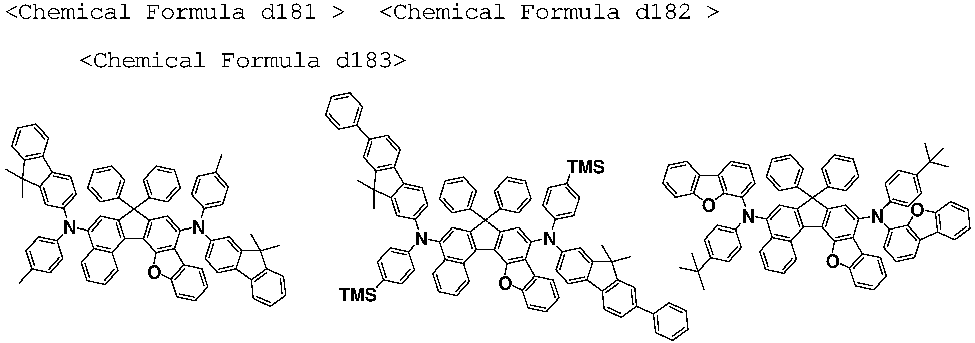

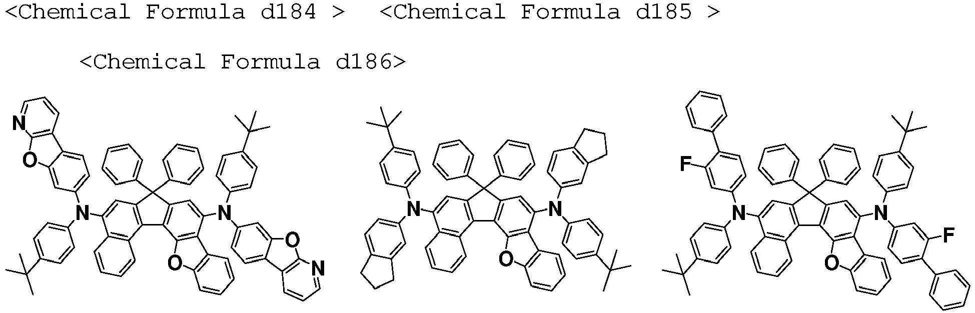

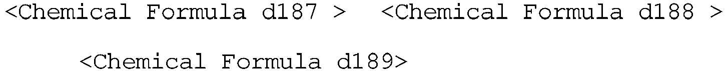

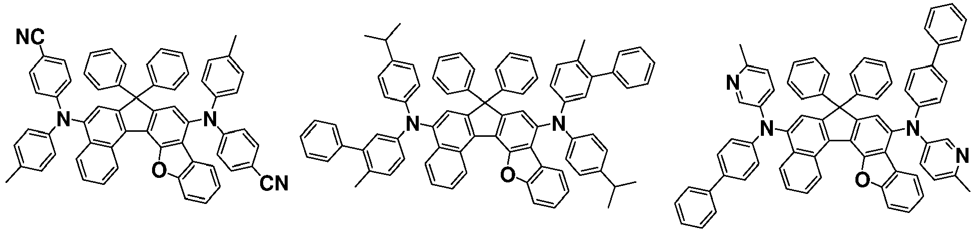

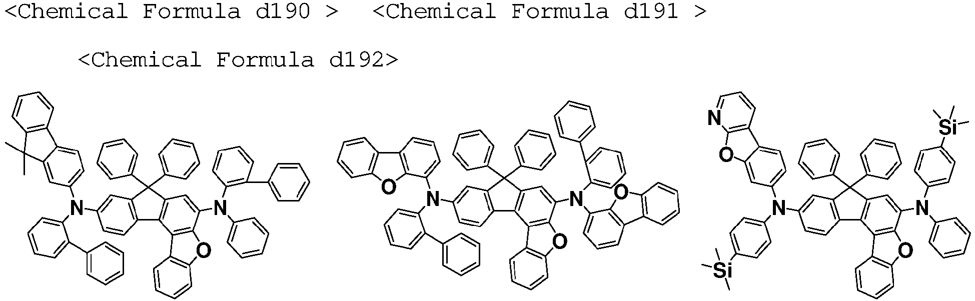

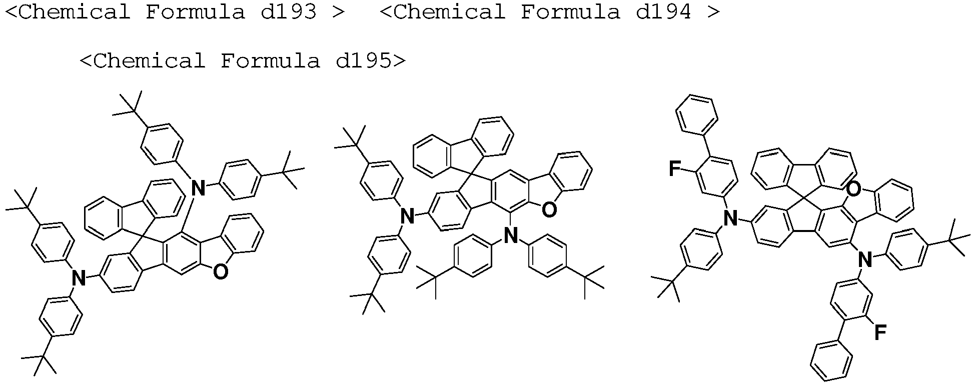

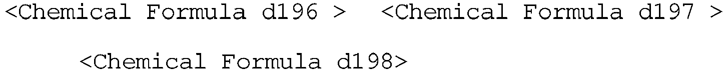

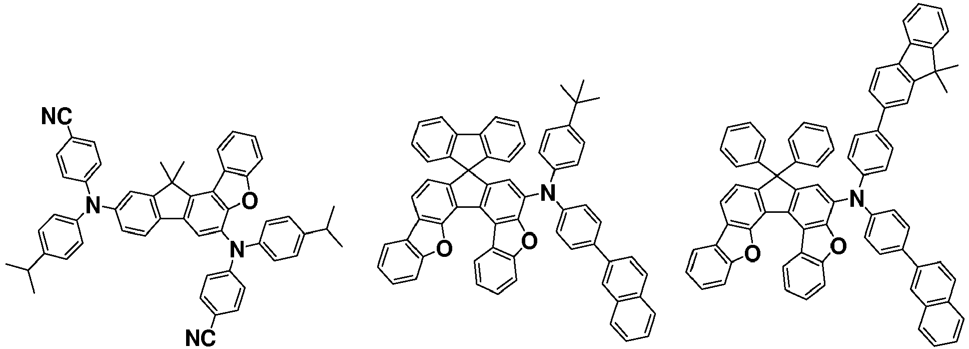

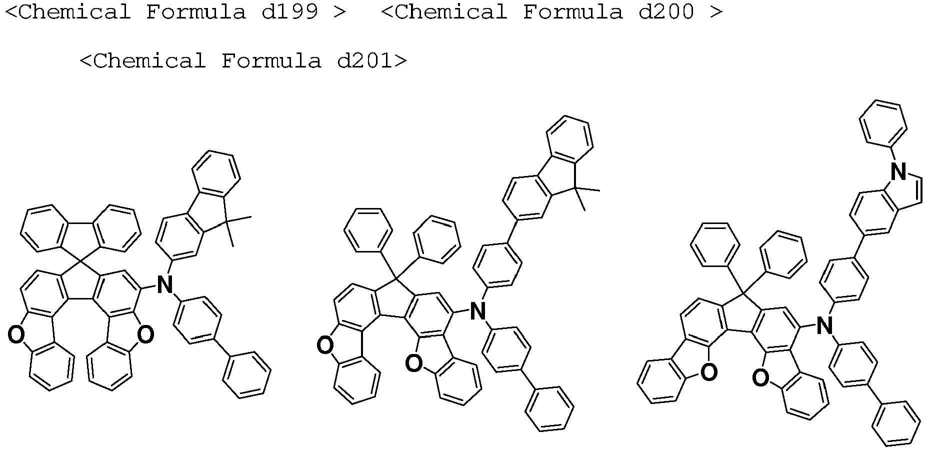

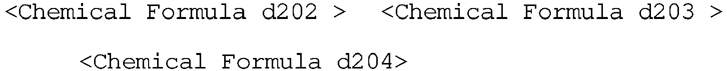

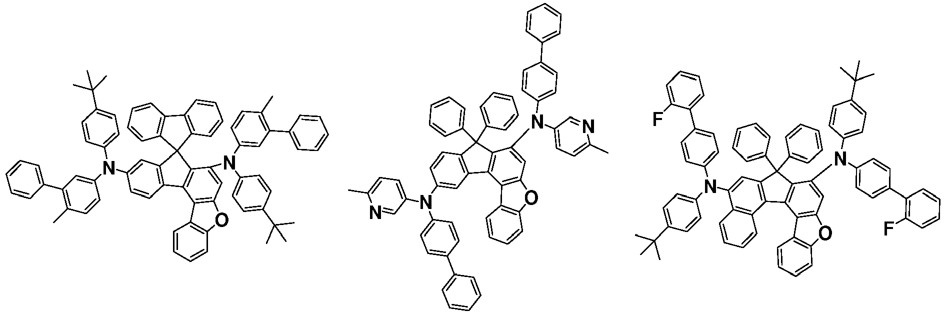

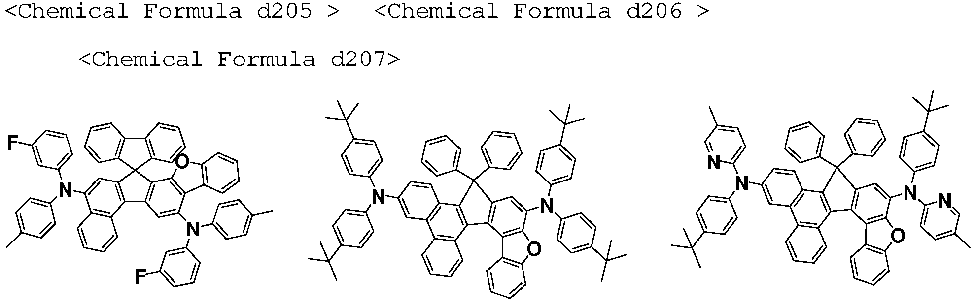

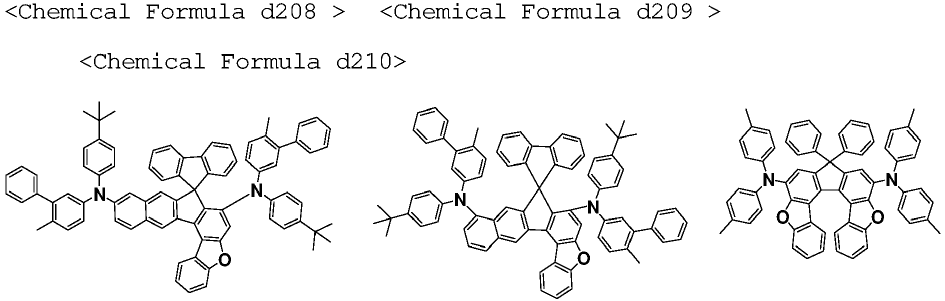

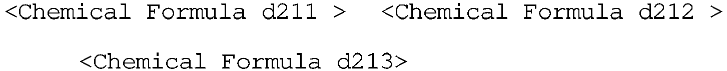

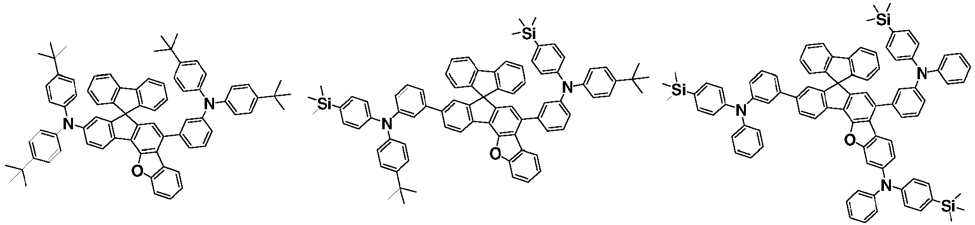

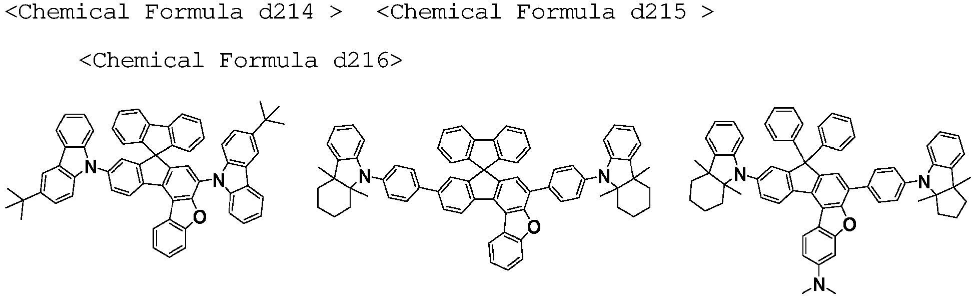

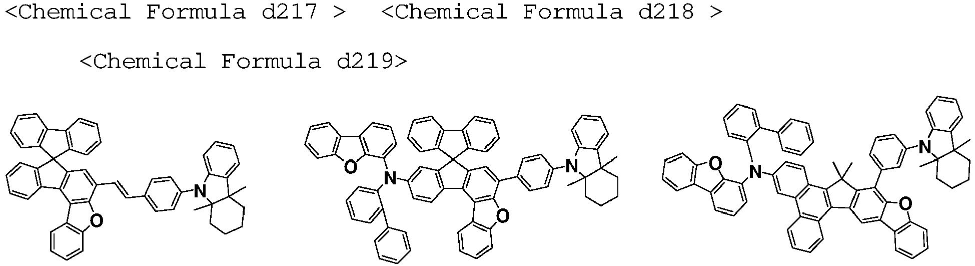

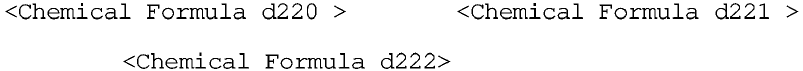

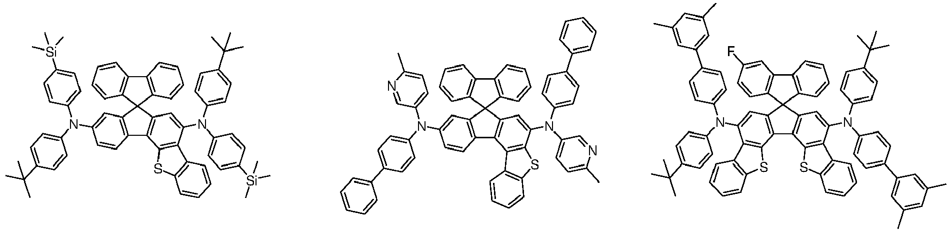

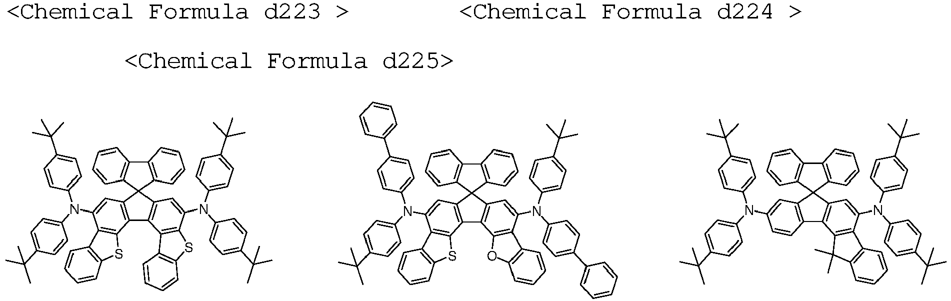

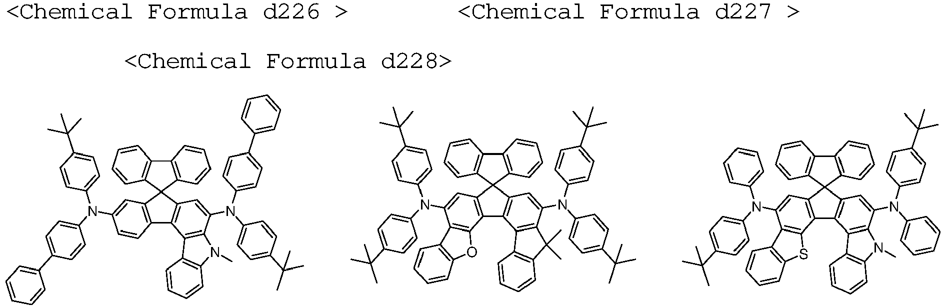

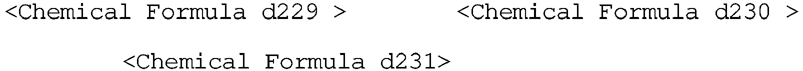

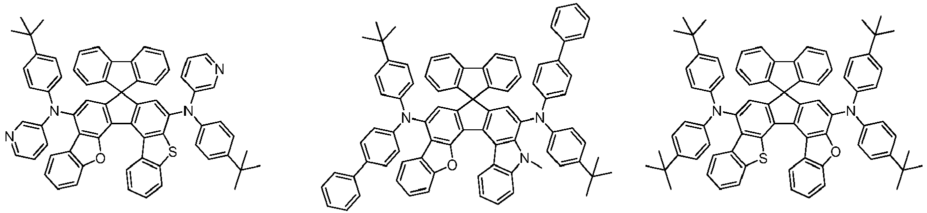

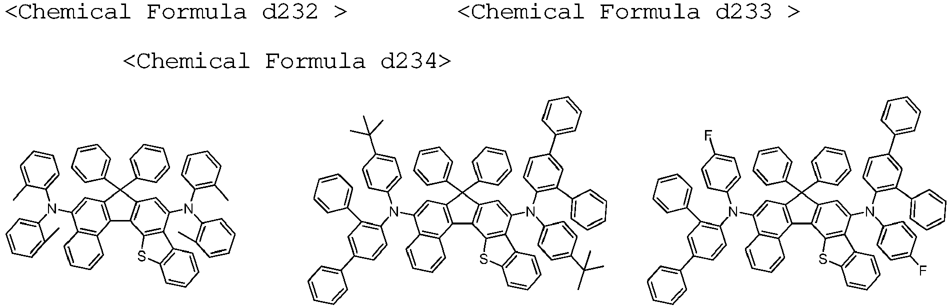

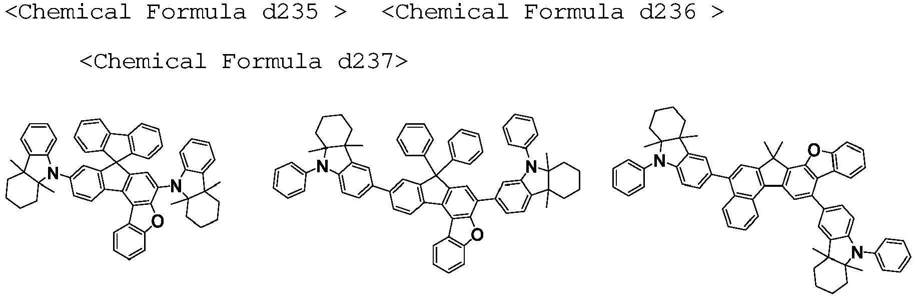

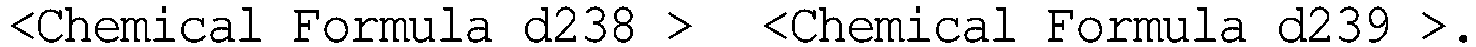

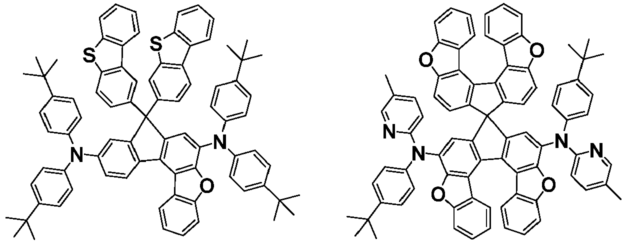

Examples of the compound represented by Chemical Formula D3 include the compounds of the following Chemical Formulas D101 to D130:

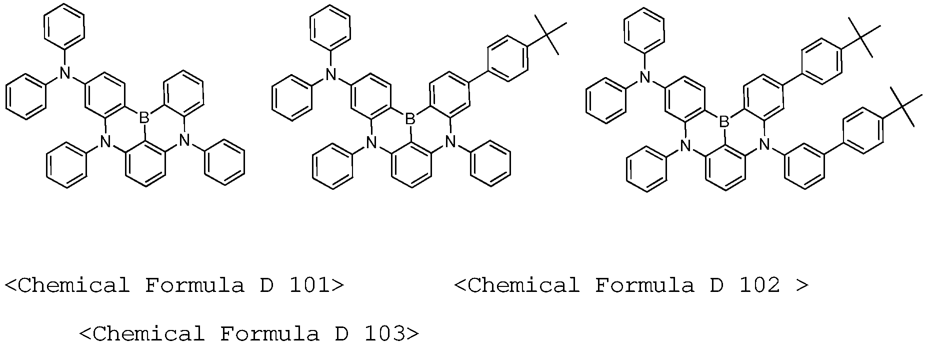

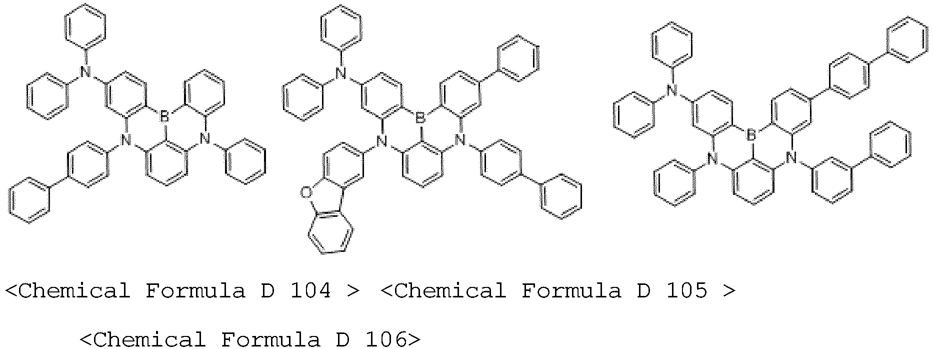

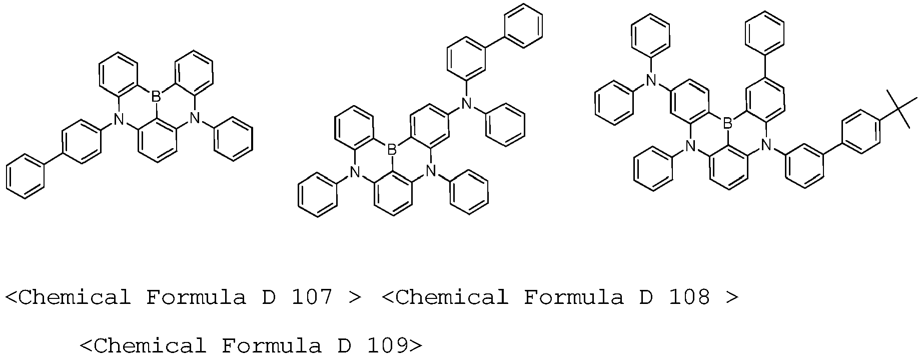

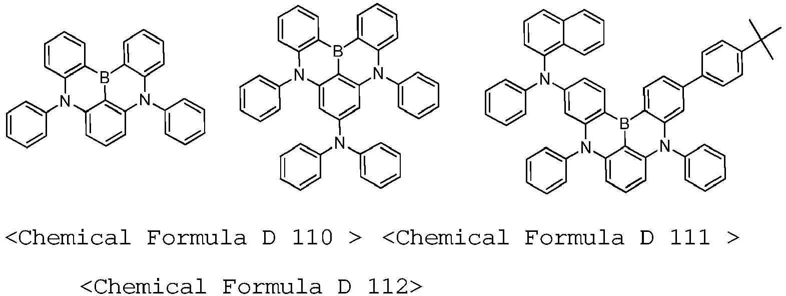

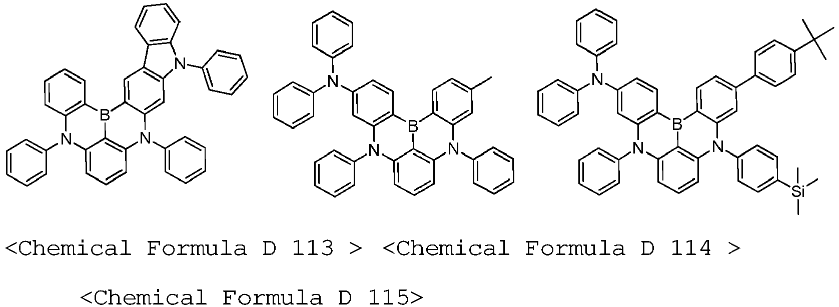

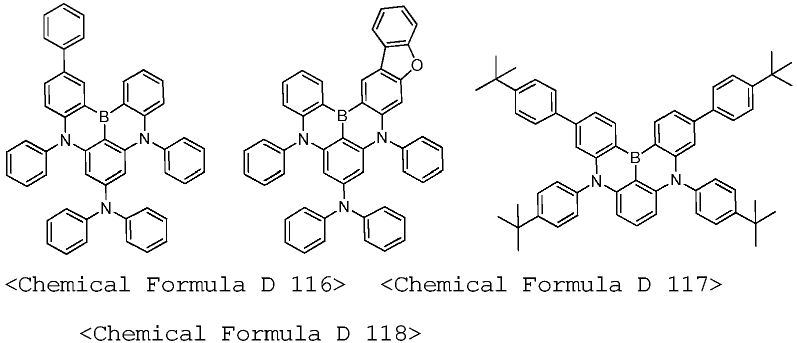

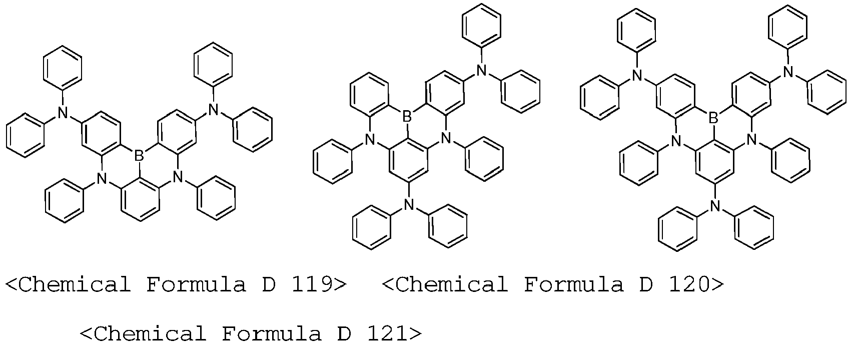

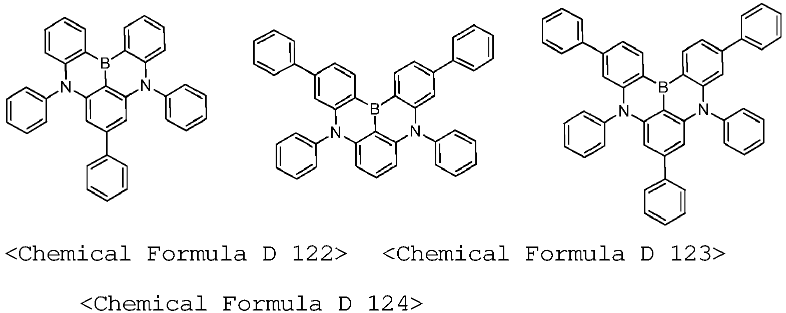

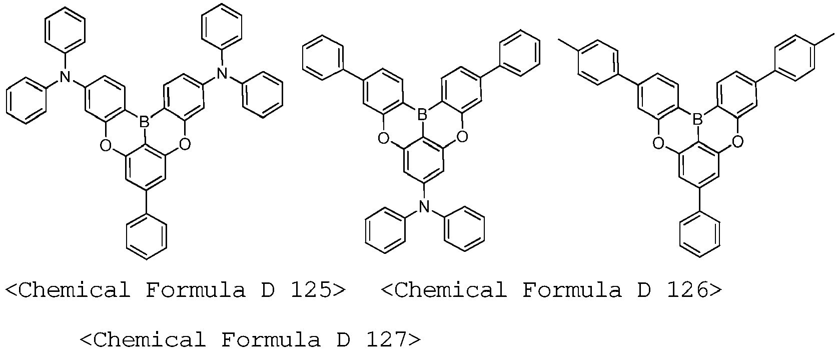

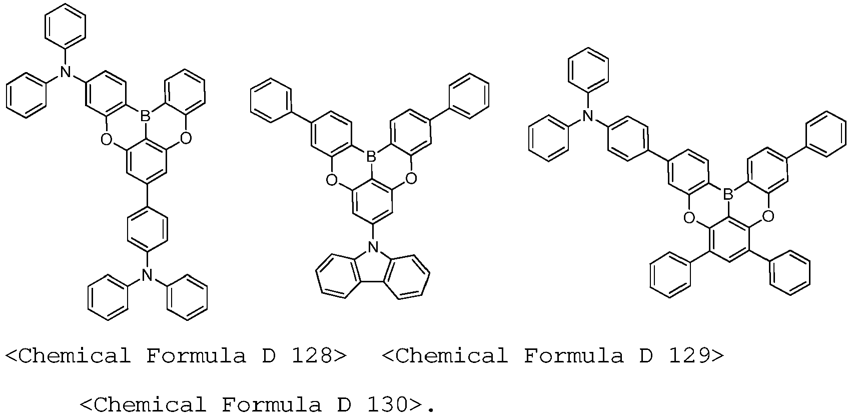

Examples of the compounds of [Chemical Formula D4] and [Chemical Formula D5] include the compounds of the following Chemical Formulas D201 to D280:

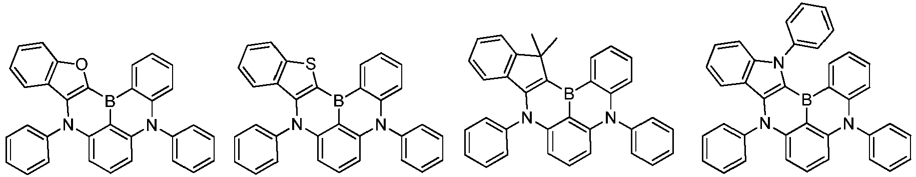

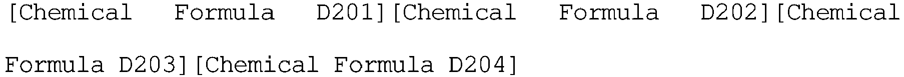

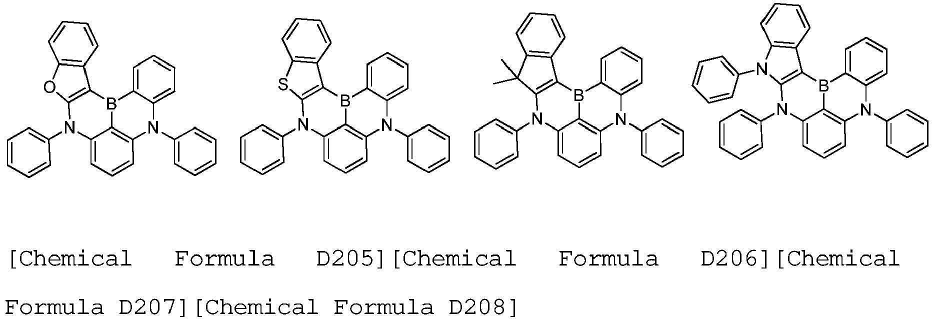

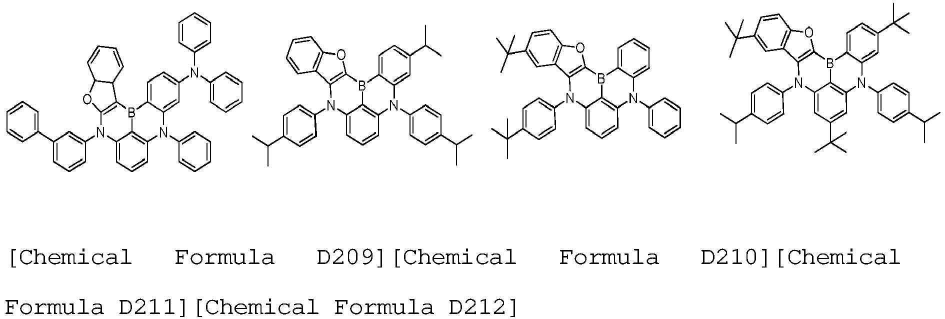

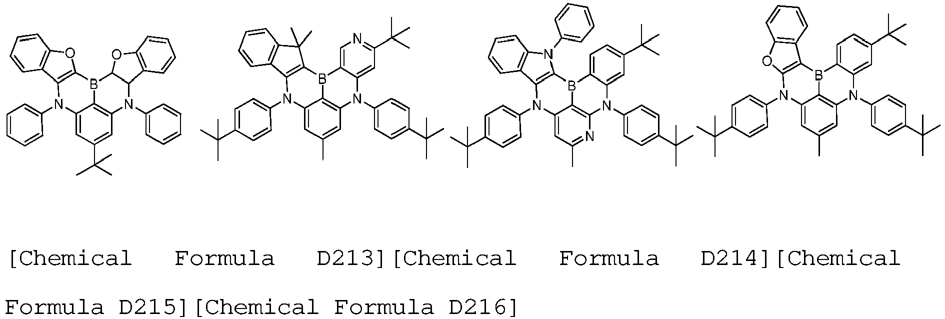

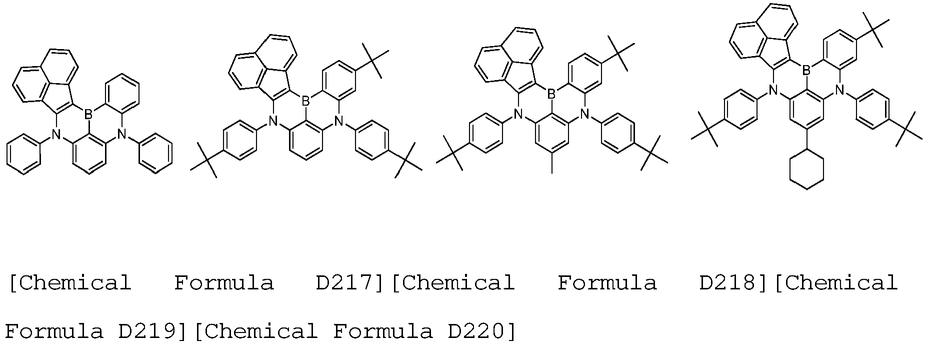

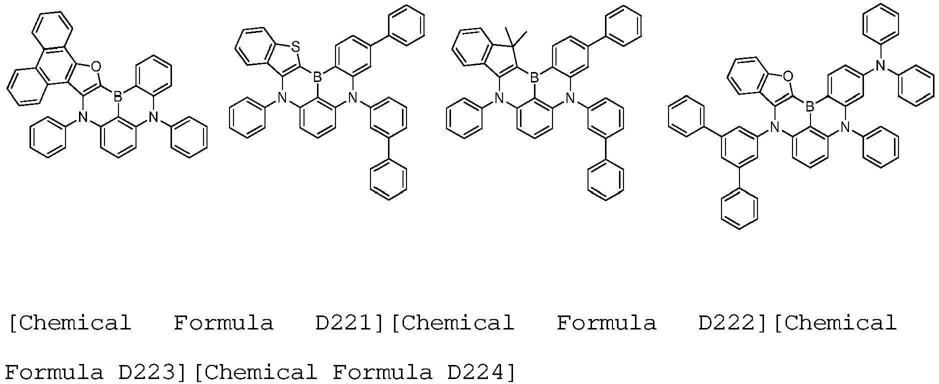

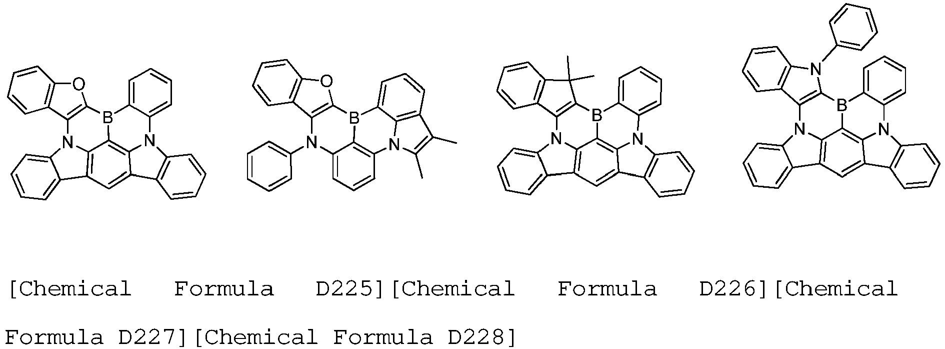

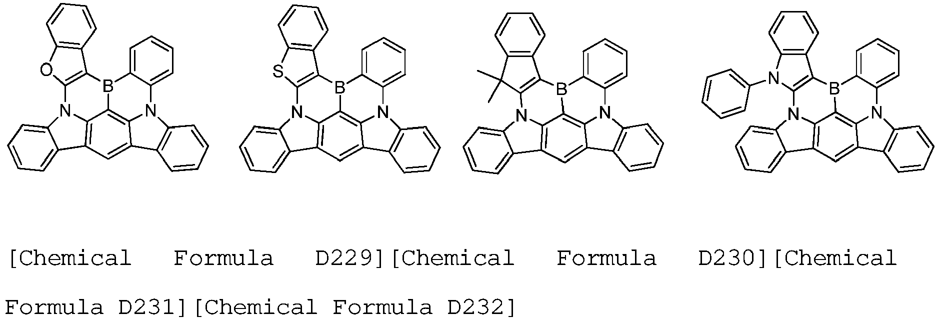

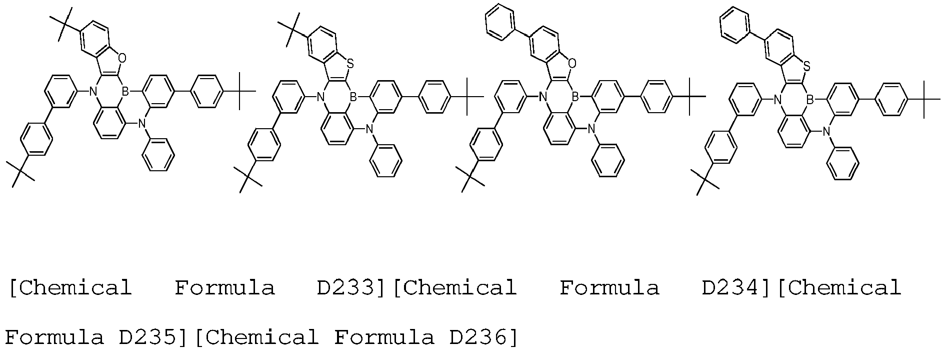

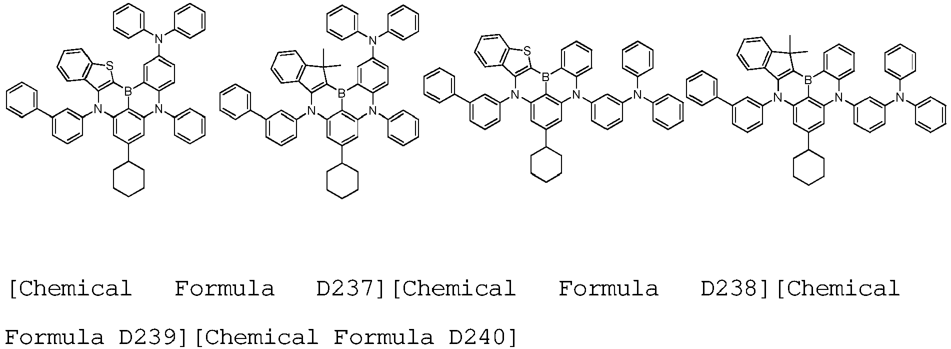

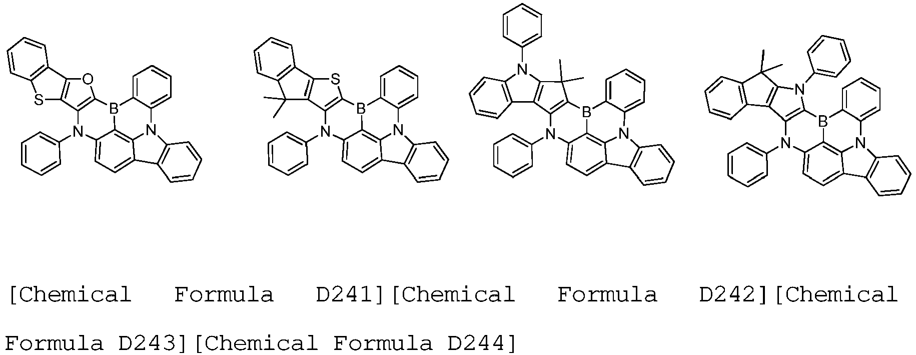

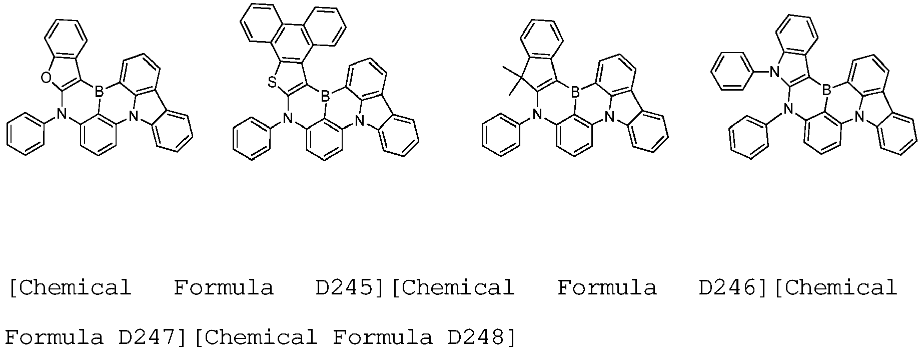

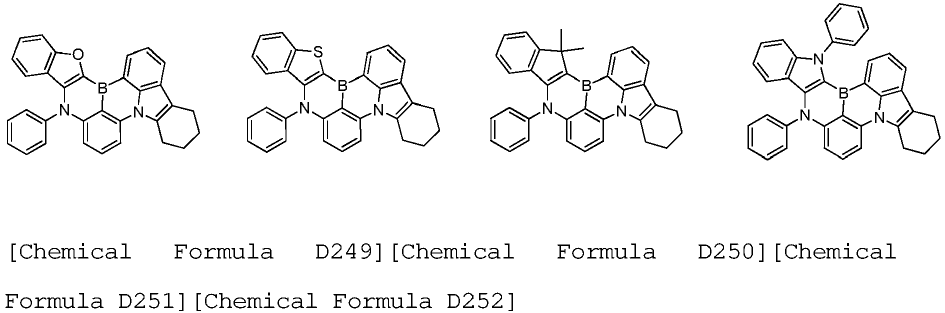

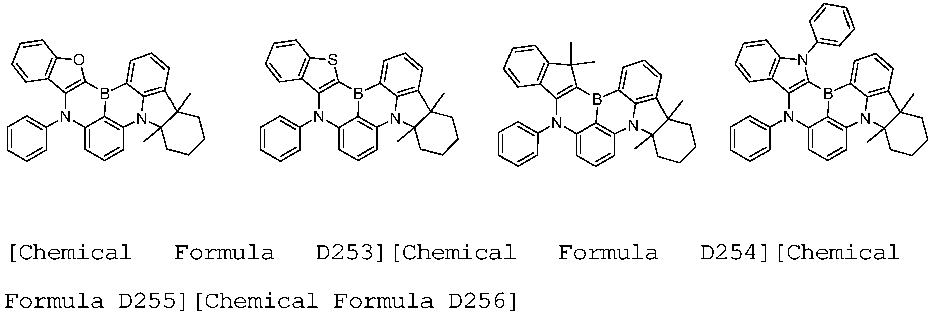

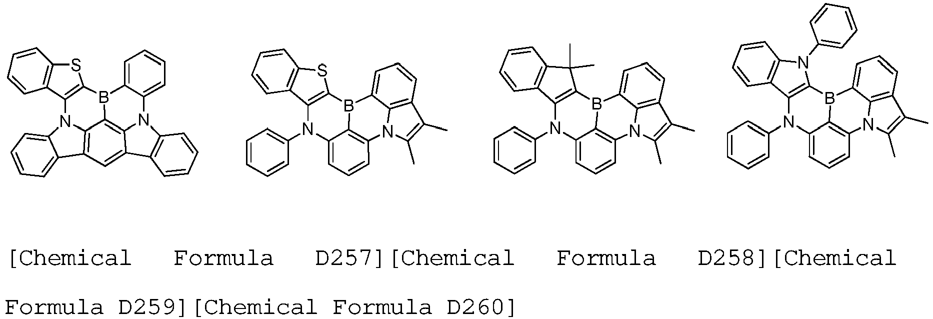

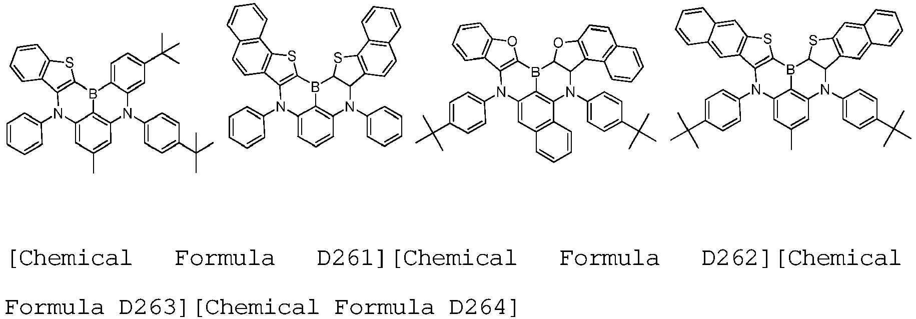

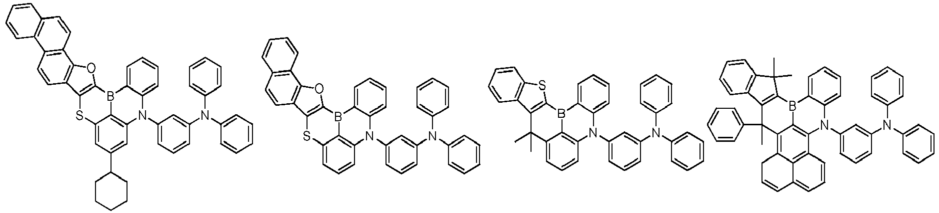

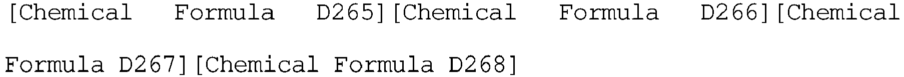

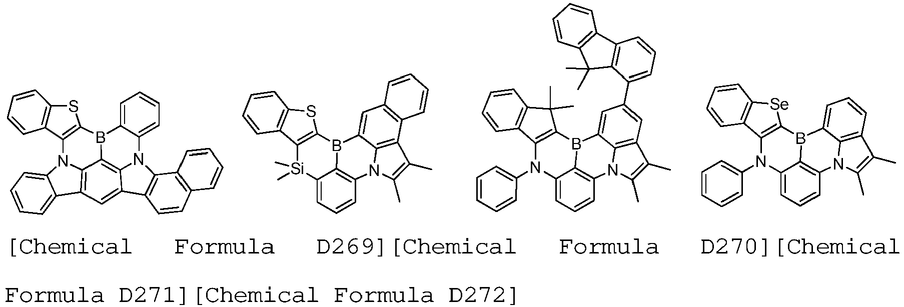

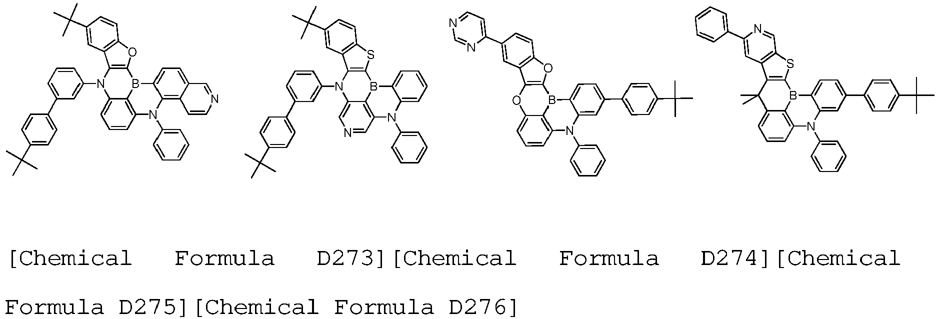

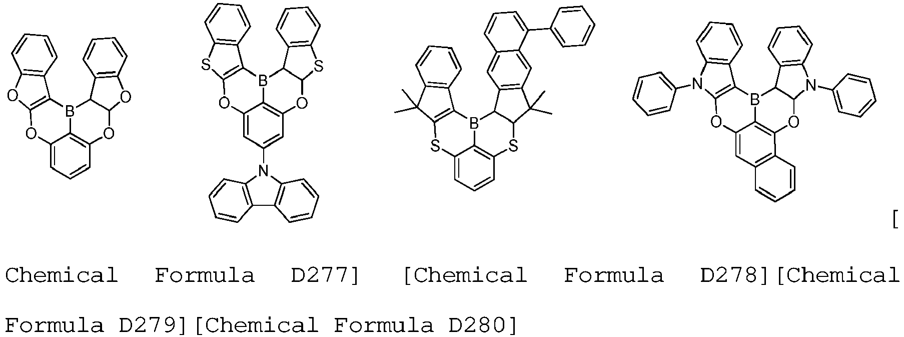

Examples of the compound represented by any one of Chemical Formulas D6 to D8 include the compounds of the following Compound D301 to D432:

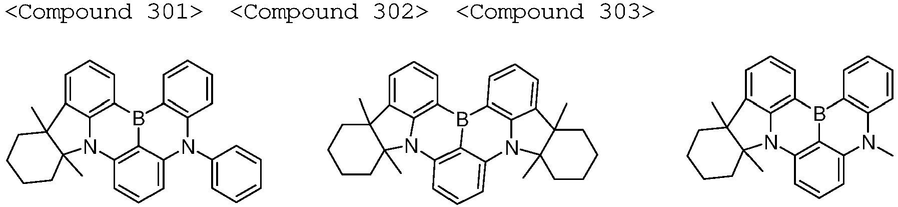

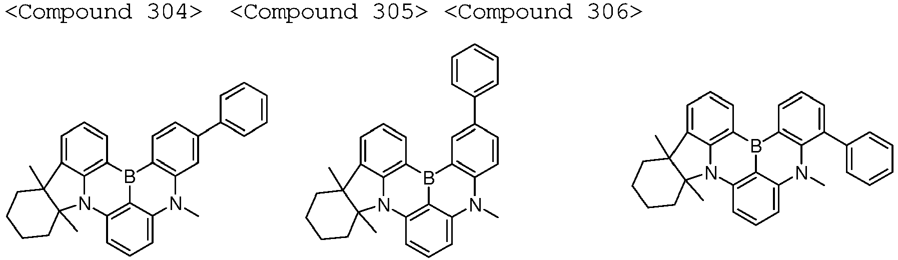

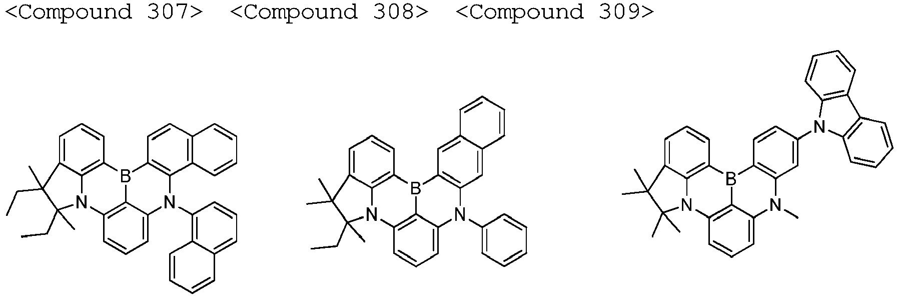

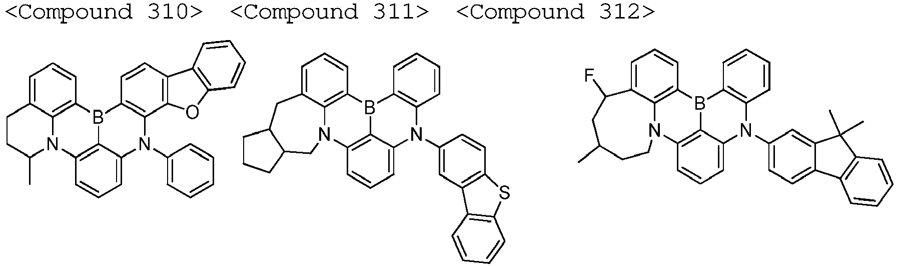

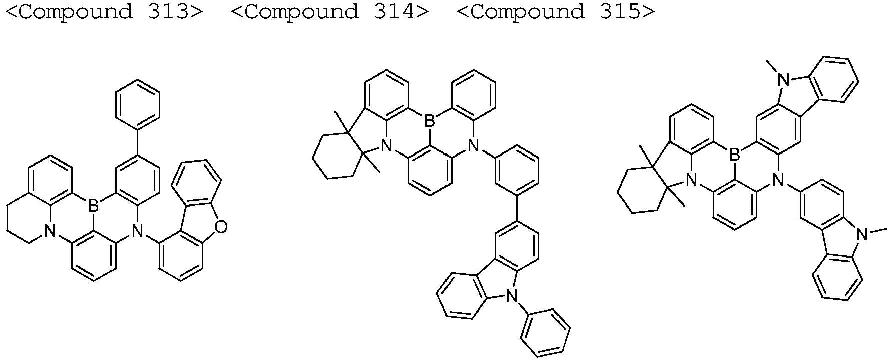

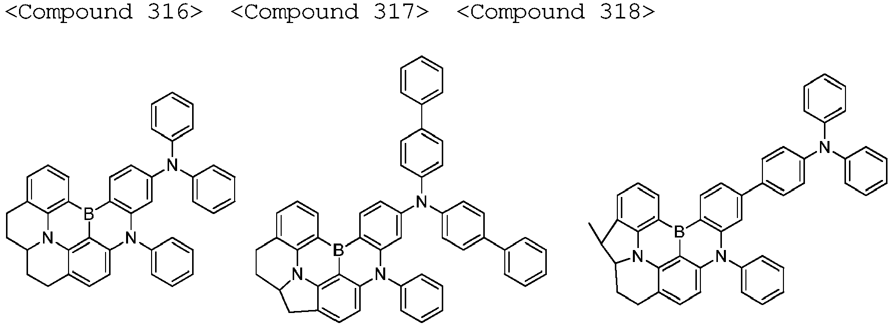

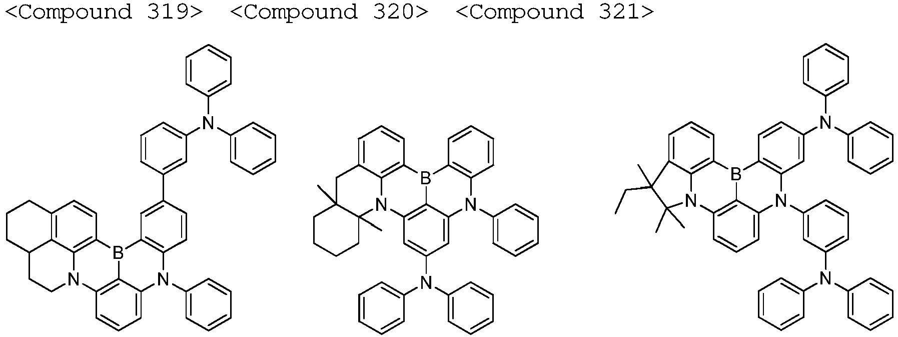

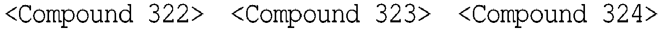

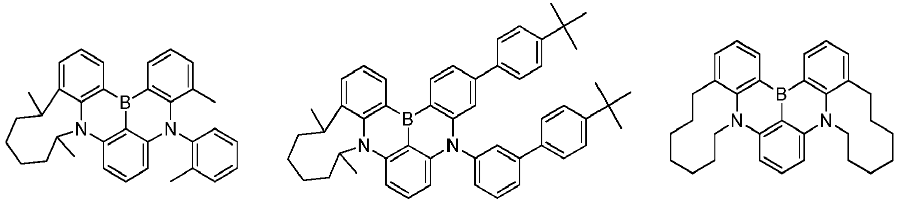

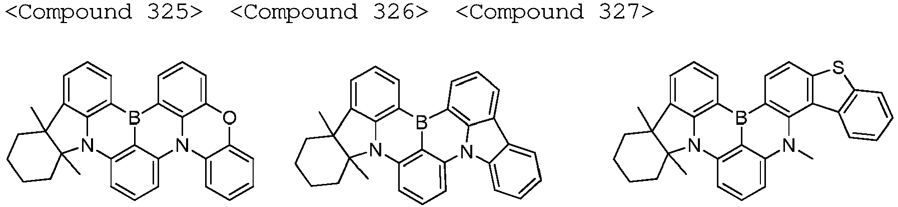

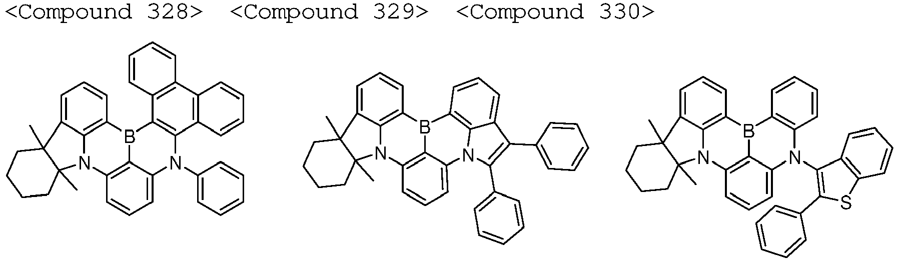

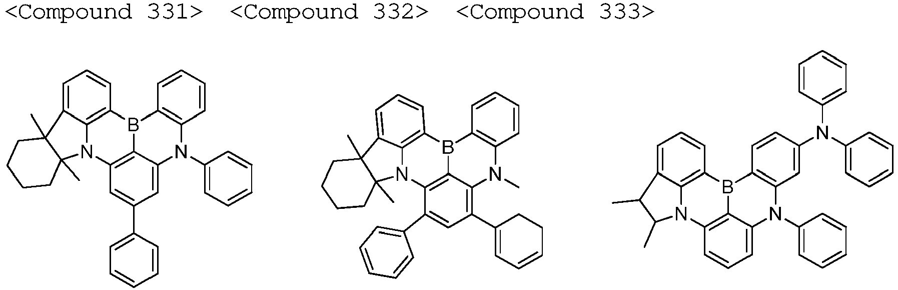

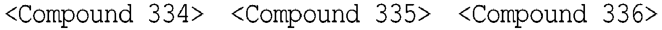

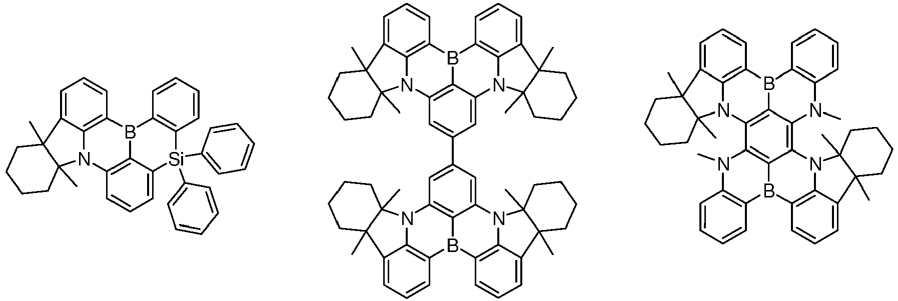

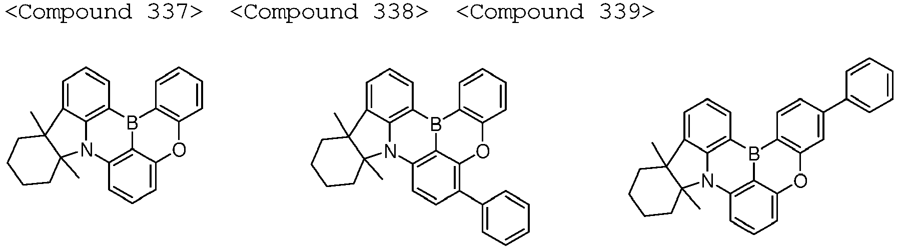

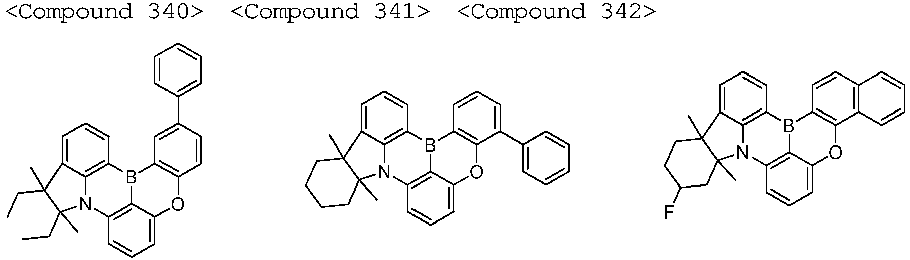

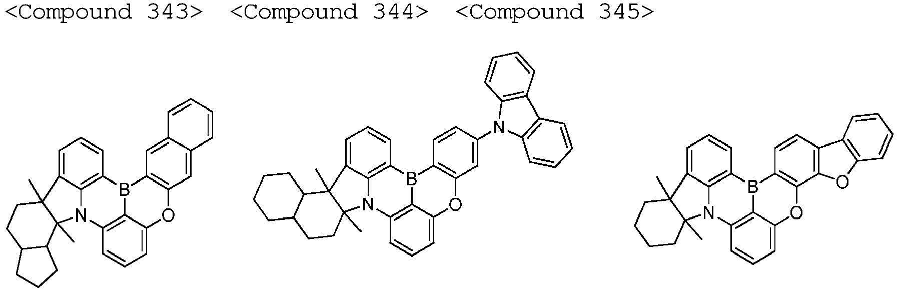

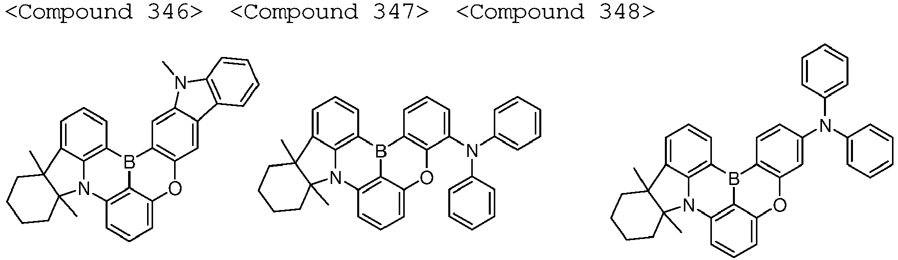

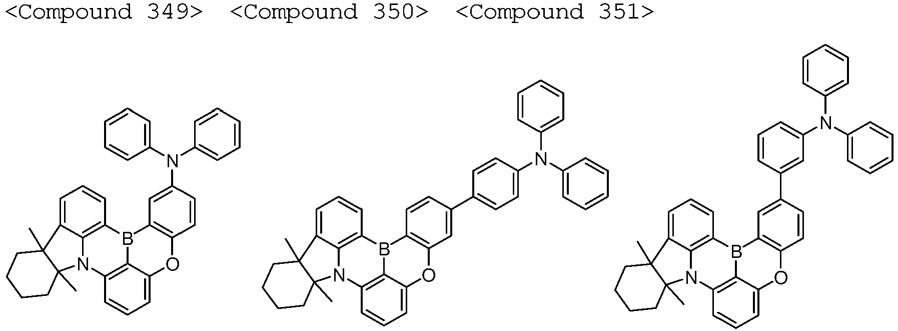

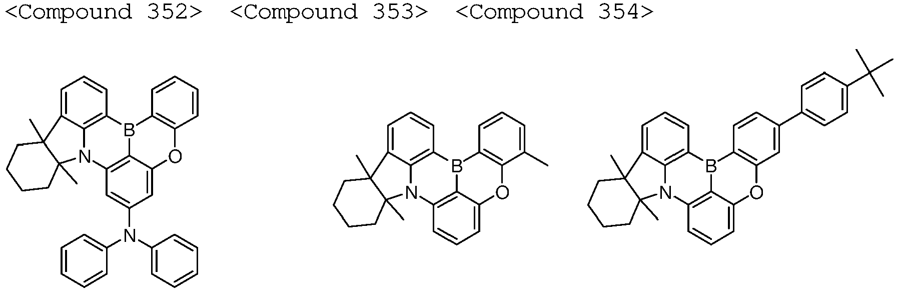

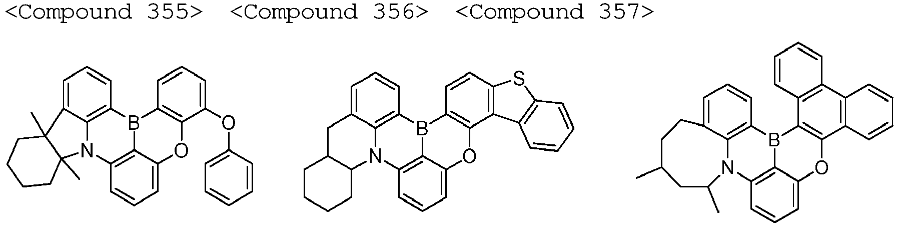

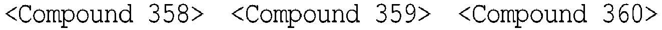

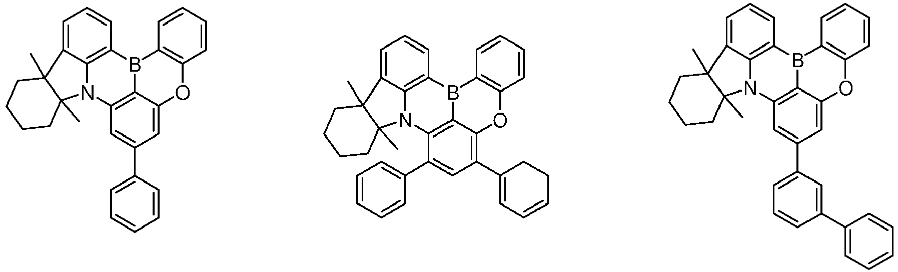

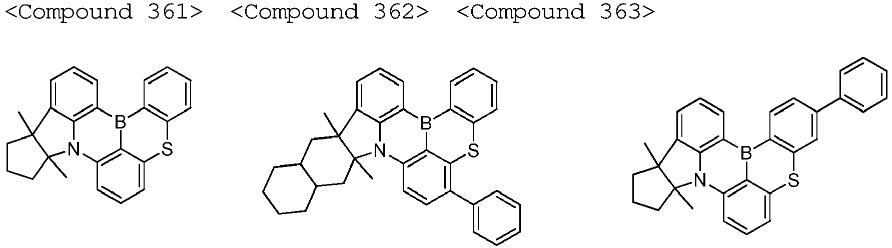

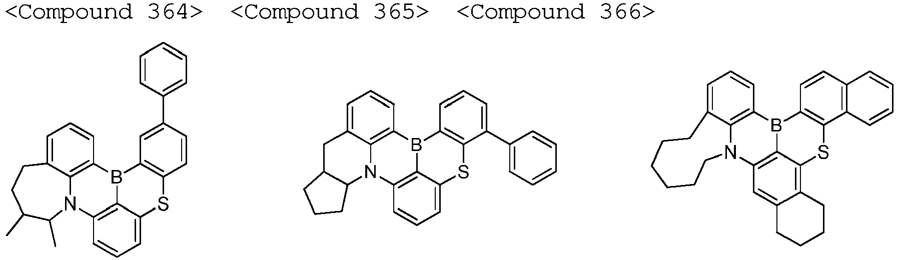

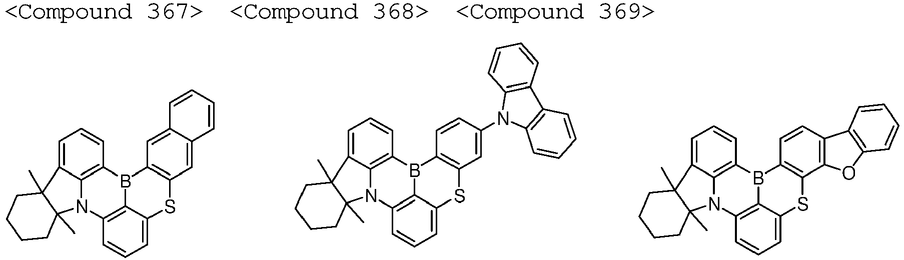

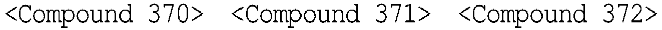

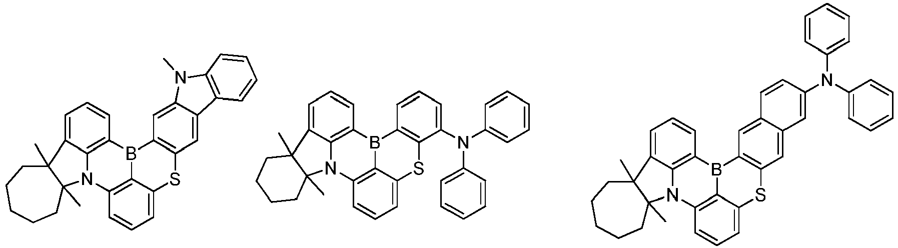

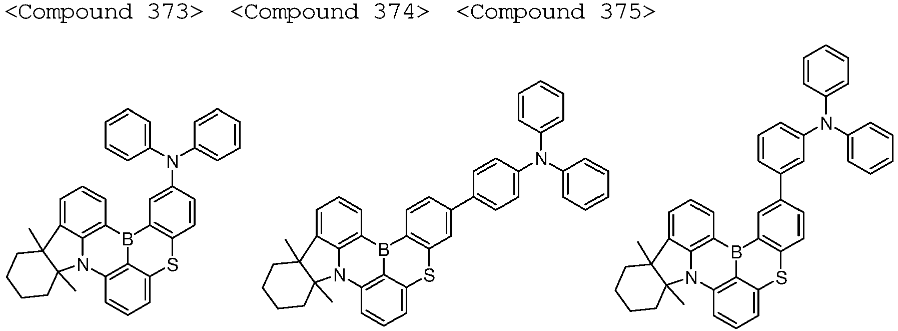

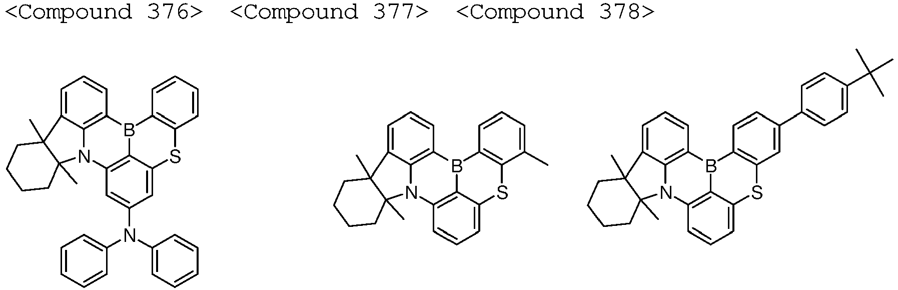

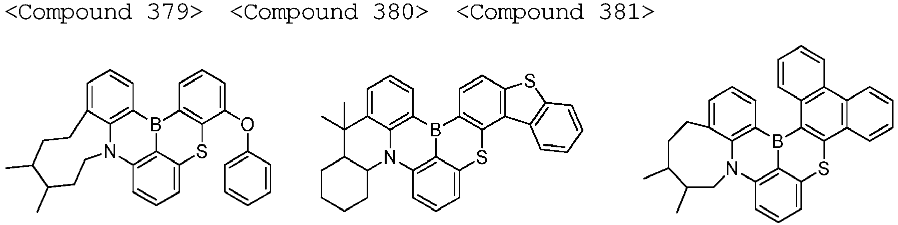

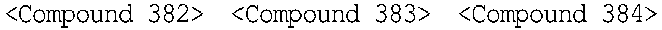

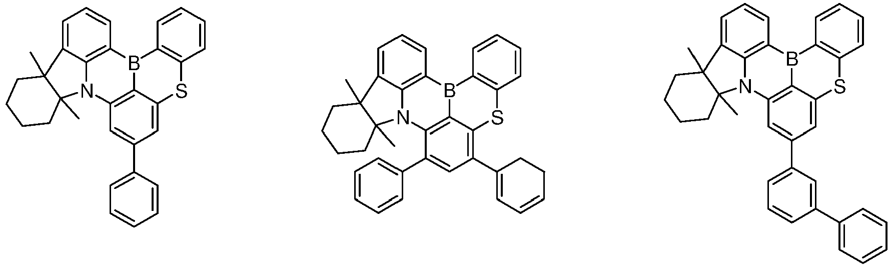

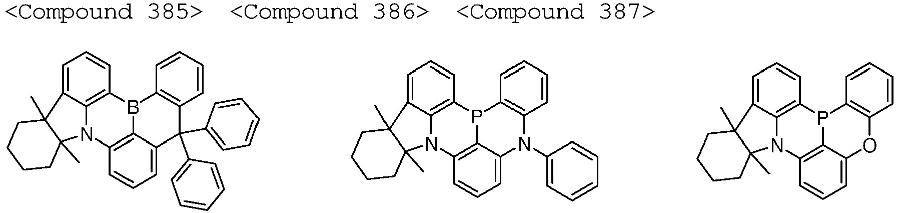

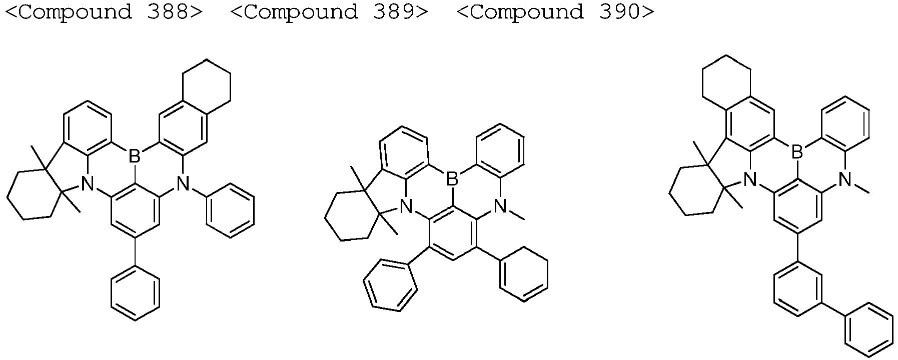

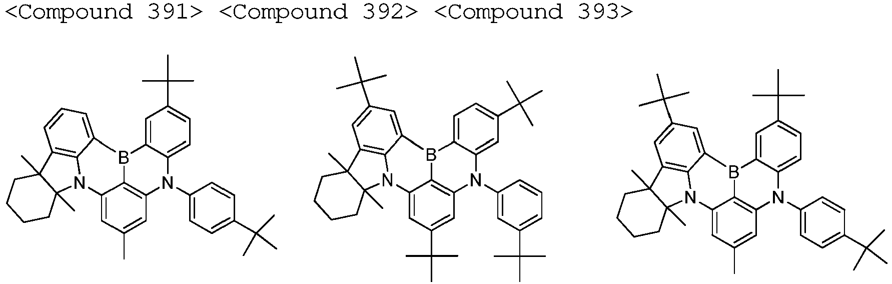

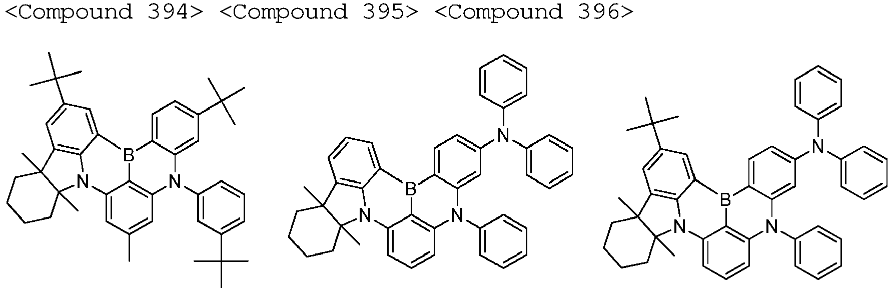

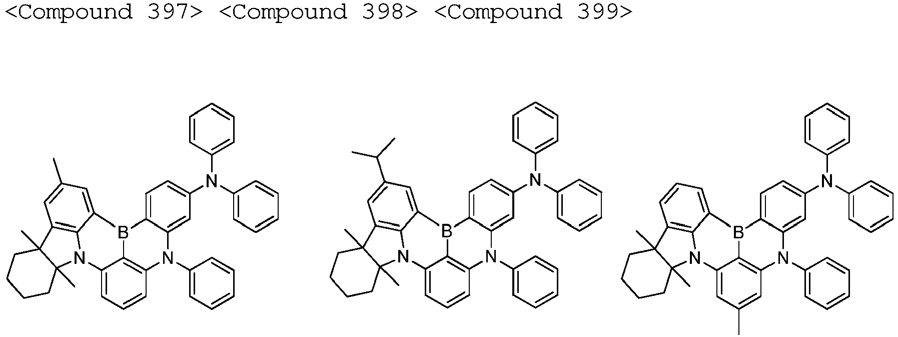

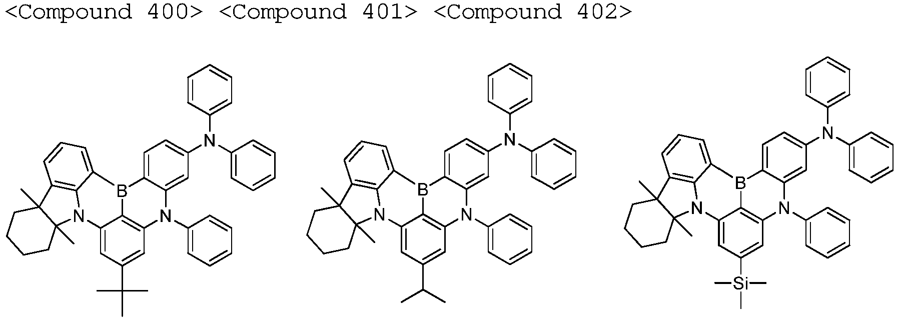

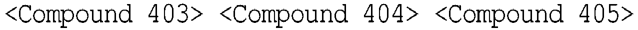

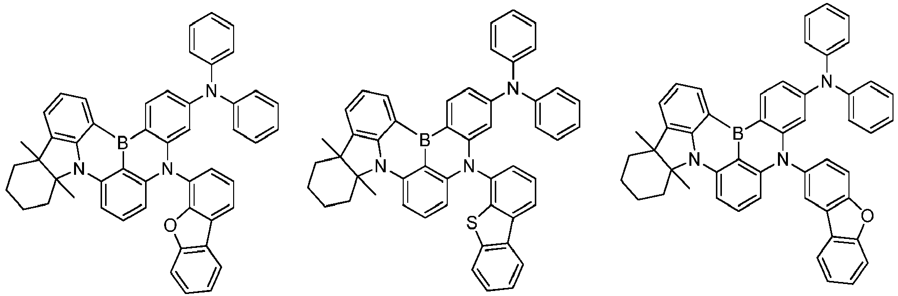

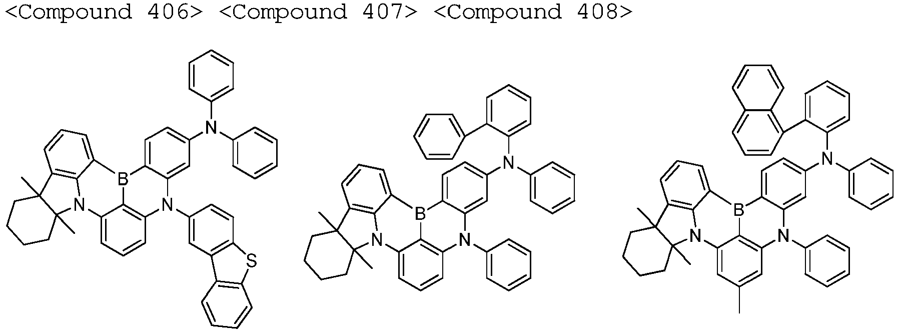

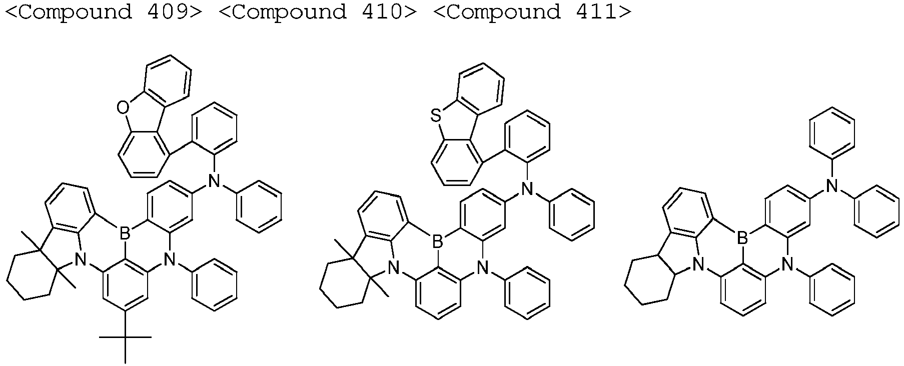

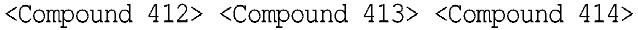

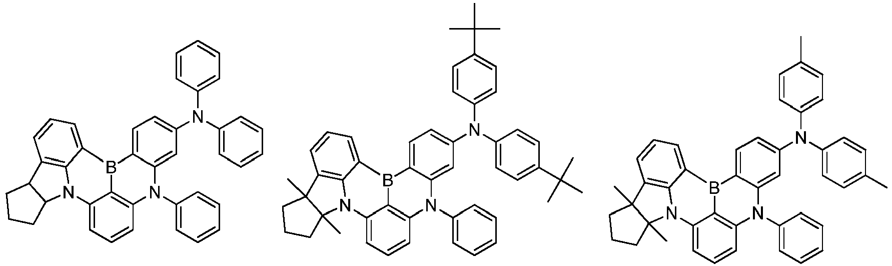

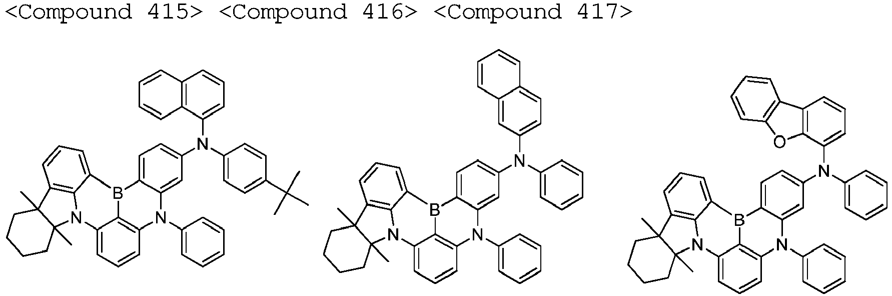

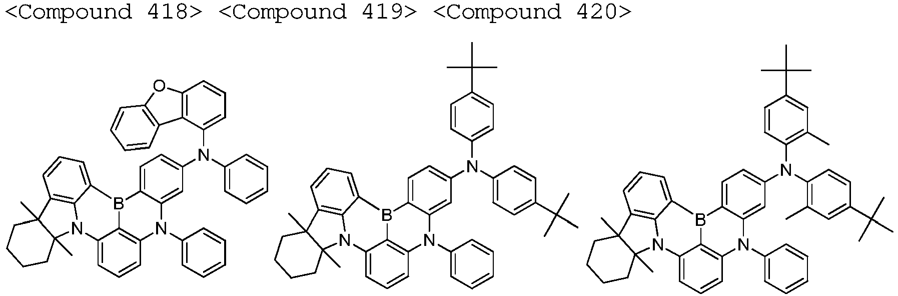

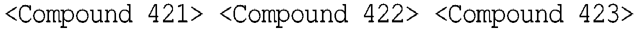

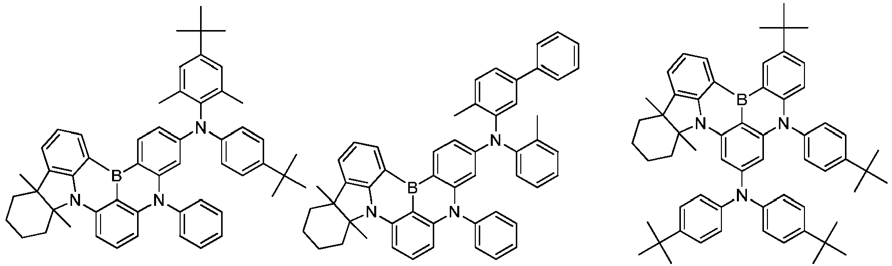

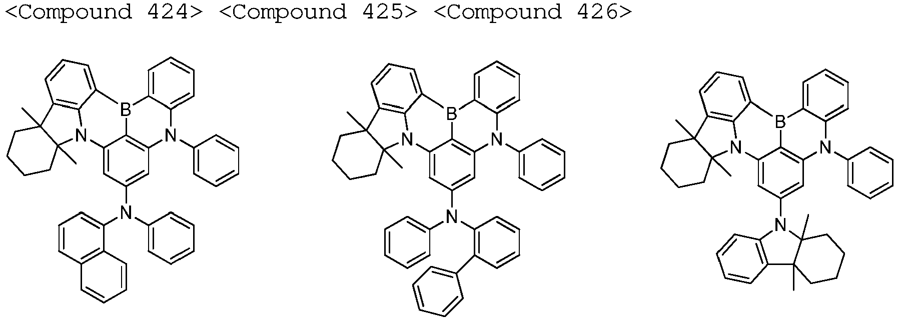

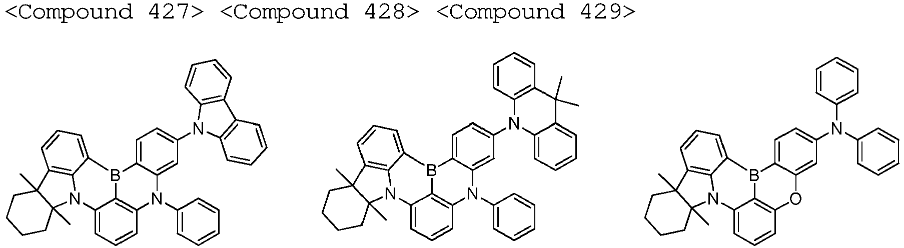

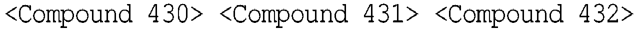

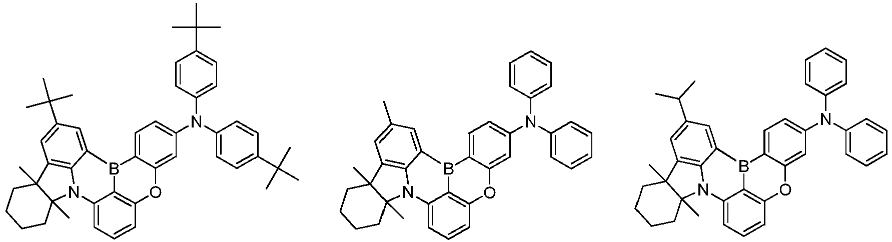

The content of the dopant in the light-emitting layer may range from about 0.01 to 20 parts by weight, based on 100 parts by weight of the host, but is not limited thereto.

In addition to the above-mentioned dopants and hosts, the light-emitting layer may further include various hosts and dopant materials.

Throughout the description of the present disclosure, the phrase "(an organic layer) includes at least one organic compound" may be construed to mean that "(an organic layer) may include a single organic compound species or two or more difference species of organic compounds falling within the scope of the present disclosure".

In this context, the organic light-emitting diode according to the present disclosure may further include at least one of a hole injection layer, a hole transport layer, a functional layer capable of both hole injection and hole transport, an electron barrier layer, a light-emitting layer, an electron transport layer, an electron injection layer, and a capping layer.

Below, the organic light-emitting diode of the present disclosure will be explained with reference to the drawing.

FIG. 1 is a schematic cross-sectional view of the structure of an organic light-emitting diode according to an embodiment of the present disclosure.

As shown in FIG. 1, the organic light-emitting diode according to an embodiment of the present disclosure comprises: an anode 20; a first emission part including a hole transport layer 40, a light-emitting layer 50, an electron transport layer 60, and a cathode 80, and optionally a hole injection layer 30 and an electron injection layer 70. In addition, one or two intermediate layers may be further formed in the organic light-emitting diode.

As stated in the foregoing, the anthracene compounds represented by Chemical Formulas A and B can be used simultaneously as individual hosts in the light emitting layer.

Reference is made to FIG. 1 with regard to the organic light-emitting diode of the present disclosure and the fabrication thereof. First, a substrate 10 is coated with an anode electrode material to form an anode 20. So long as it is used in a typical organic electroluminescence device, any substrate may be used as the substrate 10. Preferable is an organic substrate or transparent plastic substrate that exhibits excellent transparency, surface smoothness, ease of handling, and waterproofness. As the anode electrode material, indium tin oxide (ITO), indium zinc oxide (IZO), tin oxide (SnO₂), or zinc oxide (ZnO), which are transparent and superb in terms of conductivity, may be used.

A hole injection layer material is applied on the anode 20 by thermal deposition in a vacuum or by spin coating to form a hole injection layer 30. Subsequently, thermal deposition in a vacuum or by spin coating may also be conducted to form a hole transport layer 40 with a hole transport layer material on the hole injection layer 30.

No particular limitations are imparted to the material for the hole injection layer 30 as long as it is one that is typically used in the art. For example, mention may be made of 2-TNATA [4,4',4"-tris(2-naphthylphenyl-phenylamino)-triphenylamine], NPD [N,N'-di(1-naphthyl)-N,N'-diphenylbenzidine)], TPD [N,N'-diphenyl-N,N'-bis(3-methylphenyl)-1,1'-biphenyl-4,4'-diamine], or DNTPD [N,N'-diphenyl-N,N'-bis-[4-(phenyl-m-tolyl-amino)-phenyl]-biphenyl-4,4'-diamine], but the present disclosure is not limited thereby.

So long as it is typically used in the art, any material may be selected for the hole transport layer without particular limitation. Examples include, but are not limited to, N,N'-bis(3-methylphenyl)-N,N'-diphenyl-[1,1-biphenyl]-4,4'-diamine (TPD), and N,N'-di(naphthalen-1-yl)-N,N'-diphenylbenzidine (a-NPD).

Then, an organic light-emitting layer 50 containing a host and a dopant is deposited on the hole transport layer 40 by deposition in a vacuum or by spin coating. In some embodiments of the present disclosure, the light-emitting layer particularly ranges in thickness from 50 to 2,000 Å. Here, an electron density control layer (not shown) may be further formed on the organic light-emitting layer 50, as necessary.

Next, a light-emitting layer 50 may be deposited on the hole transport layer 40 by deposition in a vacuum or by spin coating.

Here, the light-emitting layer 50 may contain a host and a dopant and the materials are as described above.

In some embodiments of the present disclosure, the light-emitting layer 50 particularly ranges in thickness from 50 to 2,000 Å.

Meanwhile, an electron transport layer 60 is applied on the light-emitting layer by deposition in a vacuum and spin coating.

After being deposited on the light-emitting layer by deposition in a vacuum and spin coating, the electron transport layer 60 is covered with the electron injection layer 70. A cathode metal is deposited on the electron injection layer 70 by thermal vacuum deposition to form the cathode 80, thus obtaining an organic light-emitting diode.

A material for use in the electron transport layer 60 functions to stably carry the electrons injected from the electron injection electrode (cathode), and may be an electron transport material known in the art. Examples of the electron transport material known in the art include quinoline derivatives, particularly, tris(8-quinolinorate)aluminum (Alq₃), Liq, TAZ, BAlq, beryllium bis(benzoquinolin-10-olate) (Bebq₂), ADN, Compound 201, Compound 202, BCP, and oxadiazole derivatives such as PBD, BMD, and BND, but are not limited thereto:

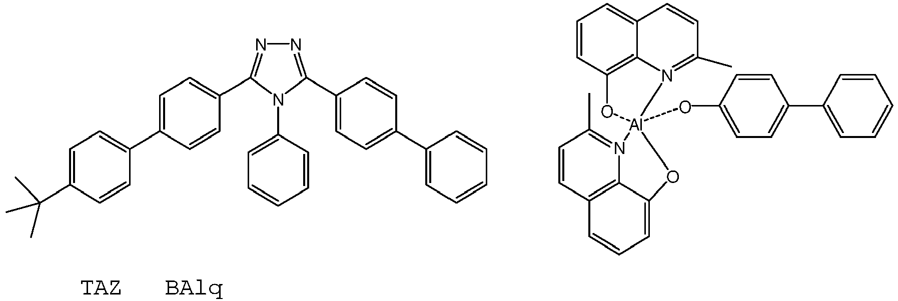

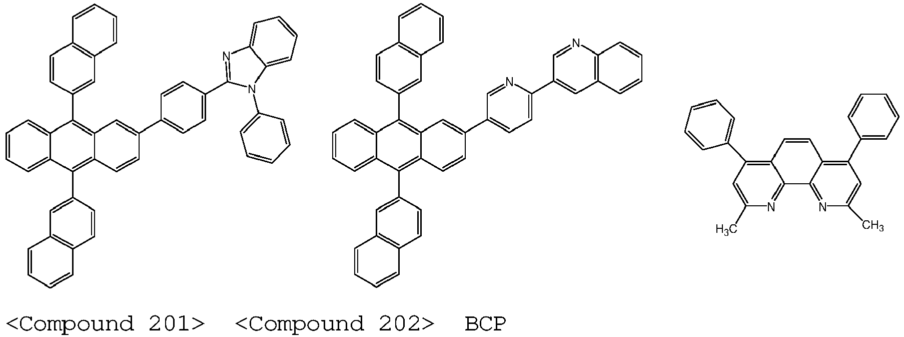

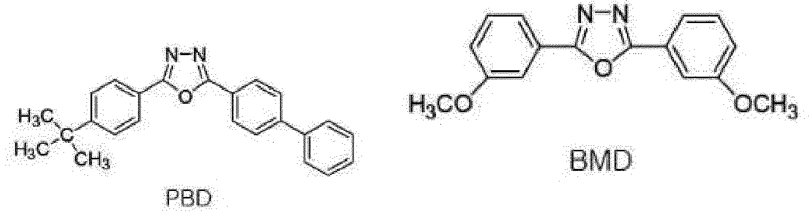

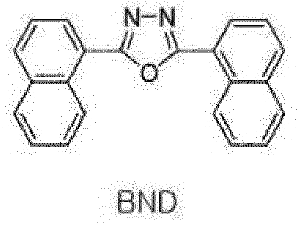

In addition, the electron transport layer 60 may be made of the organic metal compound represented by Chemical Formula F, either alone or in combination with the aforementioned electron transport layer material:

[Chemical Formula F] Yₘ-M-(OA)ₙ

wherein,
Y is a ligand that contains two moieties respectively responsible for forming a single bond with M through a direct bond and for forming a coordinate bond with M, each moiety being selected from among C, N, O and S, and which is chelated by the single bond and the coordinate bond;
M is an alkali metal, an alkaline earth metal, aluminum (Al), or a boron (B) atom, with a proviso that:
   when M is an alkali metal, m=1 and n=0,
   when M is an alkaline earth metal, m=1 and n=1, or m=2 and n=0, or
   when M is aluminum or a boron, m is an integer of 1 to 3 and n is an integer of 0 to 2, satisfying the relationship M⁺n=3;
OA is a monodentate ligand capable of forming a single bond or a coordinate bond with M,
wherein O is oxygen, and A is selected from among a substituted or unsubstituted alkyl of 1 to 30 carbon atoms, a substituted or unsubstituted aryl of 5 to 50 carbon atoms, a substituted or unsubstituted alkenyl of 2 to 30 carbon atoms, a substituted or unsubstituted alkynyl of 2 to 20 carbon atoms, a substituted or unsubstituted cycloalkyl of 3 to 30 carbon atoms, a substituted or unsubstituted cycloalkenyl of 5 to 30 carbon atoms, and a substituted or unsubstituted heteroaryl of 2 to 50 carbon atoms bearing as a heteroatom at least one selected from among O, N, S and Si.

The term 'substituted' in the expression `substituted or unsubstituted' means having at least one substituent selected from the group consisting of a deuterium atom, a cyano, a halogen, a hydroxy, a nitro, an alkyl, an alkoxy, an alkylamino, an arylamino, a hetero arylamino, an alkylsilyl, an arylsilyl, an aryloxy, an aryl, a heteroaryl, germanium, phosphorus, and boron.

In the present disclosure, the Y's may be the same or different and are each independently selected from among the following Structural Formulas C1 to C39, but are not limited thereto: 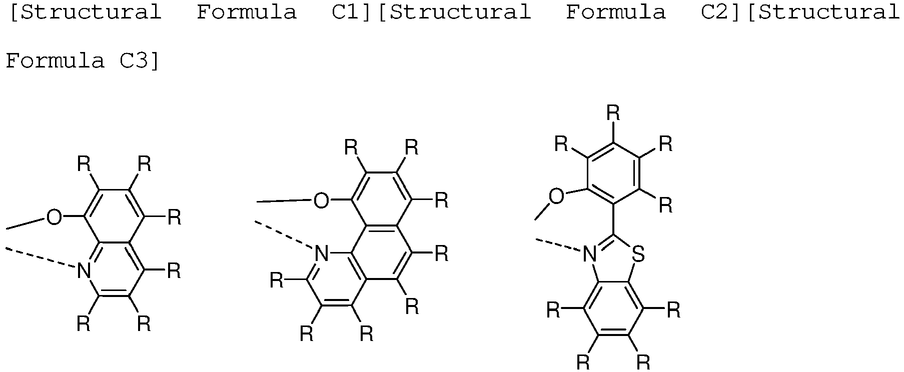 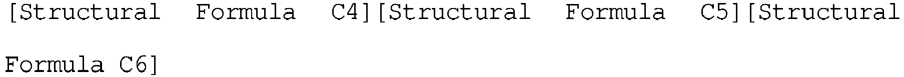 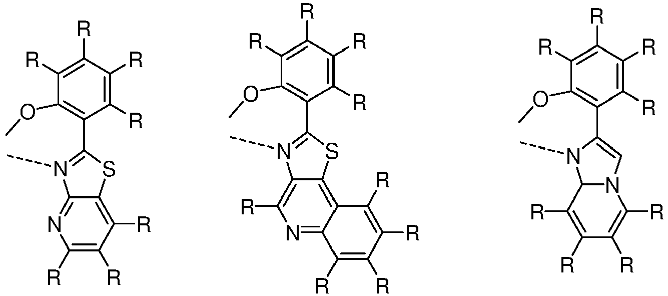 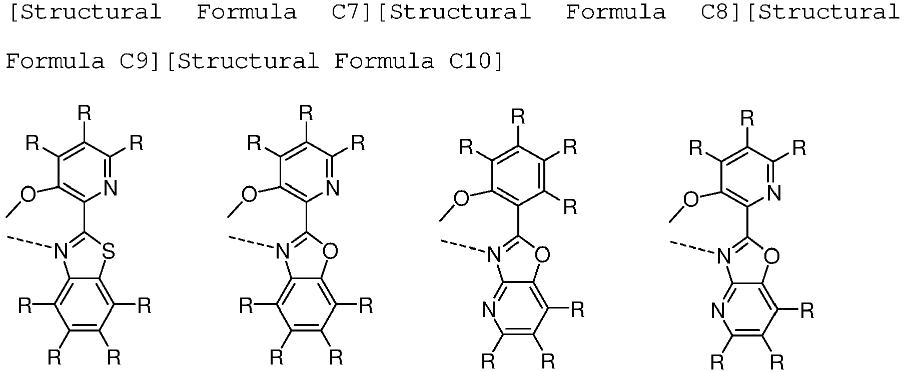 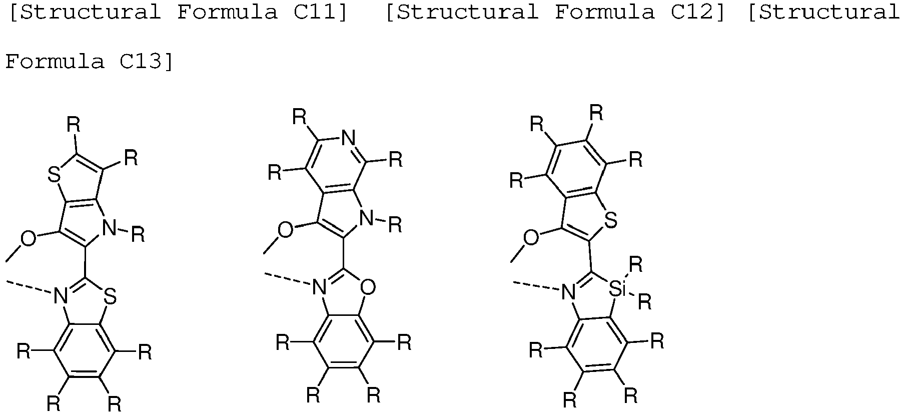 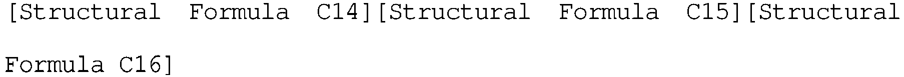 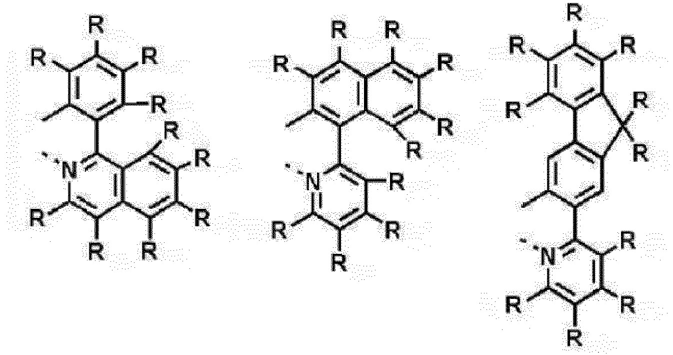 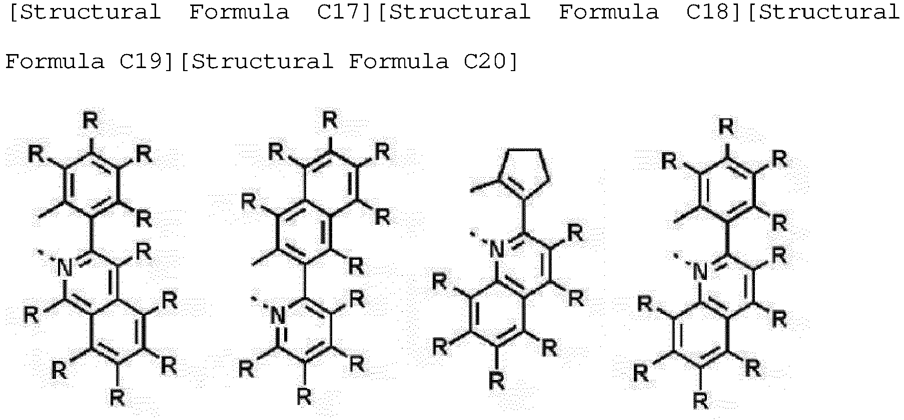 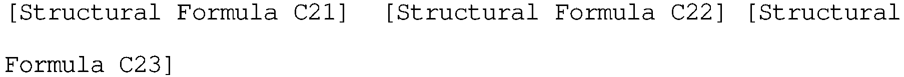 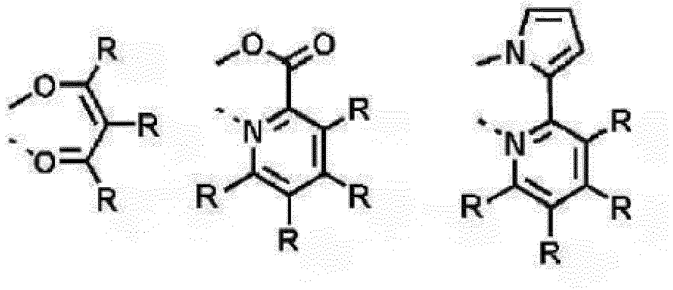 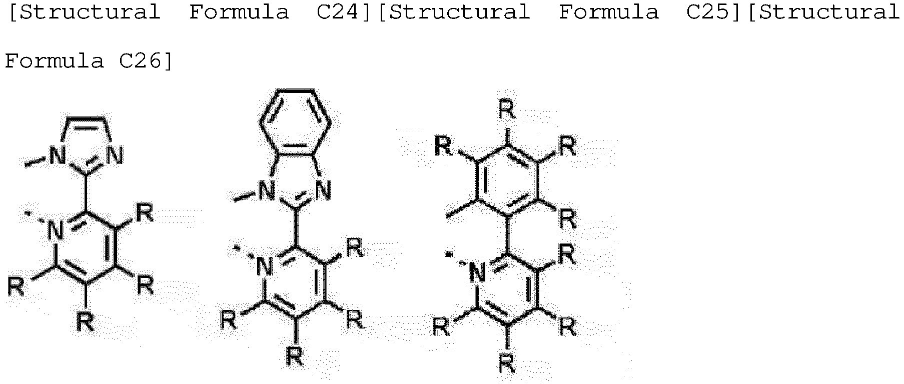 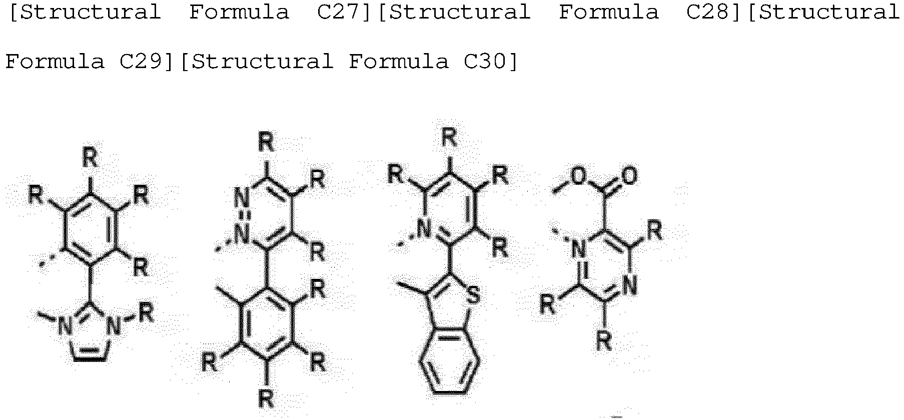 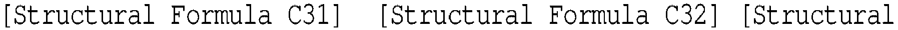 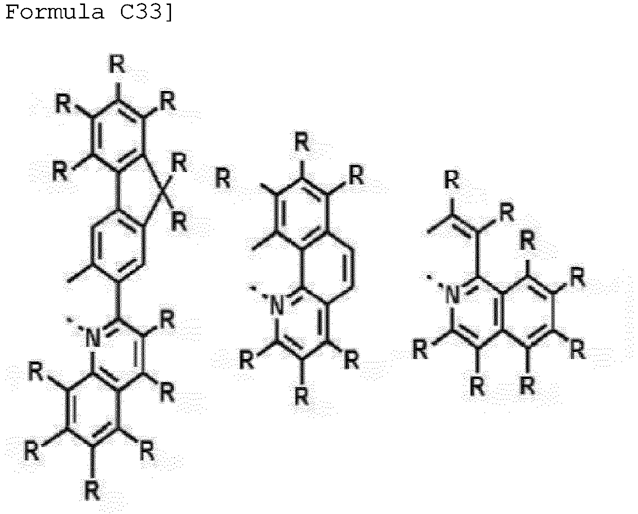 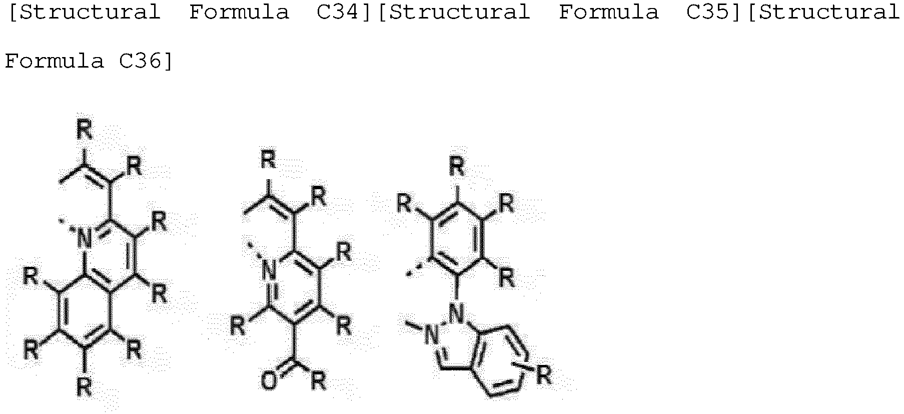 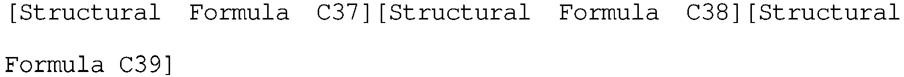 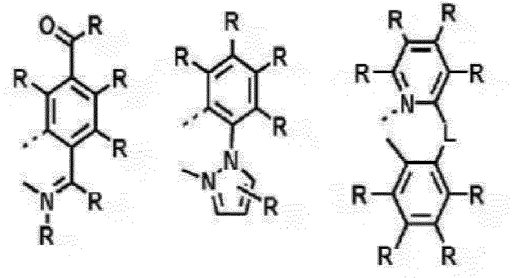 wherein,
R's, which may be same or different, are each independently selected from among a hydrogen, a deuterium, a halogen, a cyano, a substituted or unsubstituted alkyl of 1 to 30 carbon atoms, a substituted or unsubstituted aryl of 6 to 30 carbon atoms, a substituted or unsubstituted heteroaryl of 3 to 30 carbon atoms, a substituted or unsubstituted alkoxy of 1 to 30 carbon atoms, a substituted or unsubstituted cycloalkyl of 3 to 30 carbon atoms, a substituted or unsubstituted alkenyl of 2 to 30 carbon atoms, a substituted or unsubstituted alkylamino of 1 to 30 carbon atoms, a substituted or unsubstituted alkylsilyl of 1 to 30 carbon atoms, a substituted or unsubstituted arylamino of 6 to 30 carbon atoms, and a substituted or unsubstituted arylsilyl of 6 to 30 carbon atoms, and may form a spiro or fused ring with an adjacent substituent via an alkylene or alkenylene linker.

As described above, an electron injection layer (EIL) is disposed on the electron transport layer in the organic light-emitting diode of the present disclosure. So long as it functions to facilitate the injection of electrons from the cathode, any known material may be available for forming the electron injection layer, without particular limitations.

By way of example, a material for the electron injection layer 70 may be CsF, NaF, LiF, NaCl, Li₂O, or BaO. The condition for depositing the electron injection layer is dependent on the compound that is employed, but may fall within the range of conditions for the formation of the hole injection layer.

The electron injection layer may range in thickness from about 1 Å to about 100 Å, and particularly from about 3 Å to about 90 Å. Given this thickness range, the electron injection layer can exhibit satisfactory electron injection properties without an actual increase in driving voltage.

The cathode may be made of a metal or metal alloy such as lithium (Li), magnesium (Mg), aluminum (Al), aluminum-lithium (Al-Li), calcium (Ca), magnesium-indium (Mg-In), and magnesium-silver (Mg-Ag). Alternatively, ITO or IZO may be employed to form a transparent cathode for a top-emitting organic light-emitting diode.

In another embodiment, the light-emitting device of the present disclosure may further comprise a light-emitting layer, made of a blue light-emitting material, a green light-emitting material, or a red light-emitting material, which can emit light in a wavelength range of 380 nm to 800 nm. That is, the light-emitting layer in the organic light-emitting device of the present disclosure may have a multilayer structure in which the additional blue, green, and/or red light-emitting layer may be made of a fluorescent or phosphorescent material.

Furthermore, at least one selected from among the hole injection layer, the hole transport layer, the light-emitting layer, the electron transport layer, and the electron injection layer may be deposited using a deposition process or a solution process.

Here, the deposition process is a process by which a material is vaporized in a vacuum or at a low pressure and deposited to form a layer, and the solution process is a method in which a material is dissolved in a solvent and applied for the formation of a thin film by means of inkjet printing, roll-to-roll coating, screen printing, spray coating, dip coating, spin coating, etc.

Also, the organic light-emitting diode of the present disclosure may be applied to a device selected from among flat display devices, flexible display devices, monochrome or grayscale flat illumination devices, and monochrome or grayscale flexible illumination devices.

A better understanding of the light-emitting diode according to the present disclosure may be obtained through the following examples which are set forth to illustrate, but are not to be construed as limiting the present disclosure.

### HOST PREPARATION: Synthesis of BH Compound

### SYNTHESIS EXAMPLE A: Synthesis of Compound 7

### Synthesis Example A-(1): Synthesis of Compound 7

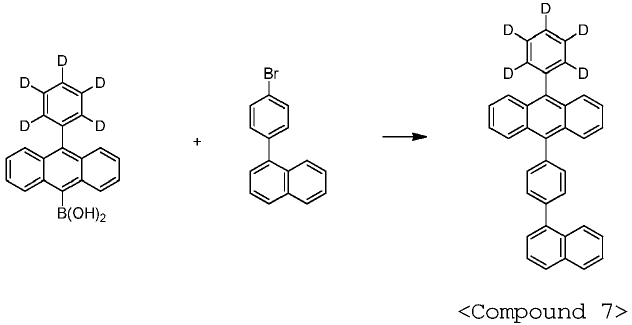

Into a 500-mL round-bottom flask were added 10-phenyl(d5)-anthracene-9-boronic acid (38.6 g, 127 mmol), 1-(4-bromophenyl)naphthalene (30.0g, 106 mmol), tetrakis(triphenylphosphine)palladium (3.43 g, 3 mmol), and potassium carbonate (27.35 g, 197.9 mmol), followed by toluene (150 mL), tetrahydrofuran (150 mL), and water (60 mL). The reactor was heated to a temperature of 90°C at which the mixture was stirred overnight. After completion of the reaction, the temperature of the reactor was lowered to room temperature and extraction was conducted with ethyl acetate. The organic layer thus formed was isolated, concentrated in a vacuum, and then purified through column chromatography to afford <Compound 7>. (39.1 g, 80%)

MS (MALDI-TOF) : m/z 461.22 [M⁺]

### SYNTHESIS EXAMPLE B: Synthesis of Compound 241

### Synthesis Example B-(1): Synthesis of Compound 241

The same procedure as in Synthesis Example A-(1) was carried out, with the exception of using 2-bromodibenzofuran instead of 1-(4-bromophenyl)naphthalene, to afford <Compound 241>.

MS (MALDI-TOF): m/z 461.22 [M⁺]

### Dopant Preparation: Synthesis of BD Compound

### SYNTHESIS EXAMPLE 1: Synthesis of BD 1

### Synthesis Example 1-(1): Synthesis of Intermediate 1-a

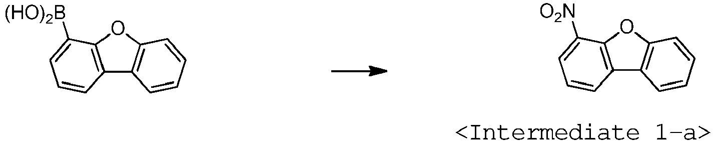

In a 2-L flask, 4-dibenzofuran boronic acid (85.0 g, 0.401 mol), bismuth (III) nitrate pentahydrate (99.2 g, 0.200 mol), and toluene (400 ml) were stirred together at 70°C for 3 hours under a nitrogen atmosphere. After completion of the reaction, the reaction mixture was cooled to room temperature and the precipitate thus formed was washed with toluene to afford <Intermediate 1-a> (61.5 g, 72%) .

### Synthesis Example 1-(2): Synthesis of Intermediate 1-b

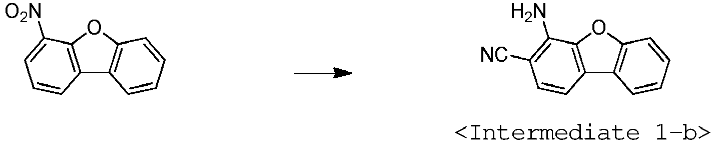

In a 2-L flask, ethyl cyanoacetate (202.9 g, 1.794 mol) and dimethyl formamide (500 ml) were added with potassium hydroxide (67.10 g, 1.196 mol) and potassium cyanide (38.95 g, 0.598 mol) and then with dimethyl formamide (200 ml) before being stirred together at room temperature. The reaction solution was added little by little with <Intermediate 1-a> (127.5 g, 0.737 mol) and then stirred 50°C for 72 hours. After completion of the reaction, sodium hydroxide (25%, 200 ml) was added for stirring under reflux. After three hours of stirring, the reaction mixture was cooled to room temperature and subjected to extraction with ethyl acetate and water. The organic layer thus formed was isolated, concentrated in a vacuum, and purified through column chromatography to afford <Intermediate 1-b> (20.0 g, 16%).

### Synthesis Example 1-(3): Synthesis of Intermediate 1-c

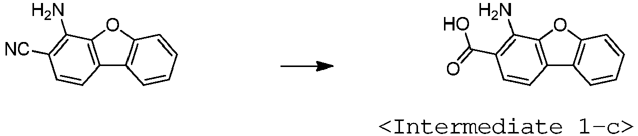

In a 2-L flask, <Intermediate 1-b> (20.0 g, 0.096 mol), ethanol (600 ml), and an aqueous potassium hydroxide solution (142.26 g, 2.53 mol, 170 ml) were stirred together for 12 hours under reflux. After completion of the reaction, the reaction mixture was cooled to room temperature. It was acidified with 6 N HCl (400 ml). The solid thus formed was stirred for 20 minutes and then filtered. The filtrate was washed with ethanol to afford <Intermediate 1-c> (17.0 g, 88%) .

### Synthesis Example 1-(4): Synthesis of Intermediate 1-d

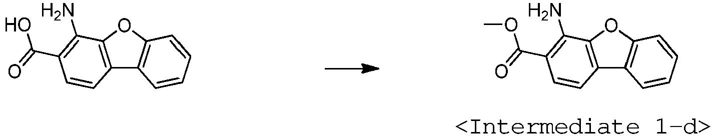

In a 2-L flask, <Intermediate 1-c> (17.0 g, 0.075 mol) and sulfuric acid (15 ml) were stirred together for 72 hours under reflux. After completion of the reaction, the reaction mixture was cooled to room temperature and subjected to extraction with ethyl acetate and water. The organic layer thus formed was isolated and washed with an aqueous sodium hydrogen carbonate. The organic layer was concentrated and added with an excess of methanol. Filtration afforded <Intermediate 1-d> as a solid (14.0 g, 78%).

### Synthesis Example 1-(5): Synthesis of Intermediate 1-e

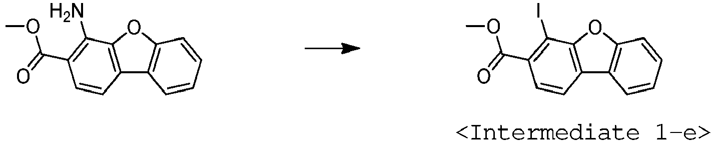

In a 1-L flask, <Intermediate 1-d> (32.6 g, 0.135 mol), HCl (30 ml), and water (150 ml) were stirred at 0°C for 1 hour. At the same temperature, an aqueous sodium nitrite solution (11.2 g, 0.162 mol, 75 ml) was added dropwise, followed by stirring for 1 hour. An aqueous potassium iodide (44.8 g, 0.270 mol, 75 ml) was added dropwise, taking care that the temperature of the reaction solution did not exceed 5°C. Stirring was conducted at room temperature for 5 hours. After completion of the reaction, the reaction mixture was washed with an aqueous sodium thiosulfate and subjected to extraction with ethyl acetate and water. The organic layer was concentrated in a vacuum and purified through column chromatography to afford <Intermediate 1-e> (22.8 g, 48%).

### Synthesis Example 1-(6): Synthesis of Intermediate 1-f

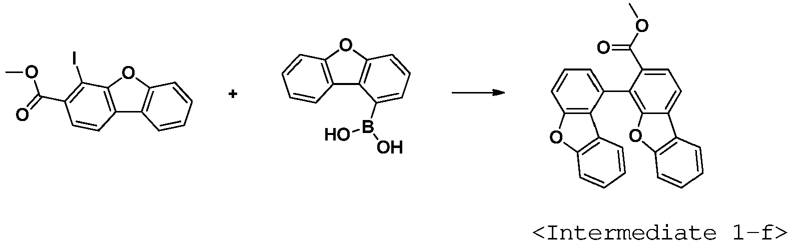

Into a 500-mL flask were added <Intermediate 1-e> (25.7 g, 73 mmol), 1-dibenzofuran boronic acid (18.7 g, 88 mmol), tetrakis(triphenylphosphine)palladium (1.7 g, 0.15 mmol), and potassium carbonate (20.2 g, 146.7 mmol), followed by toluene (125 mL), tetrahydrofuran (125 mL), and water (50 mL). The reactor was heated to 80°C at which the mixture was stirred for 10 hours. After completion of the reaction, the reactor was cooled to room temperature and the reaction mixture was subjected to extraction with ethyl acetate. The organic layer thus formed was isolated, concentrated in a vacuum, and purified through column chromatography to afford <Intermediate 1-f>. (14.9 g, 52%)

### Synthesis Example 1-(7): Synthesis of Intermediate 1-g

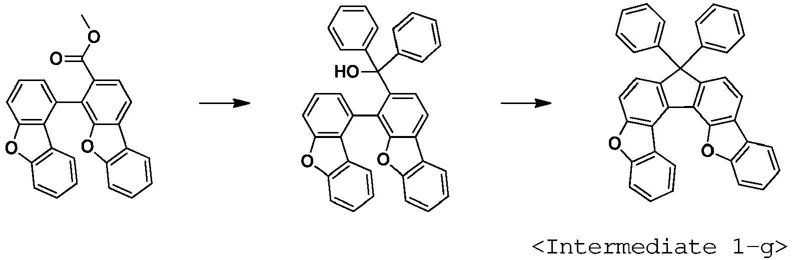

In a 500-mL flask, bromobenzene (25.5 g, 0.163 mol) and tetrahydrofuran (170 ml) were chilled to -78°C under a nitrogen atmosphere. To this chilled solution, drops of butyl lithium(1.6 M) (95.6 ml, 0.153 mol) were added. Following stirring at the same temperature for 1 hour, the solution was added with <Intermediate 1-f> (20.0 g, 0.051 mol) and stirred at room temperature for 3 hours. After completion of the reaction, the reaction mixture was added with water (50 ml), stirred for 30 minutes, and subjected to extraction with ethyl acetate and water. The organic layer thus formed was isolated and concentrated in a vacuum. The concentrate was added with acetic acid (200 ml) and HCl (1 ml) and stirred at 80°C. After completion of the reaction, the reaction mixture was filtered and washed with methanol to afford <Intermediate 1-g> (20.0 g, 78%).

### Synthesis Example 1-(8): Synthesis of Intermediate 1-h

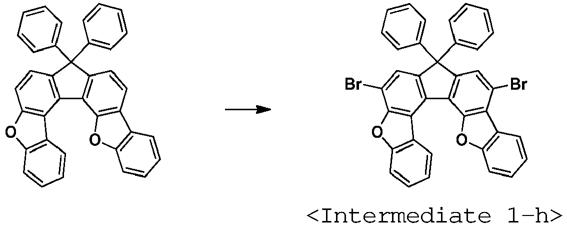

In a 1-L flask, <Intermediate 1-g> (16.5 g, 33 mmol) and dichloromethane (300 ml) were stirred at room temperature. A dilution of bromine (3.4 ml, 66 mmol) in chloromethane (50 ml) was added dropwise and stirred at room temperature for 8 hours. After completion of the reaction, acetone (100 ml) was added to the reaction vessel and stirred again. The solid thus formed was filtered and washed with acetone. Recrystallization in monochlorobenzene afforded <Intermediate 1-h>. (12.6 g, 58%)

### Synthesis Example 1-(9): Synthesis of BD 1

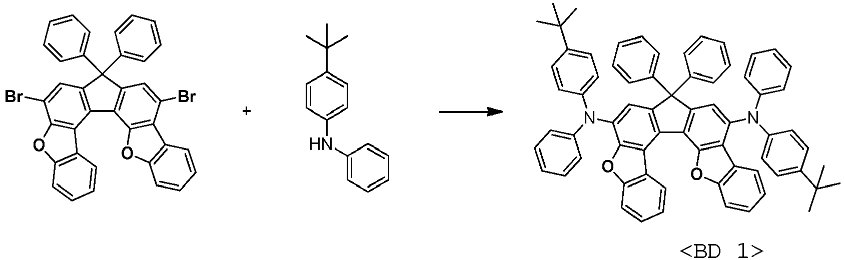

In a 250-mL flask, <Intermediate 1-h> (5.9 g, 0.009 mol), (4-tert-butylphenyl)-phenyl amine (4.7 g, 0.021 mol), palladium (II) acetate (0.08 g, 0.4 mmol), sodium tert-butoxide (3.4 g, 0.035 mol), tri-tert-butyl phosphine (0.07 g, 0.4 mmol), and toluene (60 ml) were stirred together for 2 hours under reflux. After completion of the reaction, the reaction mixture was cooled to room temperature and subjected to dichloromethane and water. Extraction with dichloromethane and water was conducted, and the organic layer thus formed was isolated, dried over magnesium sulfate, and concentrated in a vacuum. Following isolation through column chromatography, recrystallization in dichloromethane and acetone afforded <BD 1>. (4.9 g, 58%)

MS (MALDI-TOF) : m/z 944.43 [M⁺]

### SYNTHESIS EXAMPLE 2: Synthesis of BD 2

### Synthesis Example 2-(1): Synthesis of Intermediate 2-a

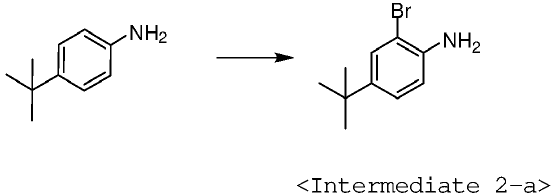

In a 1-L reactor, a solution of 4-tert-butyl aniline (40 g, 236 mmol) in methylene chloride (400 mL) was stirred at 0°C. Subsequently, N-bromosuccinimide (42 g, 236 mmol) was slowly added to the reactor. The temperature was raised elevated to the room temperature before stirring for 4 hours. After completion of the reaction, H₂O was dropwise added at room temperature and extraction with methylene chloride was conducted. The organic layer thus formed was concentrated. Purification through column chromatography afforded <Intermediate 2-a> (48 g, 80%) .

### Synthesis Example 2-2. Synthesis of <Intermediate 2-b>

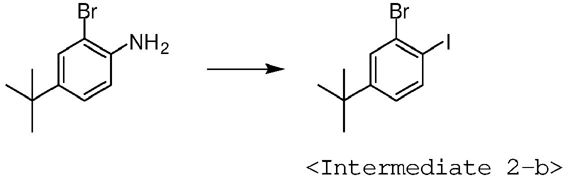

In a 2-L reactor, <Intermediate 2-a> (80 g, 351 mmol) and water (450 mL) were stirred together. Sulfuric acid (104 mL) was added. At 0°C, a solution of sodium nitrite (31.5 g, 456 mmol) in water (240 mL) was added dropwise and stirred for 2 hours. A solution of potassium iodide (116.4 g, 701 mmol) in water (450 mL) was added dropwise at 0°C and then stirred at room temperature for 6 hours. After completion of the reaction, an aqueous sodium thiosulfate solution was added at room temperature and stirred. The organic layer thus formed was concentrated, followed by isolation through column chromatography to afford <Intermediate 2-b> (58 g, 51%).

### Synthesis Example 2-3. Synthesis of <Intermediate 2-c>

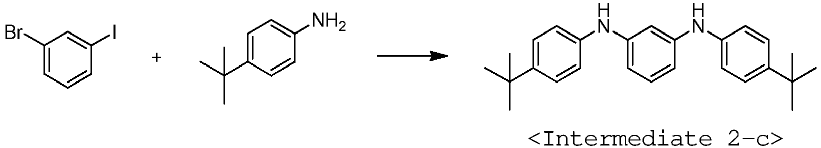

In a 1-L reactor, 1-bromo-5-iodobenzene (50.1 g, 177 mmol), 4-tert-butyl aniline (58 g, 389 mmol), palladium acetate (1.6 g, 7 mmol), sodium tert-butoxide (51 g, 530 mmol), bis(diphenylphosphino)-1,1'-binaphthyl (4.4 g, 7 mmol), and toluene (500 mL) were stirred together for 24 hours under reflux. After completion of the reaction, the reaction mixture was filtrated. The filtrate was concentrated and purified through column chromatography to afford <Intermediate 2-c> (52.8 g, 80%).

### Synthesis Example 2-4. Synthesis of <Intermediate 2-d>

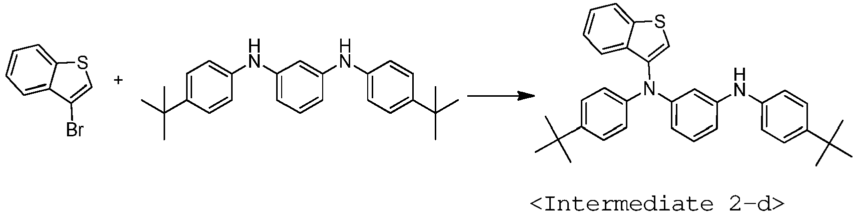

In a 250-mL reactor, <Intermediate 2-c> (36.5 g, 98 mmol), 3-bromobenzothiophene (20.9 g, 98 mmol), palladium acetate (0.5 g, 2 mmol), sodium tert-butoxide (18.9 g, 196 mmol), tri-tert-butylphosphine (0.8 g, 4 mmol), and toluene (200 mL) were stirred together for 5 hours under reflux. After completion of the reaction, the rection mixture was filtrated and the filtrate was purified by column chromatography to afford <Intermediate 2-d> (35.6 g, 72%).

### Synthesis Example 2-5. Synthesis of <Intermediate 2-e>

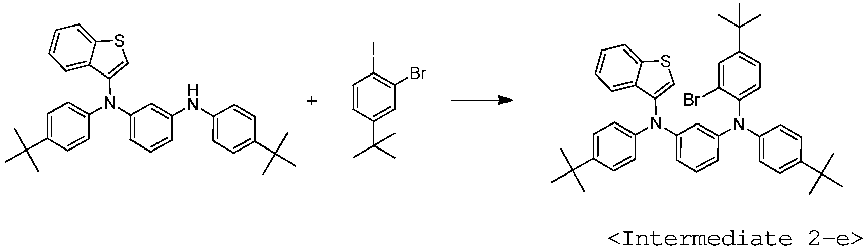

The same procedure as in Synthesis Example 2-(4) was carried out, with the exception of using <Intermediate 2-d> and 2-bromo-4-tert-butyl-1-iodobenzene instead of <Intermediate 2-c> and 3-bromobenzothiophene, to afford <Intermediate 2-e>. (yield 67 %)

### Synthesis Example 2-6. Synthesis of BD 2

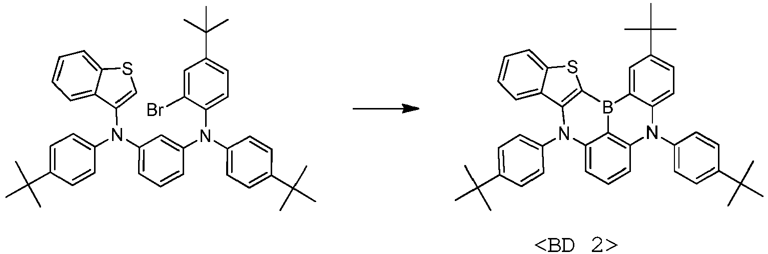

In a 300-mL reaction, <Intermediate 2-e> (16.5 g, 23 mmol) and tert-butyl benzene (120 mL) were added with drops of n-butyl lithium (42.5 mL, 68 mmol) at -78°C, followed by stirring at 60°C for 3 hours. At the same temperature, heptane was purged with nitrogen. Addition of drops of boron tribromide (11.3 g, 45 mmol) at -78°C, stirring at room temperature for one hour, addition of drops of NN-diisopropylethyl amine (5.9 g, 45 mmol) at 0°C, and stirring at 120°C for 2 hours were conducted in that order. After completion of the reaction, an aqueous sodium acetate solution was added at room temperature. Extraction with ethyl acetate was followed by concentrating the organic layer. Purification through column chromatography afforded <BD 2> (2.2 g, 15%).

MS (MALDI-TOF) : m/z 644.34 [M⁺]

### EXAMPLES 1 TO 18: Fabrication of Organic Light-Emitting Diodes

An ITO glass substrate was patterned to have a translucent area of 2 mm×2 mm and cleansed. The ITO glass was mounted in a vacuum chamber that was then set to have a base pressure of 1×10⁻⁷ torr. On the ITO glass substrate, the following organic layers were sequentially formed. HAT-CN was formed as a hole injection layer at a thickness of 70 nm. NPD was deposited as a first hole transport layer at a thickness of 30 nm. The compounds listed in Table 1 with a weight ratio (wt%) of 7:3 set forth therebetween were deposited at a thickness of 25 nm. When the light-emitting layer was deposited, the dopants listed in Table 1 were used in an amount of 3 wt%, based on 100 wt% of the hosts. Subsequently, compounds of [Chemical Formula E-1] and [Chemical Formula E-2] were deposited at a ratio of 1:1 to form electron transport layers 30 nm thick. As an electron injection layer, [Chemical Formula E-2] was deposited at a thickness of 1 nm. A cathode was formed by depositing Al at a thickness of 100 nm. The organic light-emitting diodes thus obtained were measured at 10 mA/cm² for luminescence properties.

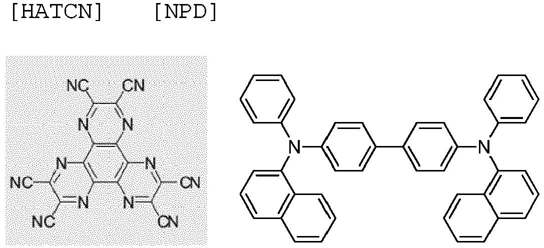

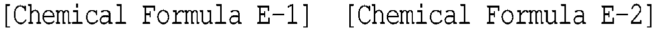

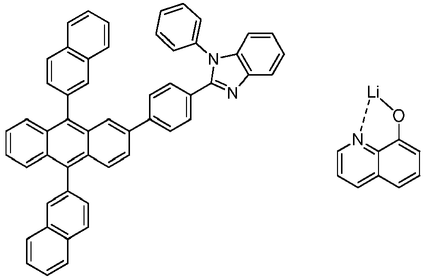

### COMPARATIVE EXAMPLES 1 TO 4

Organic light-emitting diodes were fabricated in the same manner as in Examples 1 to 18 with the exception of using compounds listed in Table 1 as hosts. The organic light-emitting diodes were measured at 10 mA/cm² for luminescence properties.

**TABLE 1**

| Example | Compound A | Compound B | Dopant | Volt (V) | Efficacy (cd/A) | Lifespan (T97) |
|---|---|---|---|---|---|---|
| Ex. 1 | Cpd. 7 | Cpd. 216 | BD1 | 3.8 | 7.34 | 269 |
| Ex. 2 | Cpd. 7 | Cpd. 234 | BD1 | 3.77 | 7.39 | 272 |
| Ex. 3 | Cpd. 18 | Cpd. 241 | BD1 | 3.78 | 7.38 | 270 |
| Ex. 4 | Cpd. 18 | Cpd. 270 | BD1 | 3.77 | 7.42 | 275 |
| Ex. 5 | Cpd. 44 | Cpd. 234 | BD1 | 3.8 | 7.38 | 274 |
| Ex. 6 | Cpd. 44 | Cpd. 316 | BD1 | 3.82 | 7.36 | 268 |
| Ex. 7 | Cpd. 14 | Cpd. 216 | BD1 | 3.8 | 7.35 | 265 |
| Ex. 8 | Cpd. 14 | Cpd. 270 | BD1 | 3.78 | 7.4 | 272 |
| Ex. 9 | Cpd. 7 | Cpd. 216 | BD2 | 3.68 | 7.7 | 283 |
| Ex. 10 | Cpd. 7 | Cpd. 234 | BD2 | 3.62 | 7.74 | 290 |
| Ex. 11 | Cpd. 18 | Cpd. 241 | BD2 | 3.64 | 7.72 | 286 |
| Ex. 12 | Cpd. 18 | Cpd. 270 | BD2 | 3.61 | 7.78 | 292 |
| Ex. 13 | Cpd. 44 | Cpd. 234 | BD2 | 3.63 | 7.75 | 288 |
| Ex. 14 | Cpd. 44 | Cpd. 316 | BD2 | 3.7 | 7.68 | 280 |
| Ex. 15 | Cpd. 95 | Cpd. 216 | BD2 | 3.67 | 7.7 | 285 |
| Ex. 16 | Cpd. 95 | Cpd. 270 | BD2 | 3.61 | 7.76 | 290 |
| Ex. 17 | Cpd. 81 | Cpd. 240 | BD1 | 3.82 | 7.30 | 258 |
| Ex. 18 | Cpd. 81 | Cpd. 240 | BD2 | 3.70 | 7.58 | 272 |
| C. Ex. 1 | Cpd. 7 | - | BD1 | 4.11 | 7.28 | 284 |
| C. Ex. 2 | - | Cpd. 241 | BD1 | 3.72 | 7.15 | 184 |
| C. Ex. 3 | Cpd. 7 | | BD2 | 4.08 | 7.3 | 296 |
| C. Ex. 4 | - | Cpd. 241 | BD2 | 3.49 | 7.51 | 186 |

As can be understood from the data of Table 1, all the characteristics of low driving voltage, long lifespan, and high efficiency were generally improved in balance in the light-emitting diodes in which the light-emitting layers were prepared with two types of the anthracene compounds according to the present disclosure, compared to organic light-emitting diodes using a single anthracene compound, so that the light-emitting diodes of the present disclosure are highly industrially applicable.

### Industrial Applicability

The organic light-emitting diode in which the light-emitting layer is prepared with two or more types of anthracene compounds according to the present disclosure exhibits a balanced improvement in low driving voltage, long lifespan, and high luminous efficiency characteristics, compared to organic light-emitting diodes employing single anthracene compounds. With such improved characteristics, the organic light-emitting diode of the present disclosure can find advantageous applications in the related industries.

## Claims

1. An organic light-emitting diode, comprising:
a first electrode;
a second electrode facing the first electrode; and
a light-emitting layer disposed between the first electrode and the second electrode,
wherein,
the light-emitting layer contains a host and a dopant, the host comprising at least one compound represented by the following Chemical Formula A and at least one compound represented by the following Chemical Formula B, with a structural difference therebetween: 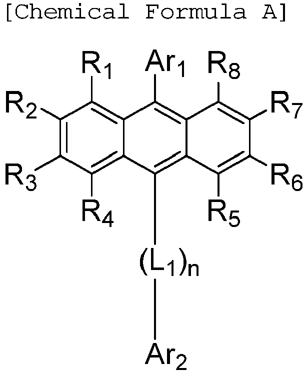
wherein,
R₁ to R₈, which are same or different, are each independently any one selected from a hydrogen atom, a deuterium atom, a substituted or unsubstituted alkyl of 1 to 30 carbon atoms, a substituted or unsubstituted aryl of 6 to 50 carbon atoms, a substituted or unsubstituted alkenyl of 2 to 30 carbon atoms, a substituted or unsubstituted alkynyl of 2 to 20 carbon atoms, a substituted or unsubstituted cycloalkyl of 3 to 30 carbon atoms, a substituted or unsubstituted cycloalkenyl of 5 to 30 carbon atoms, a substituted or unsubstituted heteroaryl of 2 to 50 carbon atoms, a substituted or unsubstituted heterocycloalkyl of 2 to 30 carbon atoms, a substituted or unsubstituted alkoxyl of 1 to 30 carbon atoms, a substituted or unsubstituted aryloxyl of 6 to 30 carbon atoms, a substituted or unsubstituted alkylthioxy of 1 to 30 carbon atoms, a substituted or unsubstituted arylthioxy of 6 to 30 carbon atoms, a substituted or unsubstituted alkylamine of 1 to 30 carbon atoms, a substituted or unsubstituted arylamine of 6 to 30 carbon atoms, a substituted or unsubstituted alkylsilyl of 1 to 30 carbon atoms, a substituted or unsubstituted arylsilyl of 6 to 30 carbon atoms, a cyano, and a halogen,
An and Ar₂, which are same or different, are each independently any one selected from a substituted or unsubstituted aryl of 6 to 50 carbon atoms and a substituted or unsubstituted heteroaryl of 2 to 50 carbon atoms,
L₁, which functions as a linker, is any one selected from a single bond, a substituted or unsubstituted arylene of 6 to 20 carbon atoms, and a substituted or unsubstituted heteroarylene of 2 to 20 carbon atoms,
n is an integer of 1 to 3 wherein when n is 2 or greater, corresponding L₁'s are same or different; 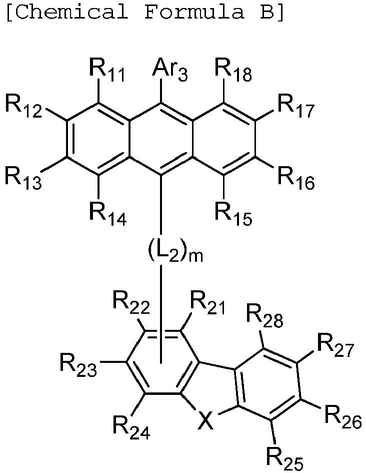
wherein,
R₁₁ to R₁₈ and R₂₁ to R₂₈, which are same or different, are each independently selected from a hydrogen atom, a deuterium atom, a substituted or unsubstituted alkyl of 1 to 30 carbon atoms, a substituted or unsubstituted aryl of 6 to 50 carbon atoms, a substituted or unsubstituted alkenyl of 2 to 30 carbon atoms, a substituted or unsubstituted alkynyl of 2 to 30 carbon atoms, a substituted or unsubstituted cycloalkyl of 3 to 30 carbon atoms, a substituted or unsubstituted cycloalkenyl of 5 to 30 carbon atoms, a substituted or unsubstituted heteroaryl of 2 to 50 carbon atoms, a substituted or unsubstituted heterocycloalkyl of 2 to 30 carbon atoms, a substituted or unsubstituted alkoxyl of 1 to 30 carbon atoms, a substituted or unsubstituted aryloxyl of 6 to 30 carbon atoms, a substituted or unsubstituted alkylthioxy of 1 to 30 carbon atoms, a substituted or unsubstituted arylthioxy of 6 to 30 carbon atoms, a substituted or unsubstituted alkylamine of 1 to 30 carbon atoms, a substituted or unsubstituted arylamine of 6 to 30 carbon atoms, a substituted or unsubstituted alkylsilyl of 1 to 30 carbon atoms, a substituted or unsubstituted arylsilyl of 6 to 30 carbon atoms, a cyano, and a halogen,
Ar₃ is any one selected from a substituted or unsubstituted aryl of 6 to 50 carbon atoms and a substituted or unsubstituted heteroaryl of 2 to 50 carbon atoms,
one of R₂₁ to R₂₈ is a single bond to L₂ that functions as a linker,
X is O or S,
the linker L₂ is any one selected from a single bond, a substituted or unsubstituted arylene of 6 to 20 carbon atoms, and a substituted or unsubstituted heteroarylene of 2 to 20 carbon atoms, and
m is an integer of 1 to 3 wherein when m is 2 or greater, corresponding L₂'s are same or different,
wherein the term "substituted" in the expression "substituted or unsubstituted" for [Chemical Formula A] and [Chemical Formula B] means having at least one substituent selected from the group consisting of a deuterium atom, a cyano, a halogen, a hydroxy, a nitro, an alkyl of 1 to 24 carbon atoms, a halogenated alkyl of 1 to 24 carbon atoms, a cycloalkyl of 3 to 30 carbon atoms, an alkenyl of 2 to 24 carbon atoms, an alkynyl of 2 to 24 carbon atoms, a heteroalkyl of 1 to 24 carbon atoms, an aryl of 6 to 24 carbon atoms, an arylalkyl of 7 to 24 carbon atoms, an alkylaryl of 7 to 24 carbon atoms, a heteroaryl of 2 to 24 carbon atoms, a heteroarylalkyl of 2 to 24 carbon atoms, an alkoxy of 1 to 24 carbon atoms, an alkylamino of 1 to 24 carbon atoms, an arylamino of 6 to 24 carbon atoms, a heteroarylamino of 1 to 24 carbon atoms, an alkylsilyl of 1 to 24 carbon atoms, and an arylsilyl of 6 to 24 carbon atoms, aryloxy of 6 to 24 carbon atoms.

2. The organic light-emitting diode of claim 1, wherein the substituents R₁ to R₈ in Chemical Formula A are same or different and each independently a hydrogen atom or a deuterium atom.

3. The organic light-emitting diode of claim 1, wherein the substituents Ar₁ and Ar₂ in Chemical Formula A are same or different and each independently a substituted or unsubstituted aryl of 6 to 18 carbon atoms.

4. The organic light-emitting diode of claim 3, wherein the substituents Ar₁ and Ar₂ are same or different and each independently any one selected from a substituted or unsubstituted phenyl, a substituted or unsubstituted naphthyl, a substituted or unsubstituted anthracenyl, a substituted or unsubstituted phenanthrenyl, and a substituted or unsubstituted fluorenyl.

5. The organic light-emitting diode of claim 1, wherein the liner in [Chemical Formula A] is a single bond or a substituted or unsubstituted arylene of 6 to 18 carbon atoms.

6. The organic light-emitting diode of claim 5, wherein the linker L₁ in Chemical Formula A is a single bond or any one selected from the following Structural Formulas 21 to 27: 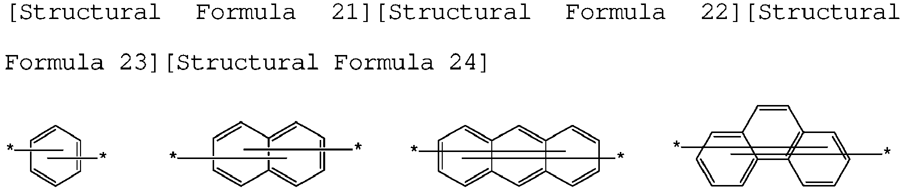 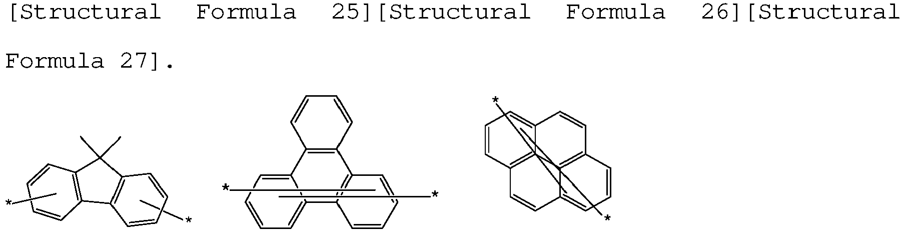 wherein each of the unsubstituted carbon atoms of the aromatic ring moiety in the linker L₁ can be bound with a hydrogen atom or a deuterium atom.

7. The organic light-emitting diode of claim 1, wherein the compound represented by Chemical Formula A is:
a hydrocarbon composed only of carbon atoms and hydrogen atoms as intramolecular elements; or
a hydrocarbon composed only of carbon atoms, deuterium atoms, and hydrogen atoms as intramolecular elements,

8. The organic light-emitting diode of claim 1, wherein the substituents R₁₁ to R₁₈ and R₂₁ to R₂₈ in Chemical Formula B are same or different and each independently a hydrogen atom or a deuterium atom.

9. The organic light-emitting diode of claim 1, wherein the substituent Ar₃ in Chemical Formula B is a substituted or unsubstituted aryl of 6 to 18 carbon atoms.

10. The organic light-emitting diode of claim 9, wherein Ar₃ is any one selected from a substituted or unsubstituted phenyl, a substituted or unsubstituted naphthyl, a substituted or unsubstituted anthracenyl, a substituted or unsubstituted phenanthrenyl, and a substituted or unsubstituted fluorenyl.

11. The organic light-emitting diode of claim 1, wherein the linker L₂ in Chemical Formula B is a single bond or a substituted or unsubstituted arylene of 6 to 18 carbon atoms.

12. The organic light-emitting diode of claim 11, wherein the linker L₂ in Chemical Formula B is a single bond or a single bond or any one selected from the following Structural Formulas 41 to 47: 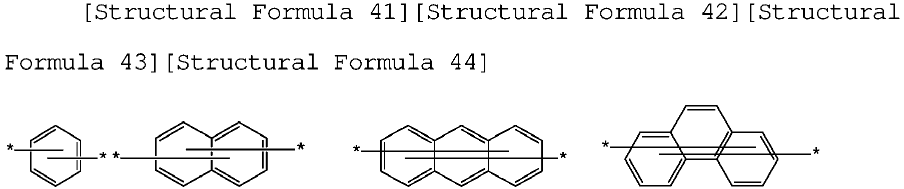 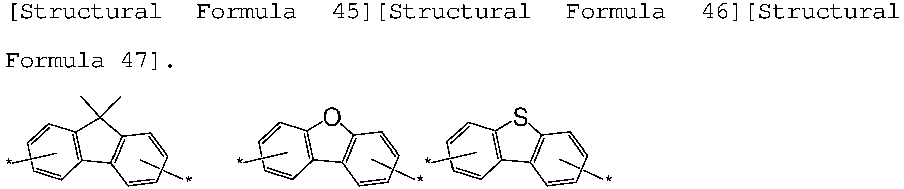 wherein, each of the unsubstituted carbon atoms of the aromatic ring moiety can be bound with a hydrogen atom or a deuterium atom.

13. The organic light-emitting diode of claim 1, wherein the compound represented by Chemical Formula B is:
a hydrocarbon composed only of carbon atoms and hydrogen atoms, except for X, as intramolecular elements; or
a hydrocarbon composed only of carbon atoms, deuterium atoms, and hydrogen atoms, except for X, as intramolecular elements.

14. The organic light-emitting diode of claim 1, wherein the compound represented by Chemical Formula A is any one selected from the following Compounds 1 to 105:

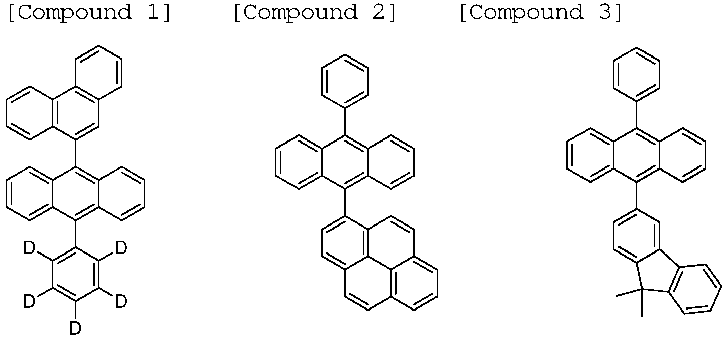

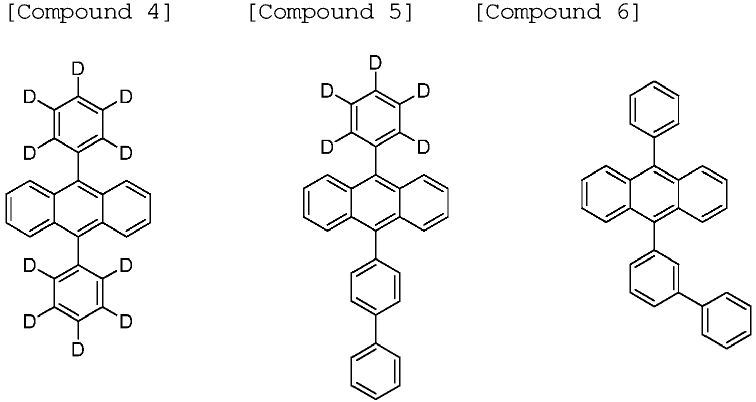

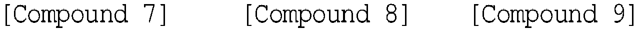

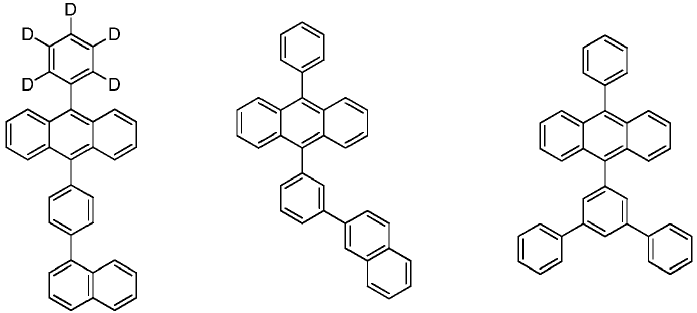

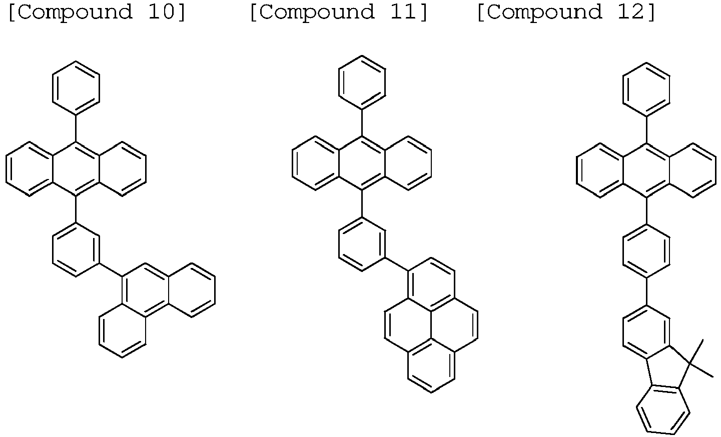

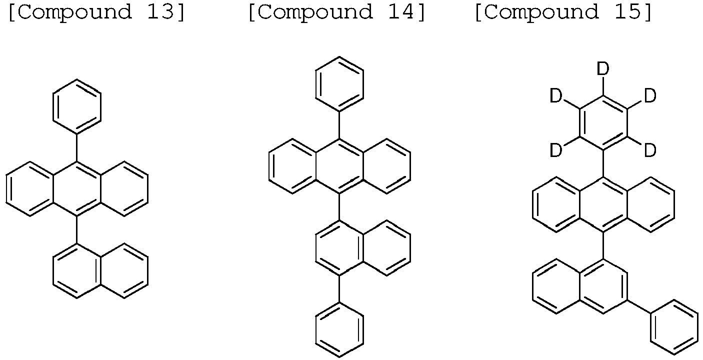

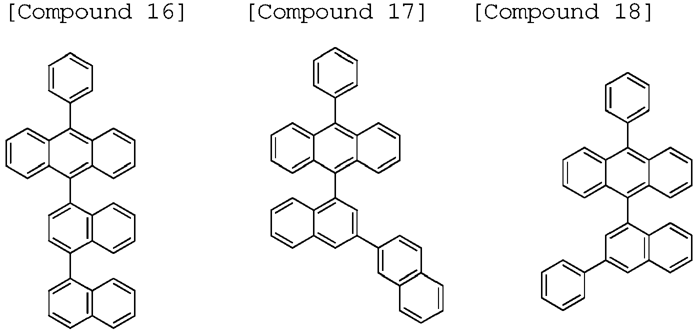

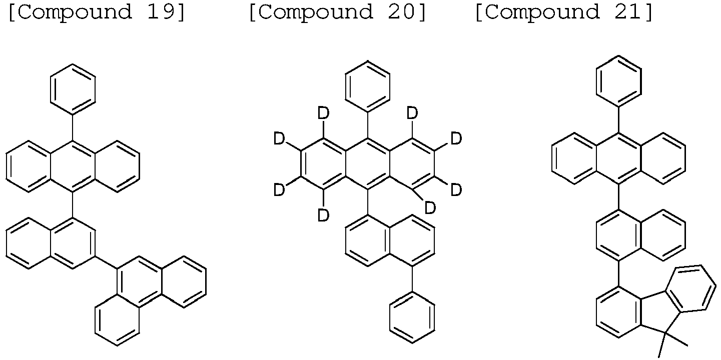

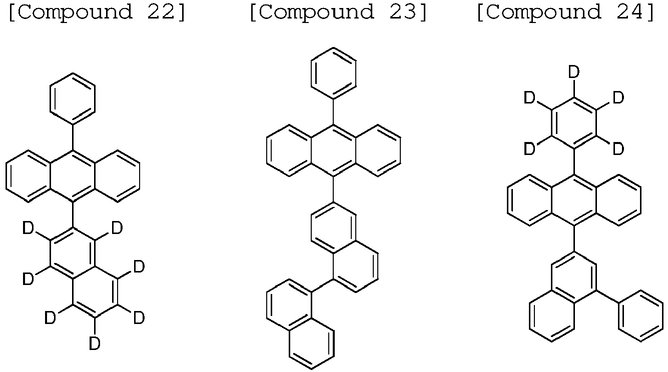

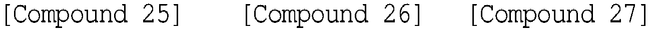

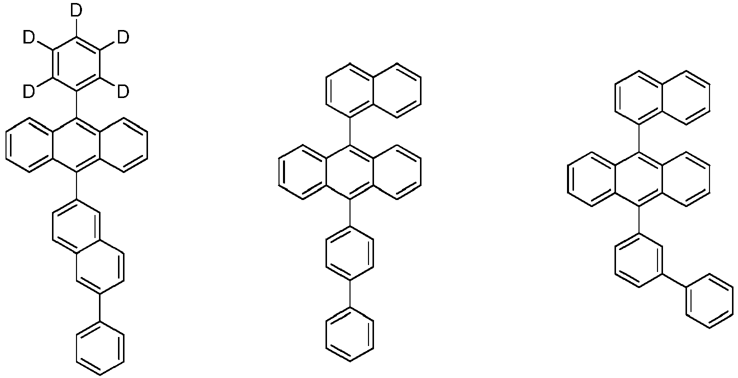

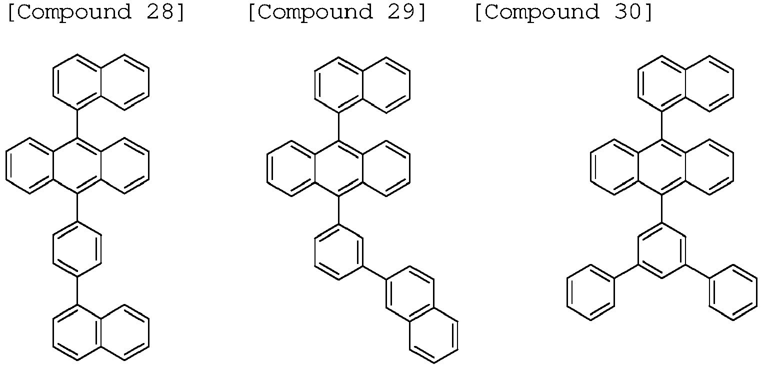

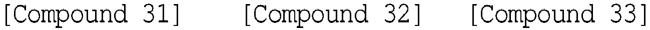

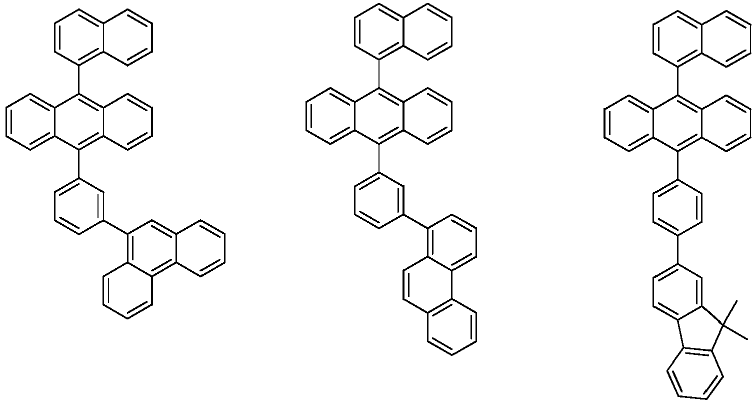

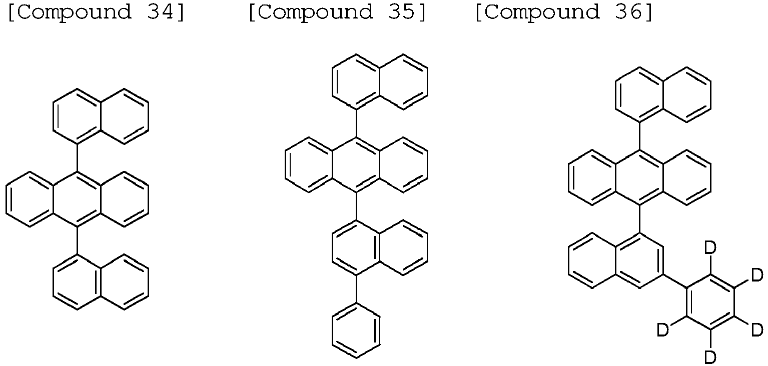

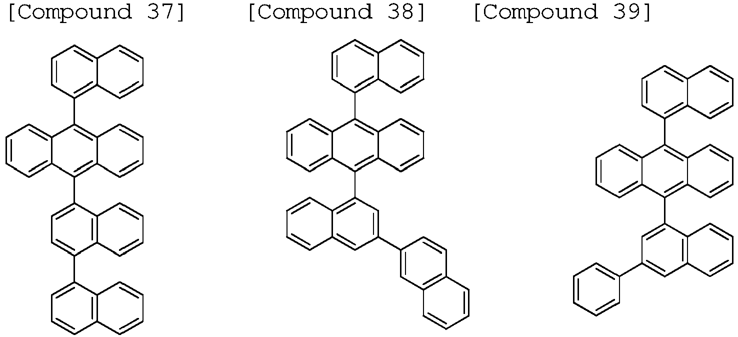

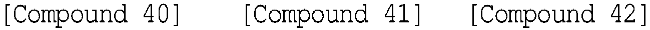

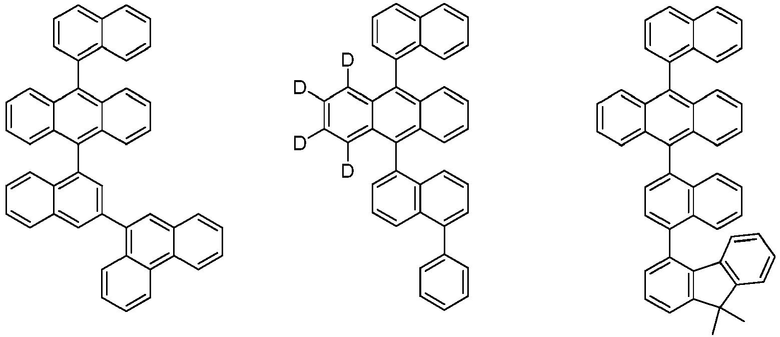

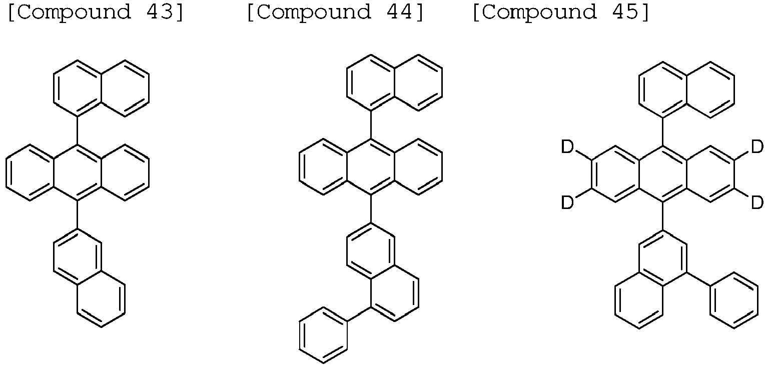

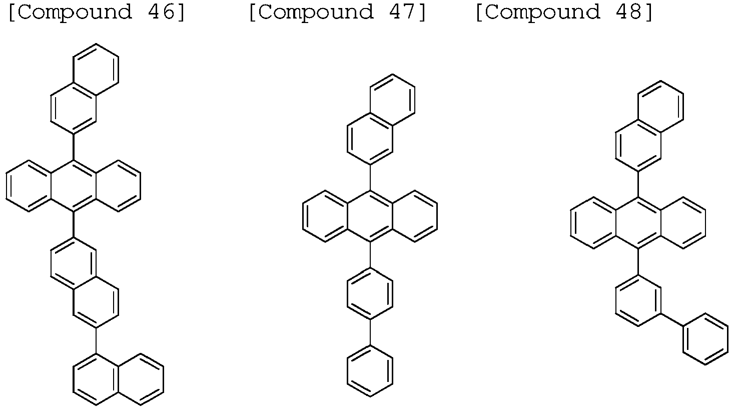

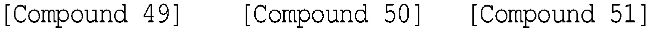

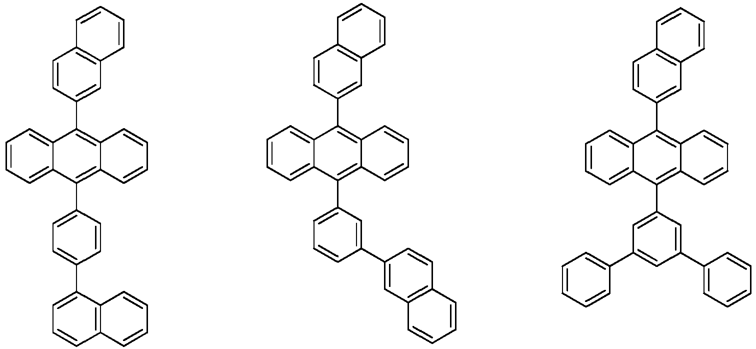

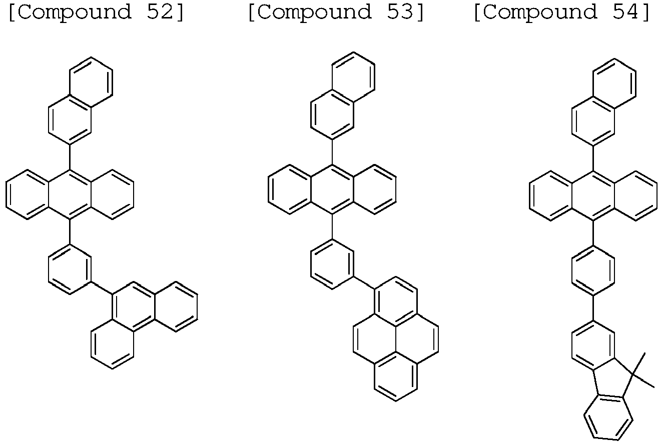

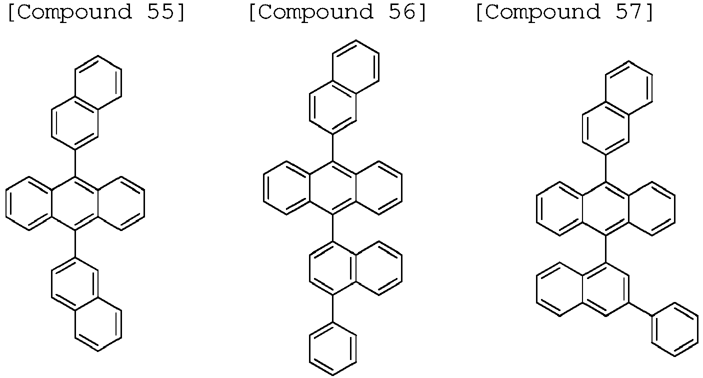

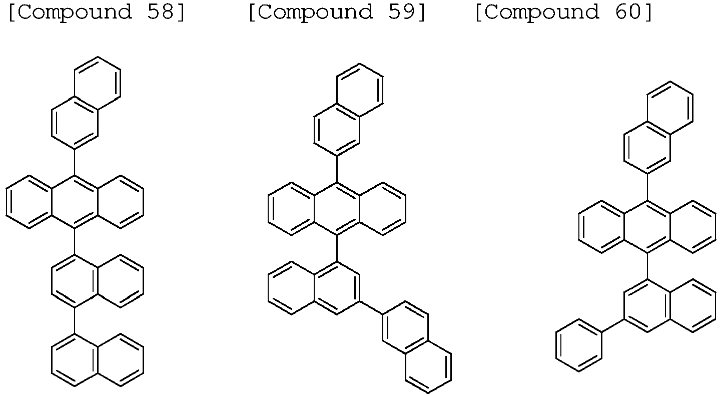

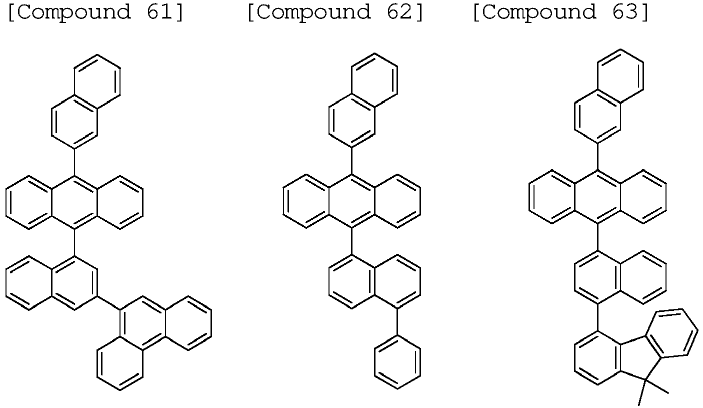

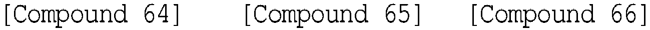

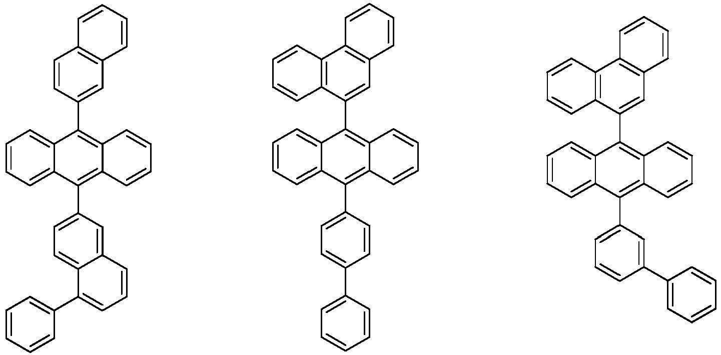

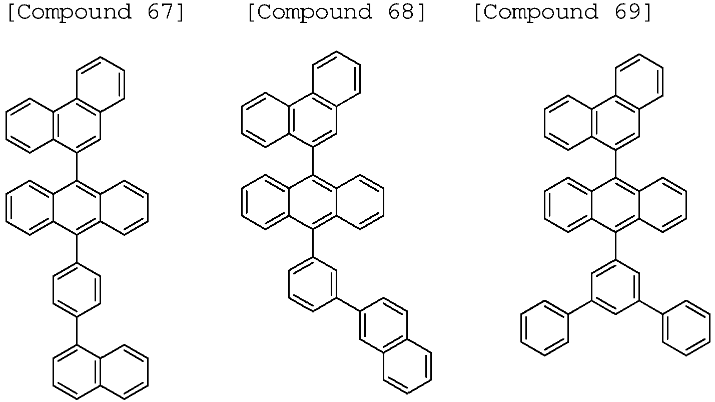

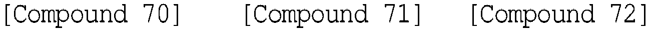

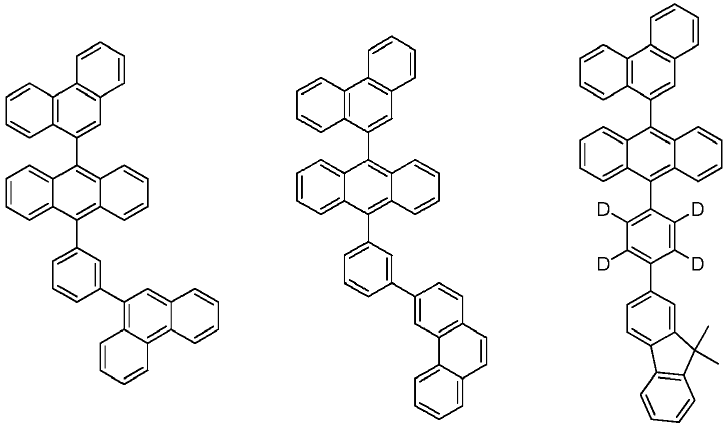

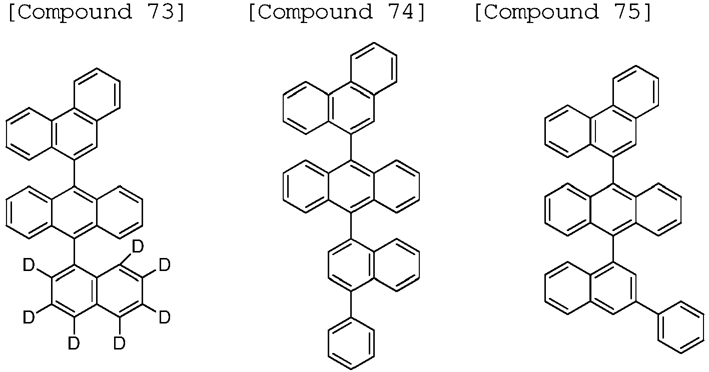

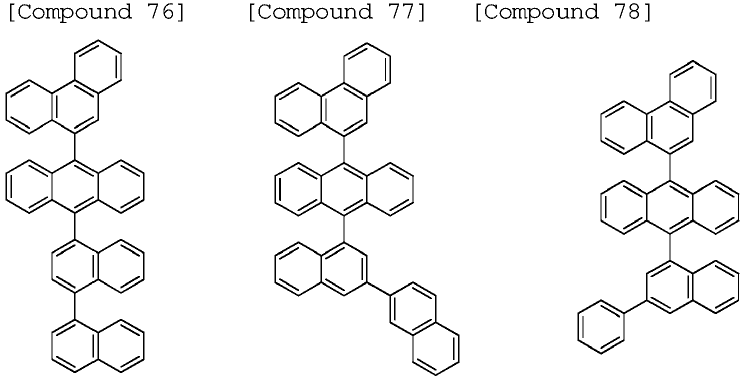

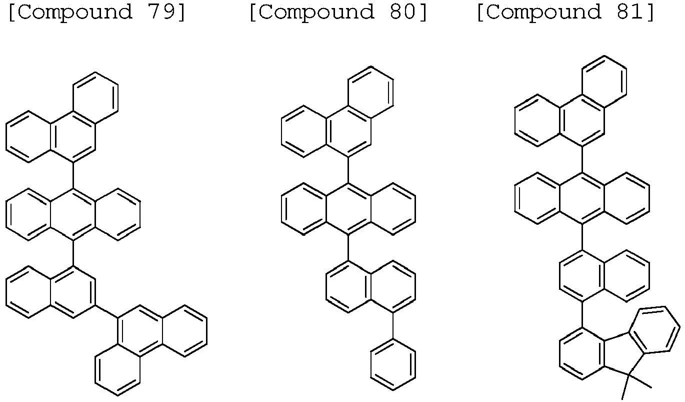

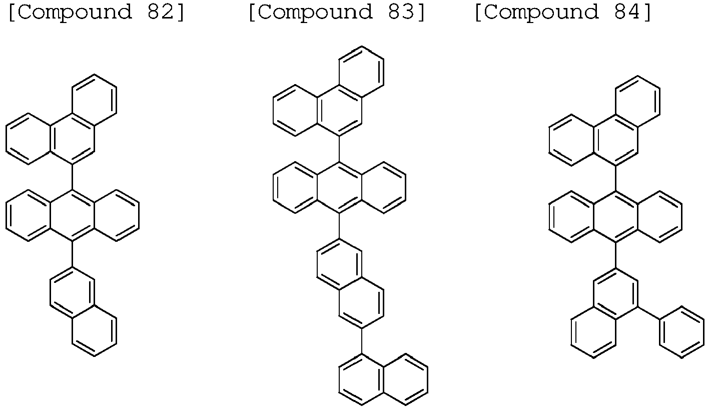

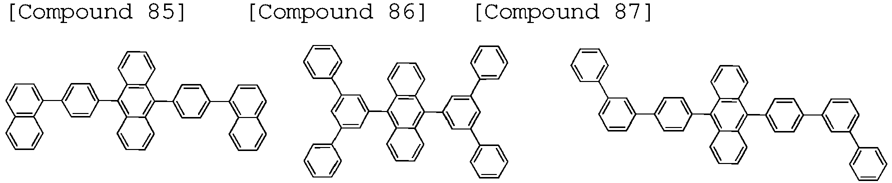

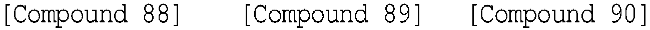

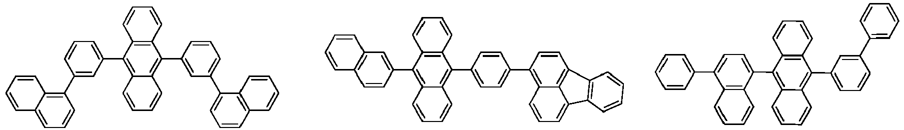

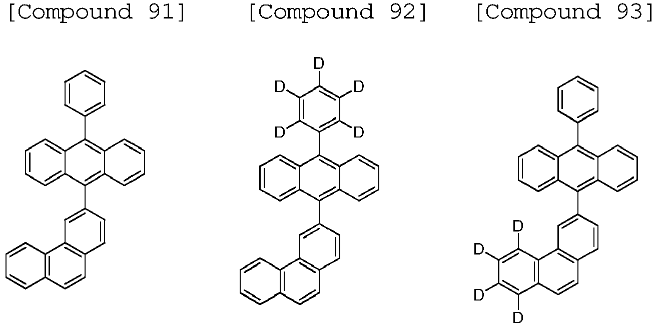

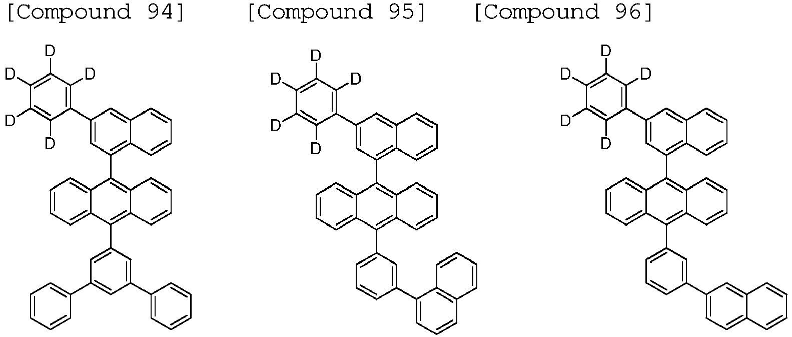

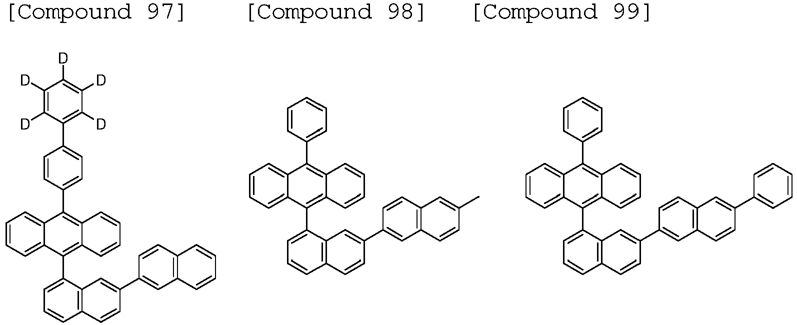

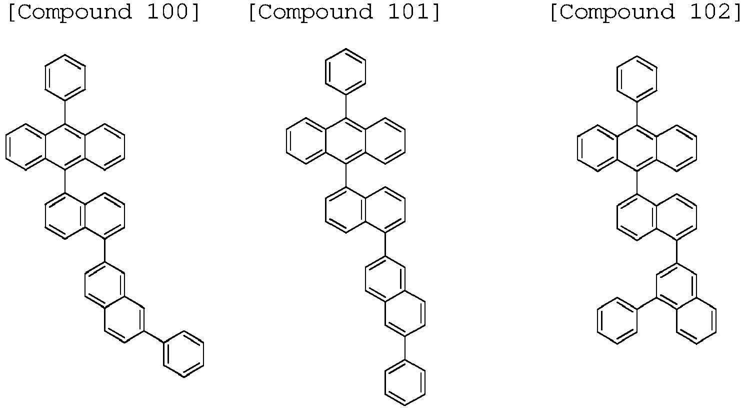

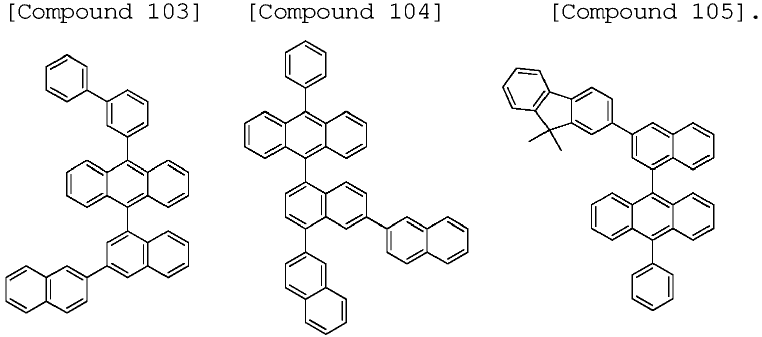

15. The organic light-emitting diode of claim 1, wherein the compound represented by Chemical Formula B is any one selected from the following Compounds 201 to 353:

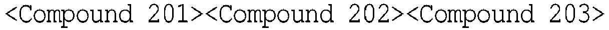

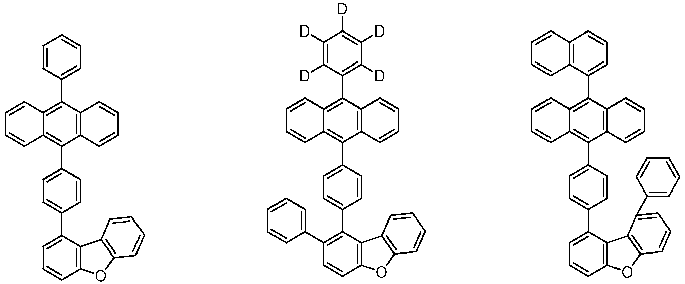

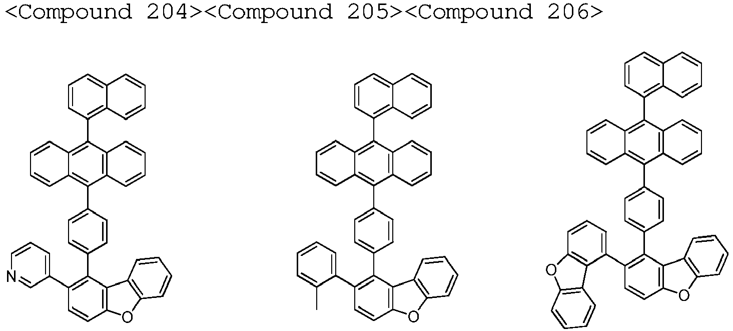

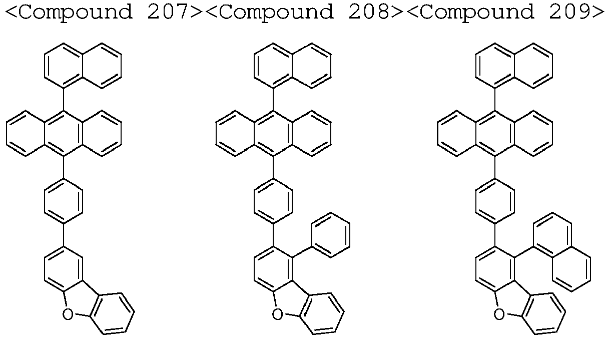

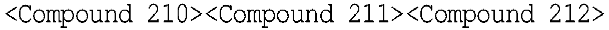

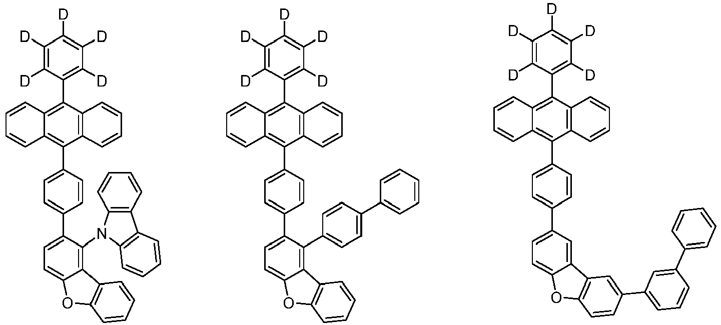

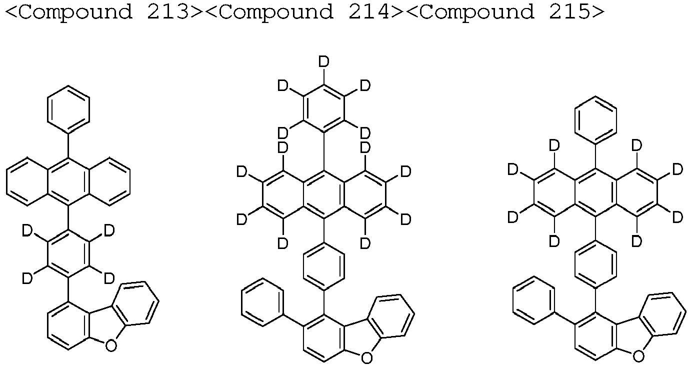

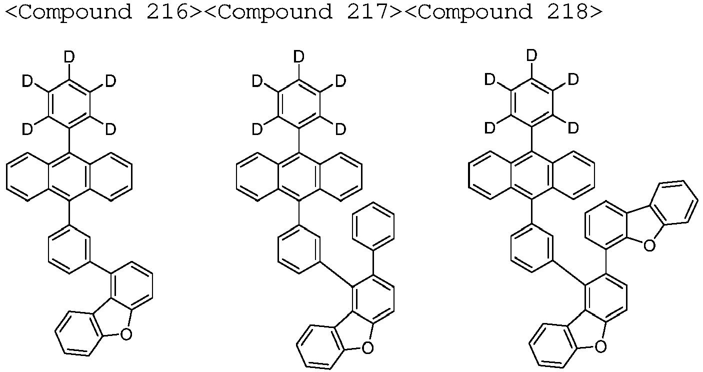

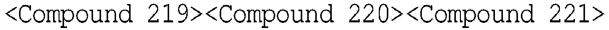

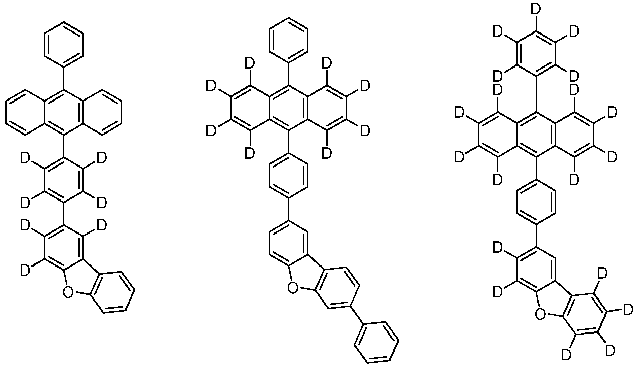

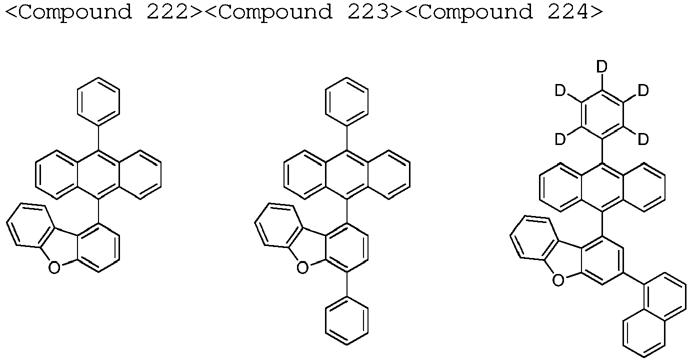

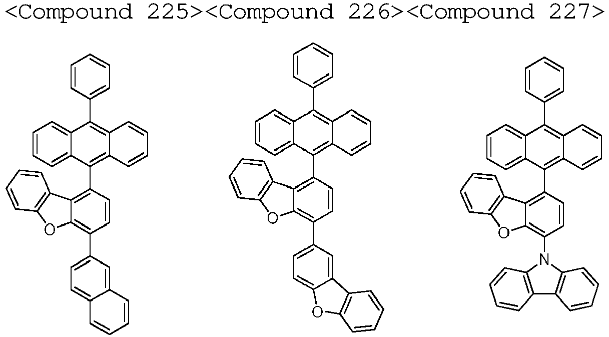

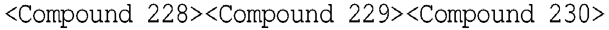

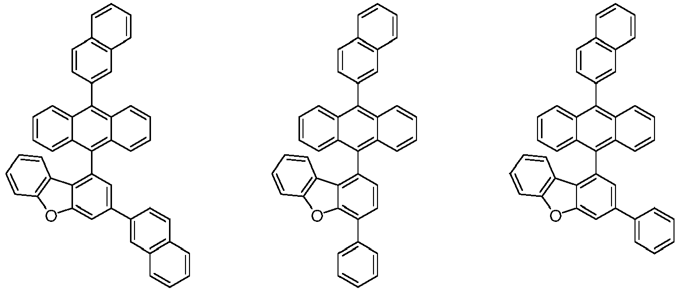

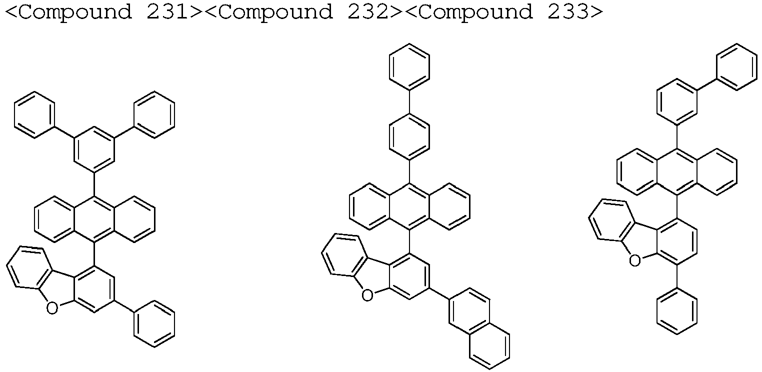

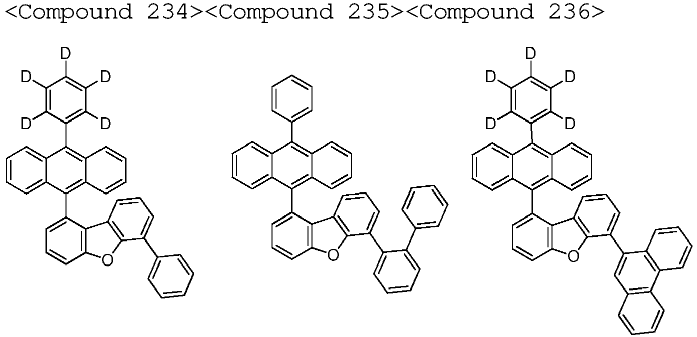

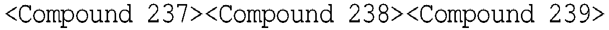

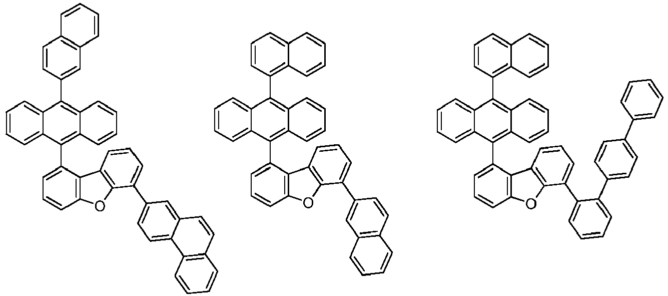

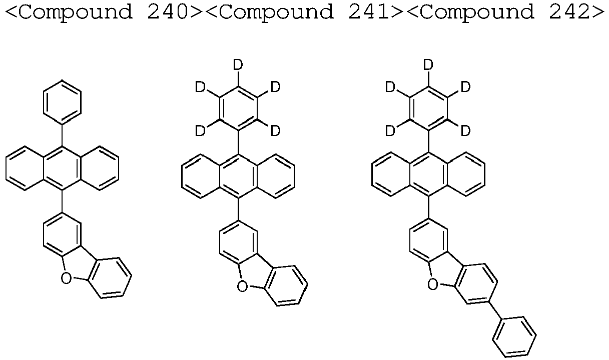

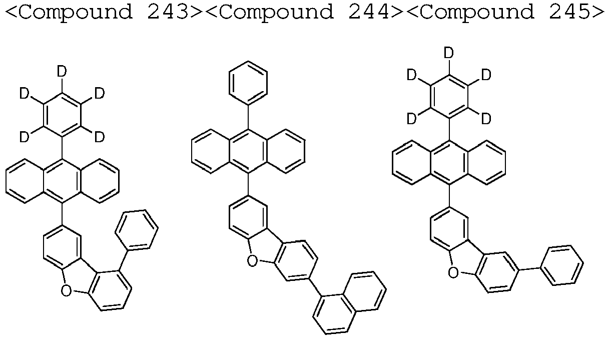

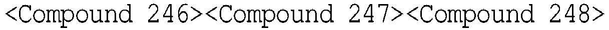

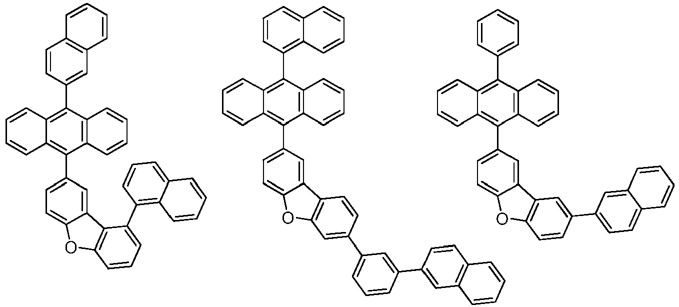

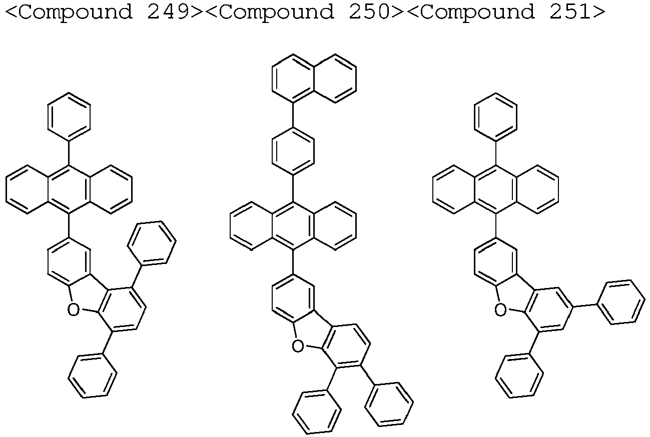

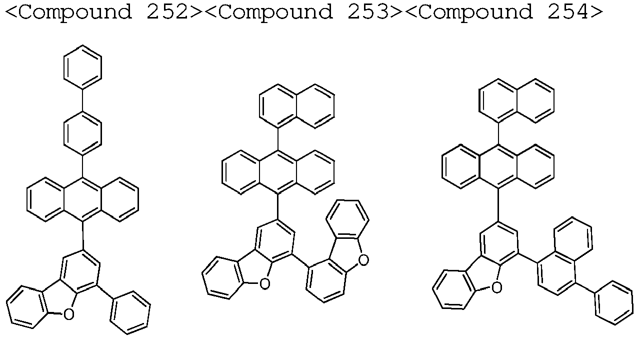

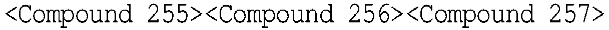

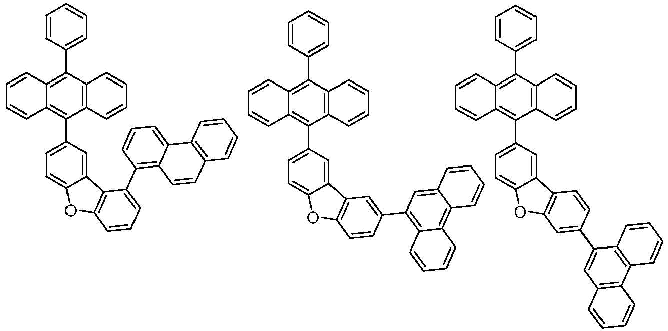

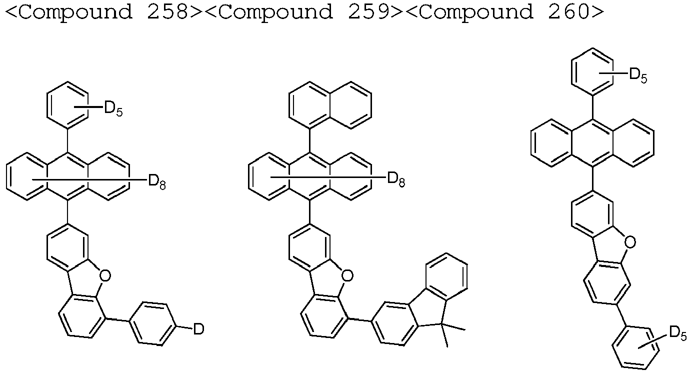

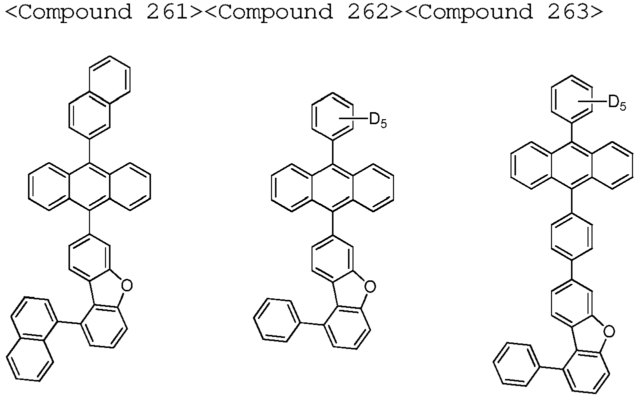

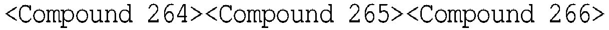

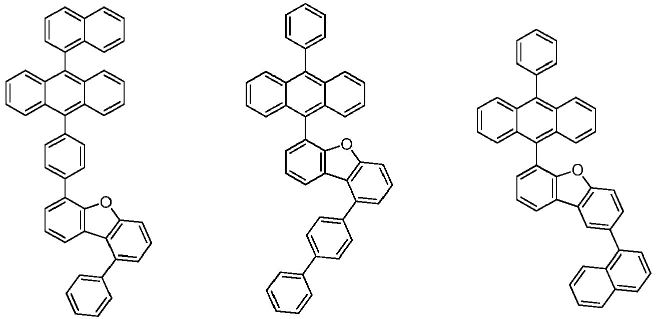

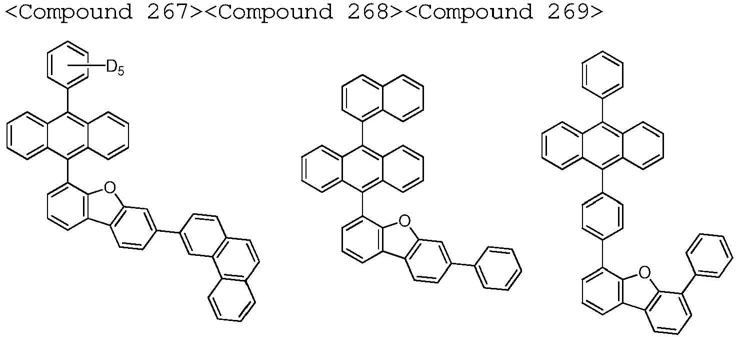

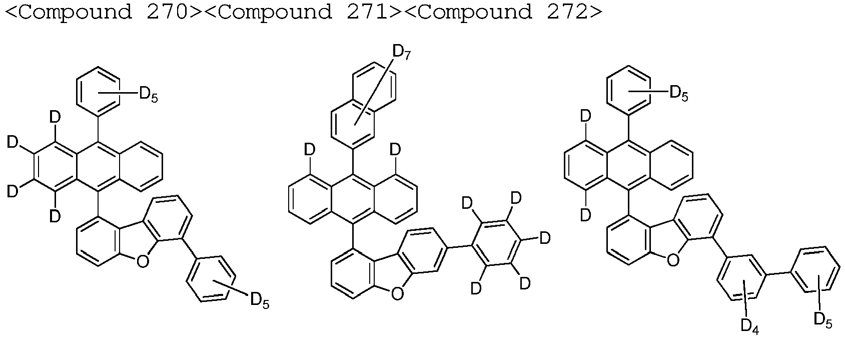

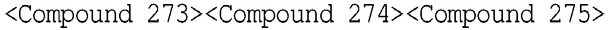

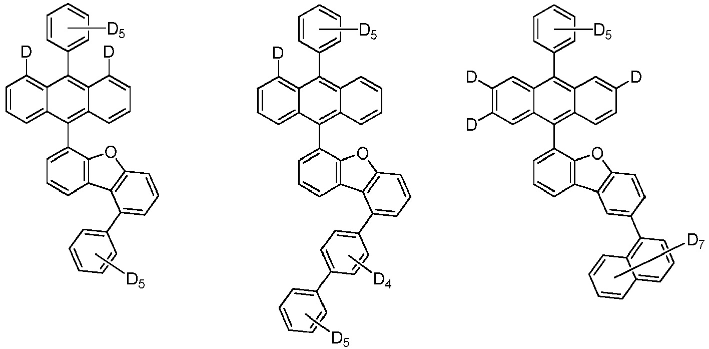

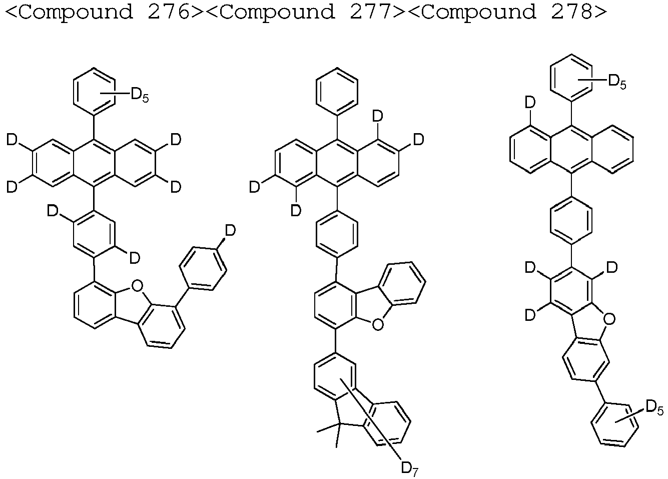

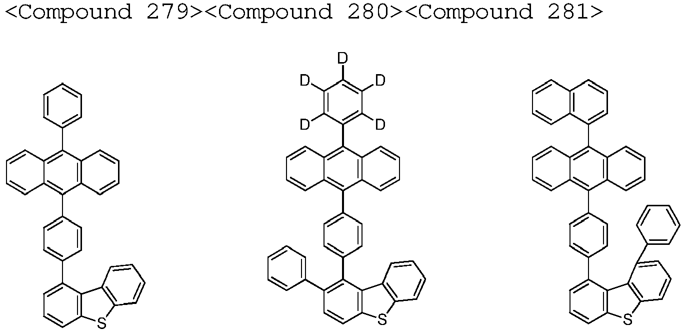

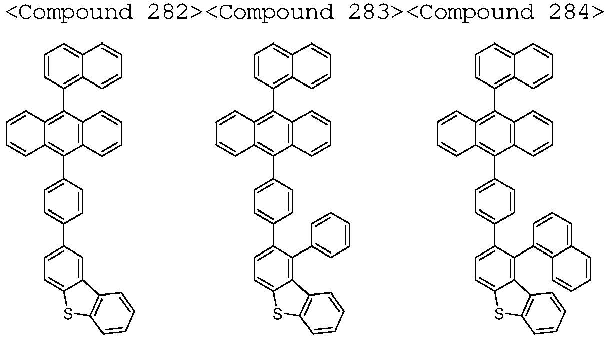

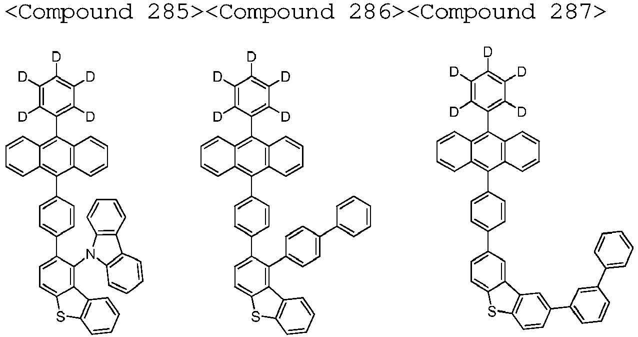

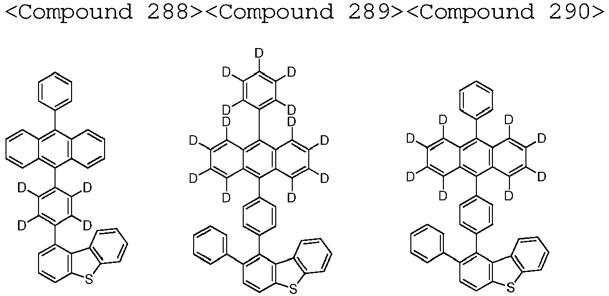

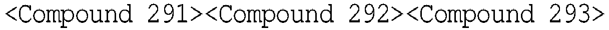

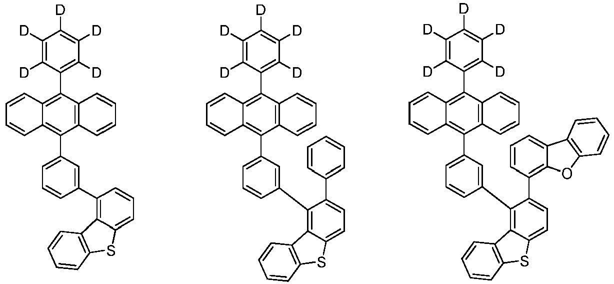

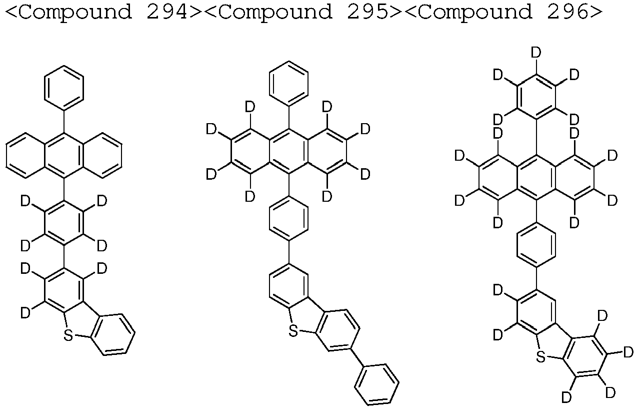

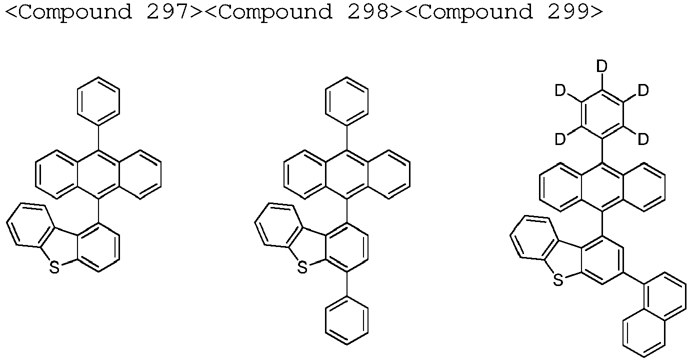

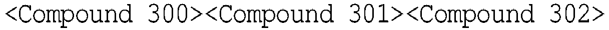

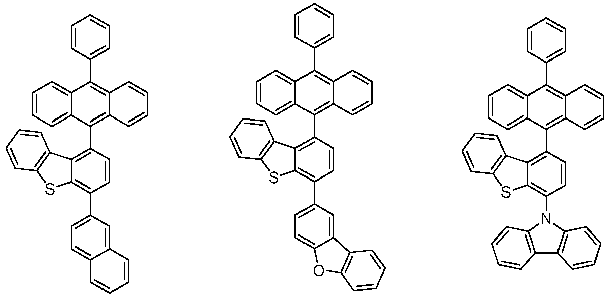

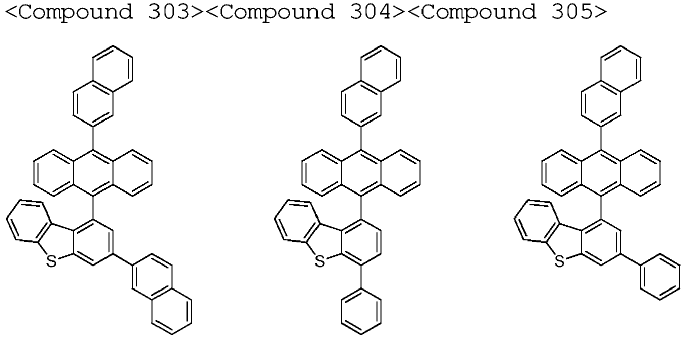

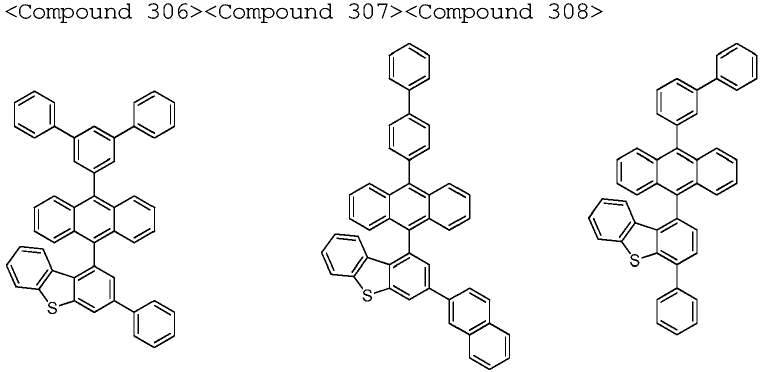

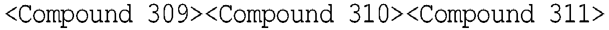

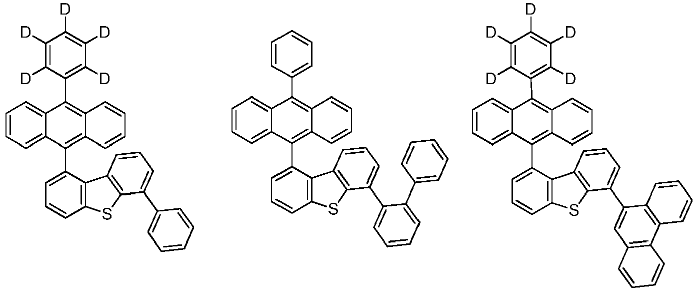

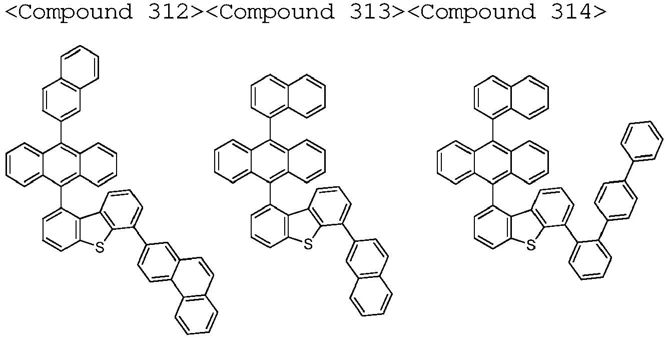

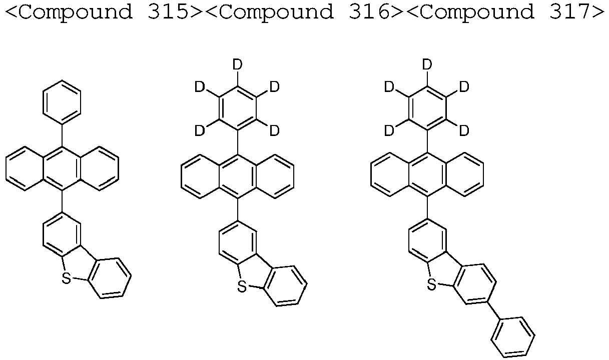

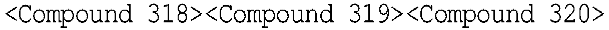

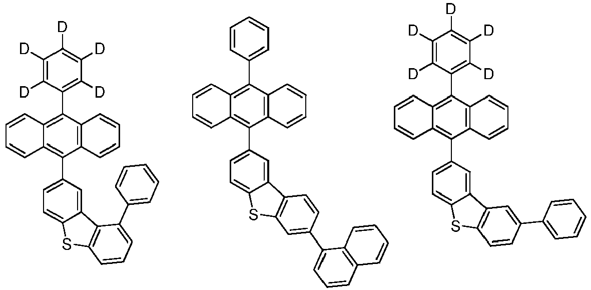

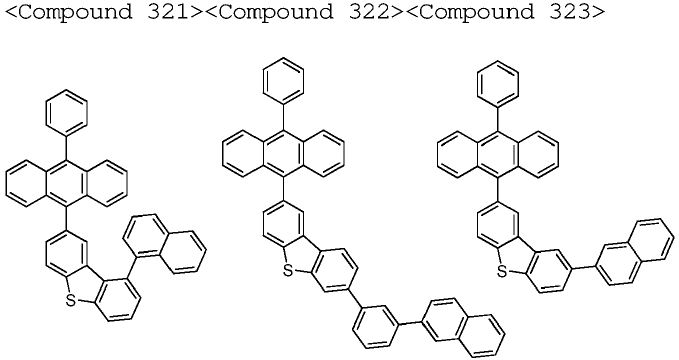

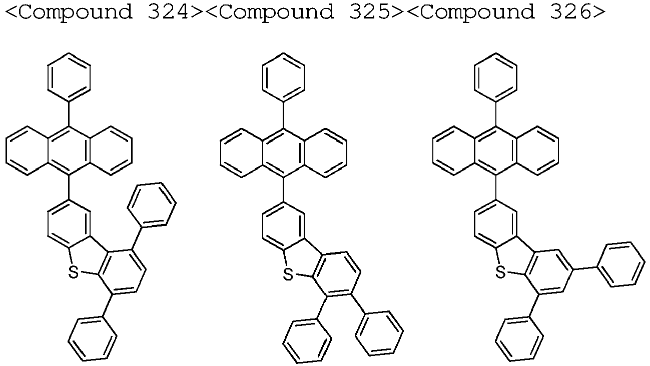

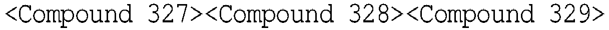

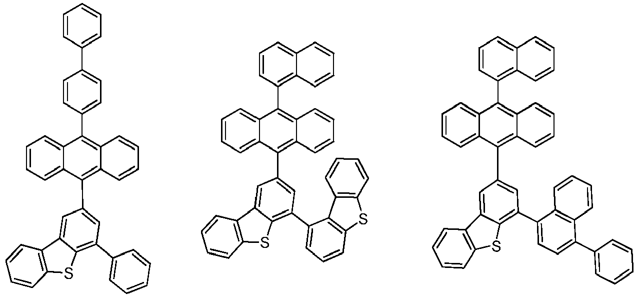

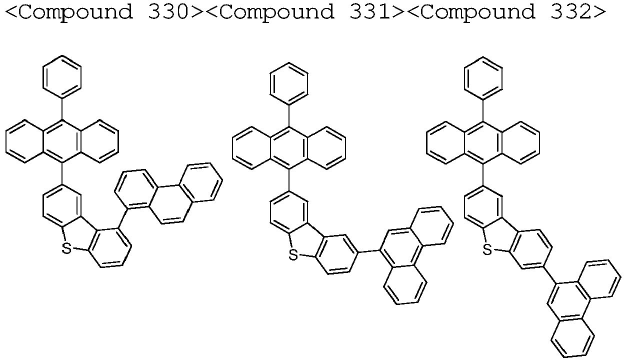

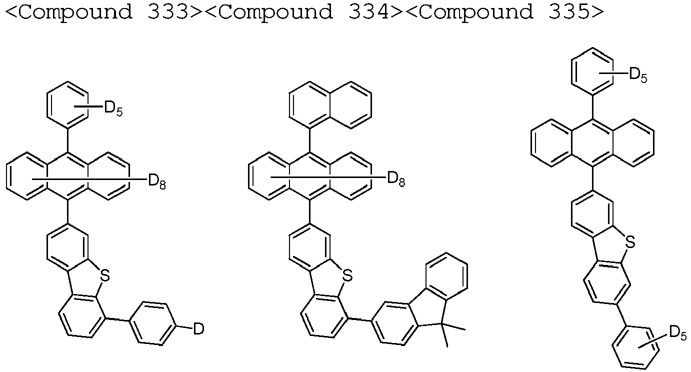

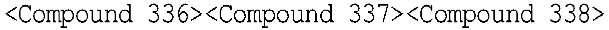

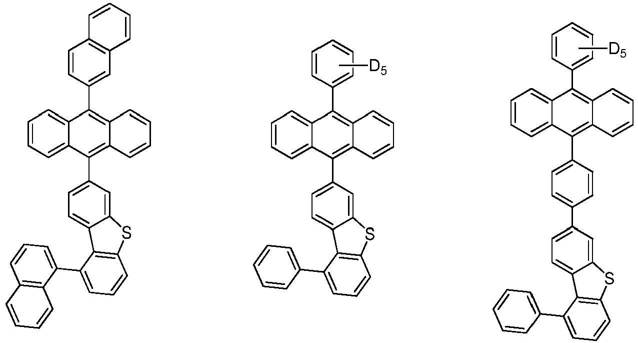

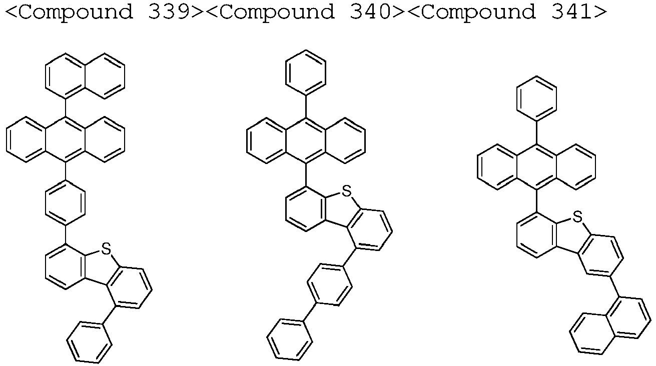

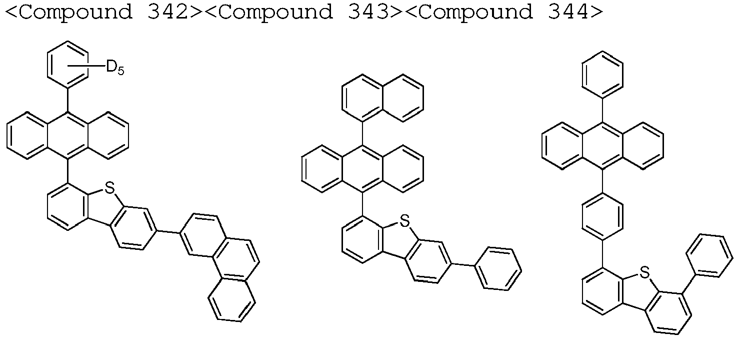

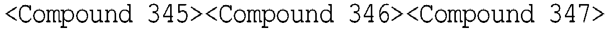

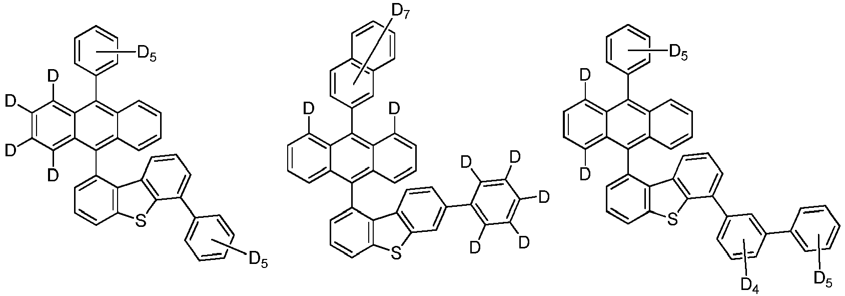

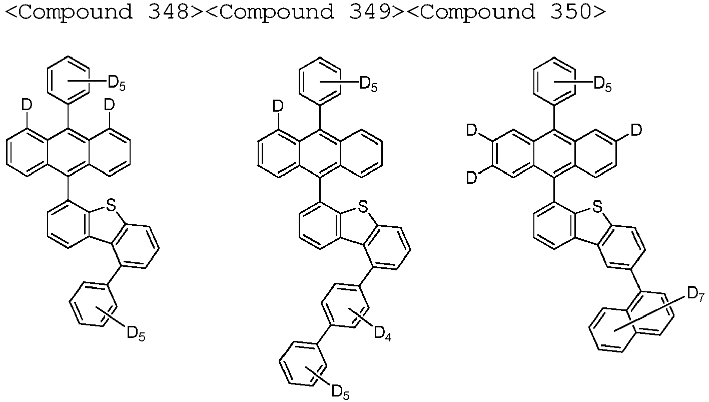

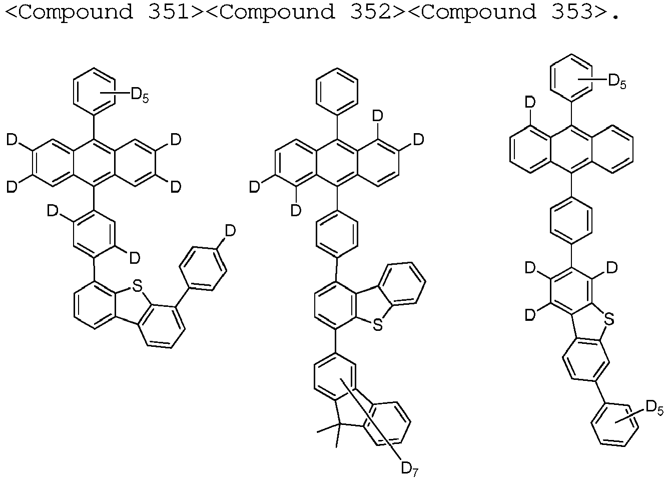

16. The organic light-emitting diode of claim 1, wherein the dopant comprises any one of compounds represented by the following Chemical Formulas D1 to D8: 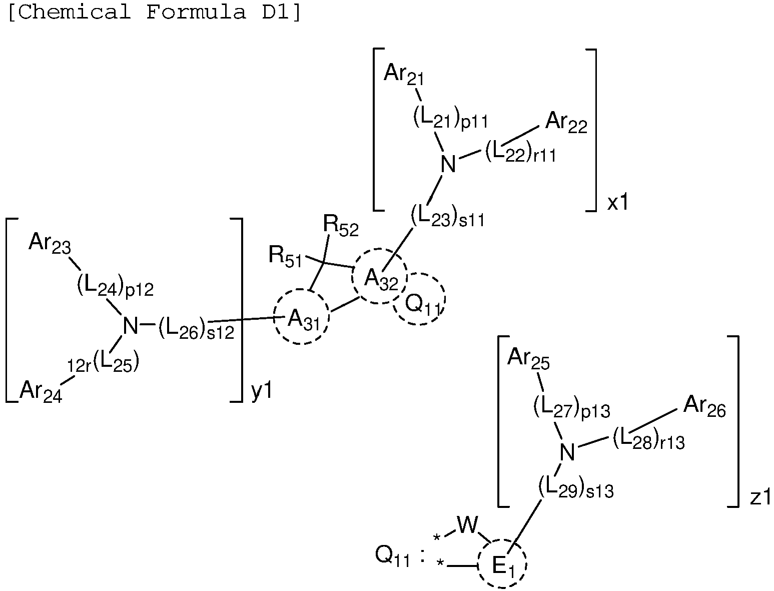 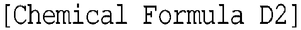 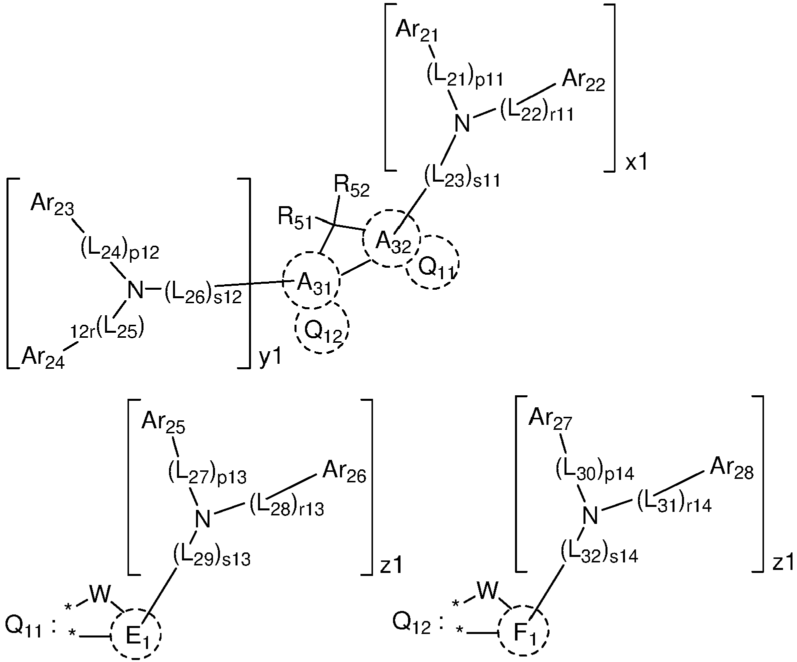 wherein,
A₃₁, A₃₂, E₁, and F₁ may be same or different and are each independently a substituted or unsubstituted aromatic hydrocarbon ring of 6 to 50 carbon atoms, or a substituted or unsubstituted heteroaromatic ring of 2 to 40 carbon atoms wherein two adjacent carbon atoms of the aromatic ring A₃₁ and two adjacent carbon atoms of the aromatic ring A₃₂ form a 5-membered fused ring together with a carbon atom to which substituents R₅₁ and R₅₂ are bonded;
linkers L₂₁ to L₃₂ may be same or different, and are each independently selected from among a single bond, a substituted or unsubstituted alkylene of 1 to 60 carbon atoms, a substituted or unsubstituted alkenylene of 2 to 60 carbon atoms, a substituted or unsubstituted alkynylene of 2 to 60 carbon atoms, a substituted or unsubstituted cycloalkylene of 3 to 60 carbon atoms, a substituted or unsubstituted heterocycloalkylene of 2 to 60 carbon atoms, a substituted or unsubstituted arylene of 6 to 60 carbon atoms, and a substituted or unsubstituted heteroarylene of 2 to 60 carbon atoms;
W is any one selected from among N-R₅₃, CR₅₄R₅₅, SiR₅₆R₅₇, GeF₅₈R₅₉, O, S, and Se;
R₅₁ to R₅₉, and Ar₂₁ to Ar₂₈ may be same or different, and are each independently any one selected from among a hydrogen atom, a deuterium atom, a substituted or unsubstituted alkyl of 1 to 30 carbon atoms, a substituted or unsubstituted aryl of 6 to 50 carbon atoms, a substituted or unsubstituted alkenyl of 2 to 30 carbon atoms, a substituted or unsubstituted alkynyl of 2 to 20 carbon atoms, a substituted or unsubstituted cycloalkyl of 3 to 30 carbon atoms, a substituted or unsubstituted cycloalkenyl of 5 to 30 carbon atoms, a substituted or unsubstituted heteroaryl of 2 to 50 carbon atoms, a substituted or unsubstituted heterocycloalkyl of 2 to 30 carbon atoms, a substituted or unsubstituted alkoxyl of 1 to 30 carbon atoms, a substituted or unsubstituted aryloxyl of 6 to 30 carbon atoms, a substituted or unsubstituted alkylthioxy of 1 to 30 carbon atoms, a substituted or unsubstituted arylthoxy of 5 to 30 carbon atoms, a substituted or unsubstituted alkylamine of 1 to 30 carbon atoms, a substituted or unsubstituted arylamine of 5 to 30 carbon atoms, a substituted or unsubstituted alkylsilyl of 1 to 30 carbon atoms, a substituted or unsubstituted arylsilyl of 5 to 30 carbon atoms, a substituted or unsubstituted alkylgermyl of 1 to 30 carbon atoms, a substituted or unsubstituted arylgermyl of 1 to 30 carbon atoms a cyano, a nitro, and a halogen, with a proviso that R₅₁ and R₅₂ together may form a mono- or polycyclic aliphatic or aromatic ring that may be a heterocyclic ring bearing a heteroatom selected from among N, O, P, Si, S, Ge, Se, and Te as a ring member;
p₁₁ to p₁₄, r₁₁ to r₁₄, and s₁₁ to s₁₄ are each independently an integer of 1 to 3, with a proviso that when any of them is 2 or greater, the corresponding linkers may be same or different,
x1 is an integer of 1 or 2, and y1 and z1 may be same or different and are each independently an integer of 0 to 3; and
Ar₂₁ may form a ring with Ar₂₂, Ar₂₃ may form a ring with Ar₂₄, Ar₂₅ may form a ring with Ar₂₆, and Ar₂₇ may form a ring with Ar₂₈;
two adjacent carbon atoms of the A₃₂ ring moiety of Chemical Formula D1 occupy respective positions * of Structural Formula Q₁₁ to form a fused ring, and
two adjacent carbon atoms of the A₃₁ ring moiety of Chemical Formula D2 occupy respective positions * of structural Formula Q₁₂ to form a fused ring, and two adjacent carbon atoms of the A₃₂ ring moiety of Chemical Formula D2 occupy respective positions * of structural Formula Q₁₁ to form a fused ring: 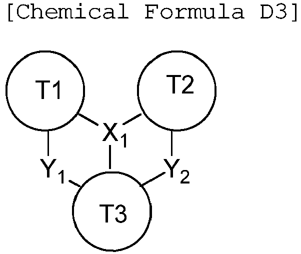 wherein,
X₁ is any one selected from B, P, and P=O,
T₁ to T₃, which are same or different, are each independently a substituted or unsubstituted aromatic hydrocarbon ring of 6 to 50 carbon atoms, or a substituted or unsubstituted heteroaromatic ring of 2 to 40 carbon atoms;
Y₁ is any one selected from among N-R₆₁, CR₆₂R₆₃, O, S, and SiR₆₄R₆₅;
Y₂ is any one selected from among N-R₆₆, CR₆₇R₆₈, O, S, SiR₆₉R₇₀,
wherein R₆₁ to R₇₀, which may be same or different, are each independently any one selected from among a hydrogen atom, a deuterium atom, a substituted or unsubstituted alkyl of 1 to 30 carbon atoms, a substituted or unsubstituted aryl of 6 to 50 carbon atoms, a substituted or unsubstituted cycloalkyl of 3 to 30 carbon atoms, a substituted or unsubstituted heteroaryl of 2 to 50 carbon atoms, a substituted or unsubstituted alkoxy of 1 to 30 carbon atoms, a substituted or unsubstituted aryloxy of 6 to 30 carbon atoms, a substituted or unsubstituted alkylthioxy of 1 to 30 carbon atoms, a substituted or unsubstituted arylthioxy of 5 to 30 carbon atoms, a substituted or unsubstituted alkylamine of 1 to 30 carbon atoms, a substituted or unsubstituted arylamine of 5 to 30 carbon atoms, a substituted or unsubstituted alkylsilyl of 1 to 30 carbon atoms, a substituted or unsubstituted arylsilyl of 5 to 30 carbon atoms, a cyano, and a halogen and wherein at least one of R₆₁ to R₇₀ may be connected to at least one of T₁ to T₃ to form an additional mono- or polycyclic aliphatic or aromatic ring; 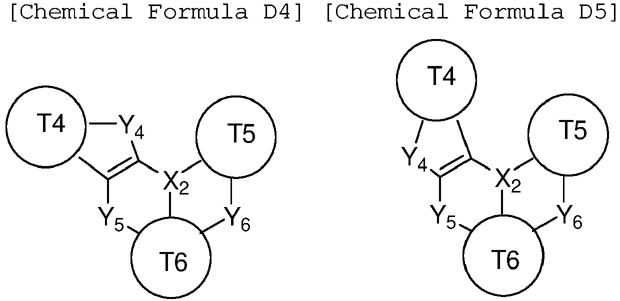 wherein,
X₂ is any one selected from among B, P, and P=O,
T₄ to T₆ are same or different and are as defined for T₁ to T₃ in Chemical Formula D3,
Y₄ to Y₆ are same or different and are as defined for Y₁ to Y₂ in Chemical Formula D3; 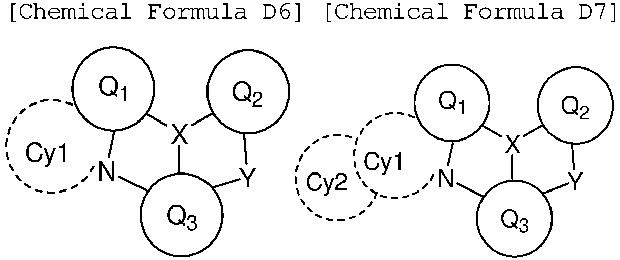 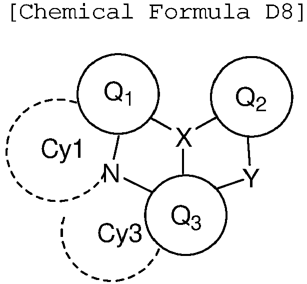 wherein,
Q₁ to Q₃, which are same or different, are each independently a substituted or unsubstituted aromatic hydrocarbon ring of 6 to 50 carbon atoms, or a substituted or unsubstituted heteroaromatic ring of 2 to 50 carbon atoms,
Y is any one selected from N-R₇₃, CR₇₄R₇₅, O, S, and Se,
X is any one selected from B, P, and P=O,
R₇₃ to R₇₅, which are same or different, are each independently any one selected from a hydrogen atom, a deuterium atom, a substituted or unsubstituted alkyl of 1 to 30 carbon atoms, a substituted or unsubstituted aryl of 6 to 50 carbon atoms, a substituted or unsubstituted cycloalkyl of 3 to 30 carbon atoms, a substituted or unsubstituted heteroaryl of 2 to 50 carbon atoms, a substituted or unsubstituted alkoxyl of 1 to 30 carbon atoms, a substituted or unsubstituted aryloxyl of 6 to 30 carbon atoms, a substituted or unsubstituted alkylthioxy of 1 to 30 carbon atoms, a substituted or unsubstituted arylthoxy of 5 to 30 carbon atoms, a substituted or unsubstituted alkylamine of 1 to 30 carbon atoms, a substituted or unsubstituted arylamine of 5 to 30 carbon atoms, a substituted or unsubstituted alkylsilyl of 1 to 30 carbon atoms, a substituted or unsubstituted arylsilyl of 5 to 30 carbon atoms, a nitro, a cyano, and a halogen, and
R₇₃ to R₇₅ can each be connected to the Q₂ or Q₃ ring moiety to form an additional mono- or polycyclic aliphatic or aromatic,
R₇₄ and R₇₅ can be connected to each other to form an additional mono- or polycyclic aliphatic or aromatic ring,
the ring formed by Cy1 is a substituted or unsubstituted alkylene of 1 to 10 carbon atoms, except for the nitrogen (N) atom, the aromatic carbon atom of Q₁ to which the nitrogen (N) atom is connected, and the aromatic carbon atom of Q₁ to which Cy1 is to bond,
Cy2 in Chemical Formula D7 forms a saturated hydrocarbon ring added to Cy1 wherein the ring formed by Cy2 is a substituted or unsubstituted alkylene of 1 to 10 carbon atoms, except for the carbon atoms included in Cy1, and
the ring formed by Cy3 in Chemical Formula D8 is a substituted or unsubstituted alkylene of 1 to 10 carbon atoms, except for the aromatic carbon atom of Q₃ to which Cy3 is to bond, the aromatic carbon atom of Q₃ to which the nitrogen (N) atom is connected, the nitrogen (N) atom, and the carbon atom of Cy1 to which the nitrogen (N) atom is connected,
wherein the term "substituted" in the expression "substituted or unsubstituted" used for compounds of Chemical Formulas D1 to D8 is as defined in claim 1.

17. The organic light-emitting diode of claim 1, wherein Compound A and Compound B are different in molecular weight by 200 or less.

18. The organic light-emitting diode of claim 1, wherein the organic layer comprises at least one of a hole injection layer, a hole transport layer, a functional layer capable of both hole injection and hole transport, an electron blocking layer, a light-emitting layer, an electron transport layer, an electron injection layer, and a capping layer.

19. The organic light-emitting diode of claim 18, wherein at least one selected from among the layers is deposited using a single-molecule deposition process or a solution process.

20. The organic light-emitting diode of claim 1, wherein the organic light-emitting diode is used for a device selected from among a flat display device; a flexible display device; a monochrome or grayscale flat illumination; and a monochrome or grayscale flexible illumination device.
